# EUROPEAN PATENT APPLICATION

(11) **EP 4 851 252 A1**
(43) Date of publication of application: **09.12.2026**
(21) Application number: 26174296.9
(22) Date of filing: 23.04.2026
(51) Int. Cl.: C09B 57/00, H10K 85/60

(54) **HETEROCYCLIC COMPOUND, AND ORGANIC LIGHT-EMITTING DEVICE AND ELECTRONIC APPARATUS INCLUDING THE HETEROCYCLIC COMPOUND**

(30) Priority: 05.06.2025 KR 20250074000; 17.04.2026 KR 20260070199
(71) Applicant: Samsung Display Co., Ltd., Yongin-si, Gyeonggi-do 17113 (KR)
(72) Inventor: LEE, Eunkyung, 16678 Suwon-si (KR); KIM, Sangmo, 16678 Suwon-si (KR); LEE, Halim, 16678 Suwon-si (KR); CHWAE, Jun, 16678 Suwon-si (KR); KIM, Raesung, 16678 Suwon-si (KR); KIM, Jiwhan, 16678 Suwon-si (KR); NAM, Sungho, 16678 Suwon-si (KR); JEONG, Daun, 16678 Suwon-si (KR); CHO, Hwayoung, 16678 Suwon-si (KR)
(74) Representative: Elkington and Fife LLP

(57) **Abstract**

Provided are a heterocyclic compound represented by Formula 1, and an organic light-emitting device and an electronic apparatus that include the heterocyclic compound: 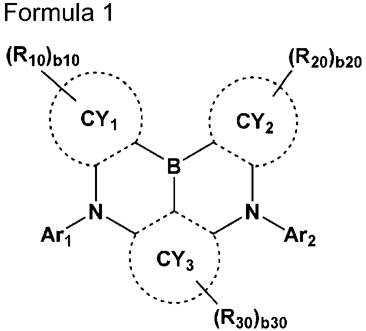 wherein, in Formula 1, ring CY₁ to ring CY₃ are each independently a C₅-C₃₀ carbocyclic group unsubstituted or substituted with Q₁, Z₁, or a combination thereof; or a C₁-C₃₀ heterocyclic group unsubstituted or substituted with Q₁, Z₁, or a combination thereof; at least one of ring CY₁ to ring CY₃ is substituted with Q₁; Q₁ is a group represented by Formula 2; and Z₁ is a group represented by Formula 3: 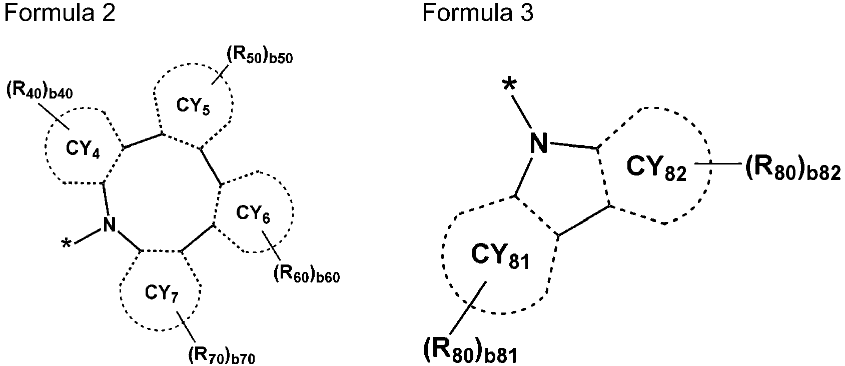 wherein the remaining substituent groups are as defined herein.

## Description

### FIELD OF THE INVENTION

The disclosure relates to a heterocyclic compound, and an organic light-emitting device and an electronic apparatus that include the heterocyclic compound.

### BACKGROUND OF THE INVENTION

Organic light-emitting devices (OLEDs) are self-emissive devices, which have excellent characteristics in terms of viewing angles, response time, brightness, driving voltage, and response speed. In addition, OLEDs can produce full-color images.

In an example, an organic light-emitting device includes an anode, a cathode, and an organic layer arranged between the anode and the cathode and including an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. The excitons may transition from an excited state to a ground state, thereby generating light.

### SUMMARY OF THE INVENTION

Provided are a heterocyclic compound, and an organic light-emitting device and an electronic apparatus that include the heterocyclic compound.

Additional aspects will be set forth in part in the detailed description that follows and, in part, will be apparent from the detailed description, or may be learned by practice of the presented exemplary embodiments herein.

According to an aspect, provided is a heterocyclic compound represented by Formula 1: 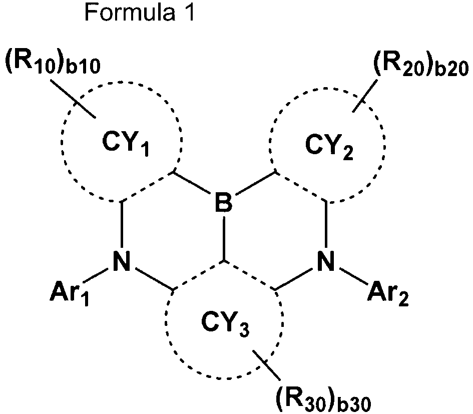 wherein, in Formula 1,
ring CY₁ to ring CY₃ are each independently a C₅-C₃₀ carbocyclic group unsubstituted or substituted with Q₁, Z₁, or a combination thereof, or a C₁-C₃₀ heterocyclic group unsubstituted or substituted with Q₁, Z₁, or a combination thereof,
at least one of ring CY₁ to ring CY₃ is substituted with Q₁,
Q₁ is a group represented by Formula 2, 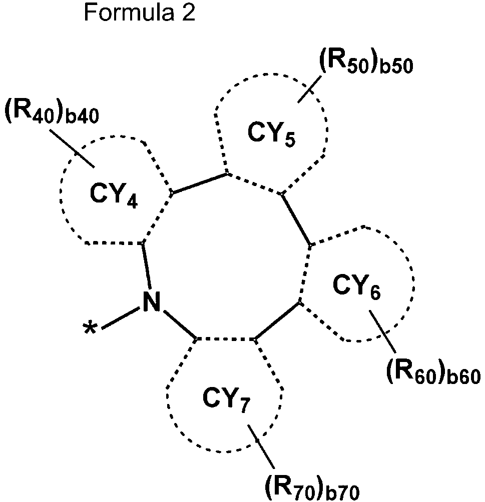
Z₁ is a group represented by Formula 3, and 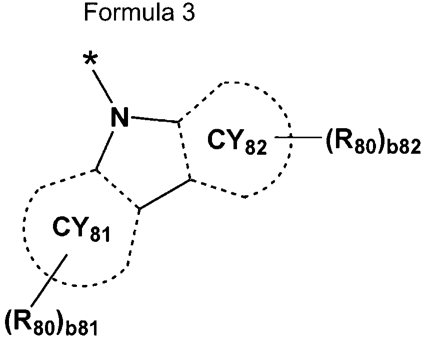
Ar₁ and Ar₂ are each independently a group represented by Formula 4, hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q_{1A})(Q_{2A}), -Si(Q_{1A})(Q_{2A})(Q_{3A}), - Ge(Q_{1A})(Q_{2A})(Q_{3A}), -C(=O)(Q_{1A}), -S(=O)(Q_{1A}), -S(=O)₂(Q_{1A}), -B(Q_{1A})(Q_{2A}), - P(Q_{1A})(Q_{2A}), -P(=O)(Q_{1A})(Q_{2A}), or -P(=S)(Q_{1A})(Q_{2A}), 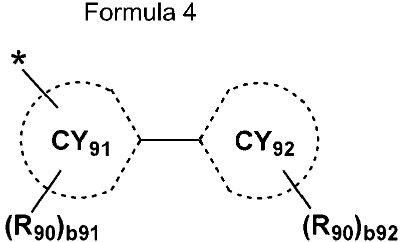
wherein, in Formulae 1 to 4,
ring CY₄ to ring CY₇, ring CY₈₁, ring CY₈₂, ring CY₉₁, and ring CY₉₂ are each independently a C₅-C₃₀ carbocyclic group or a C₁-C₃₀ heterocyclic group,
   R₁₀, R₂₀, R₃₀, R₄₀, R₅₀, R₆₀, R₇₀, R₈₀, and R₉₀ are each independently hydrogen, deuterium, -F, -Cl, -Br, -I, -SF₅, a hydroxyl group, a cyano group, a nitro group, an amino group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q_{1A})(Q_{2A}), -Si(Q_{1A})(Q_{2A})(Q_{3A}), -Ge(Q_{1A})(Q_{2A})(Q_{3A}), -C(=O)(Q_{1A}), -S(=O)(Q_{1A}), -S(=O)₂(Q_{1A}), -B(Q_{1A})(Q_{2A}), -P(Q_{1A})(Q_{2A}), - P(=O)(Q_{1A})(Q_{2A}), or -P(=S)(Q_{1A})(Q_{2A}),
   b10, b20, b30, b40, b50, b60, b70, b80, and b90 are each independently 1, 2, 3, 4, 5, 6, 7, 8, 9, 10, 11, 12, 13, or 14,
   neighboring two or more of R₁₀, R₂₀, R₃₀, R₄₀, R₅₀, R₆₀, R₇₀, R₈₀, and R₉₀ are optionally bonded to each other to form a substituted or unsubstituted C₅-C₃₀ carbocyclic group or a substituted or unsubstituted C₁-C₃₀ heterocyclic group,
   two or more of a plurality of R₁₀ are optionally bonded to each other to form a substituted or unsubstituted C₅-C₃₀ carbocyclic group or a substituted or unsubstituted C₁-C₃₀ heterocyclic group,
   two or more of a plurality of R₂₀ are optionally bonded to each other to form a substituted or unsubstituted C₅-C₃₀ carbocyclic group or a substituted or unsubstituted C₁-C₃₀ heterocyclic group,
   two or more of a plurality of R₃₀ are optionally bonded to each other to form a substituted or unsubstituted C₅-C₃₀ carbocyclic group or a substituted or unsubstituted C₁-C₃₀ heterocyclic group,
   two or more of a plurality of R₄₀ are optionally bonded to each other to form a substituted or unsubstituted C₅-C₃₀ carbocyclic group or a substituted or unsubstituted C₁-C₃₀ heterocyclic group,
   two or more of a plurality of R₅₀ are optionally bonded to each other to form a substituted or unsubstituted C₅-C₃₀ carbocyclic group or a substituted or unsubstituted C₁-C₃₀ heterocyclic group,
   two or more of a plurality of R₆₀ are optionally bonded to each other to form a substituted or unsubstituted C₅-C₃₀ carbocyclic group or a substituted or unsubstituted C₁-C₃₀ heterocyclic group,
two or more of a plurality of R₇₀ are optionally bonded to each other to form a substituted or unsubstituted C₅-C₃₀ carbocyclic group or a substituted or unsubstituted C₁-C₃₀ heterocyclic group,
two or more of a plurality of R₈₀ are optionally bonded to each other to form a substituted or unsubstituted C₅-C₃₀ carbocyclic group or a substituted or unsubstituted C₁-C₃₀ heterocyclic group,
   two or more of a plurality of R₉₀ are optionally bonded to each other to form a substituted or unsubstituted C₅-C₃₀ carbocyclic group or a substituted or unsubstituted C₁-C₃₀ heterocyclic group,
   at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is each independently:
      deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
      a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q_{11A})(Q_{12A}), -Si(Q_{11A})(Q_{12A})(Q_{13A}), -Ge(Q_{11A})(Q_{12A})(Q_{13A}), - C(=O)(Q_{11A}), -S(=O)(Q_{11A}), -S(=O)₂(Q_{11A}), -B(Q_{11A})(Q_{12A}), -P(Q_{11A})(Q_{12A}), - P(=O)(Q_{11A})(Q_{12A}), -P(=S)(Q_{11A})(Q_{12A}), or a combination thereof,
      a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q_{21A})(Q_{22A}), -Si(Q_{21A})(Q_{22A})(Q_{23A}), -Ge(Q_{21A})(Q_{22A})(Q_{23A}), - C(=O)(Q_{21A}), -S(=O)(Q_{21A}), -S(=O)₂(Q_{21A}), -B(Q_{21A})(Q_{22A}), -P(Q_{21A})(Q_{22A}), - P(=O)(Q_{21A})(Q_{22A}), -P(=S)(Q_{21A})(Q_{22A}), or a combination thereof,
      -N(Q_{31A})(Q_{32A}), -Si(Q_{31A})(Q_{32A})(Q_{33A}), -Ge(Q_{31A})(Q_{32A})(Q_{33A}), - C(=O)(Q_{31A}), -S(=O)(Q_{31A}), -S(=O)₂(Q_{31A}), -B(Q_{31A})(Q_{32A}), -P(Q_{31A})(Q_{32A}), - P(=O)(Q_{31A})(Q_{32A}), or -P(=S)(Q_{31A})(Q_{32A}), or
      a combination thereof,
      Q1A to Q_{3A}, Q11A to Q_{13A}, Q21A to Q_{23A}, and Q_{31A} to Q_{33A} are each independently hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or
      a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof, and
      * indicates a binding site to a neighboring atom.

According to another aspect, an organic light-emitting device includes the heterocyclic compound.

According to another aspect, an organic light-emitting device includes a first electrode; a second electrode; and an organic layer arranged between the first electrode and the second electrode, wherein the organic layer comprises an emission layer, and wherein the organic layer further comprises a heterocyclic compound represented by Formula 1 as described herein.

According to another aspect, an electronic apparatus includes the organic light-emitting device.

### BRIEF DESCRIPTION OF THE DRAWINGS

The above and other aspects, features, and advantages of certain embodiments of will be more apparent from the following detailed description taken in conjunction with the accompanying drawings, in which:
FIG. 1 is a schematic cross-sectional view of an organic light-emitting device according to one or more embodiments; and
FIGS. 2 to 6 are each a schematic diagram showing energy transfer of an organic light-emitting device according to one or more embodiments.

### DETAILED DESCRIPTION OF THE EMBODIMENTS

Reference will now be made in further detail to exemplary embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

A heterocyclic compound is represented by Formula 1: 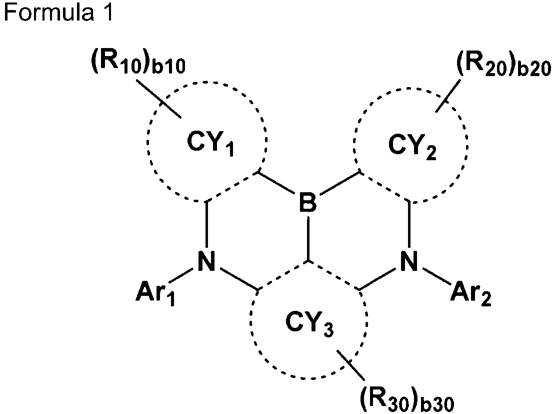 wherein, in Formula 1, ring CY₁ to ring CY₃ are each independently a C₅-C₃₀ carbocyclic group unsubstituted or substituted with Q₁, Z₁, or a combination thereof; or a C₁-C₃₀ heterocyclic group unsubstituted or substituted with Q₁, Z₁, or a combination thereof.

In one or more embodiments, ring CY₁ to ring CY₃ may each independently be i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring, each unsubstituted or substituted with Q₁, Z₁, or a combination thereof,
wherein the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, ring CY₁ to ring CY₃ may each independently be a C₆-C₃₀ aromatic carbocyclic group or a C₁-C₃₀ aromatic heterocyclic group, each unsubstituted or substituted with Q₁, Z₁, or a combination thereof.

In one or more embodiments, ring CY₁ to ring CY₃ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group, each unsubstituted or substituted with Q₁, Z₁, or a combination thereof.

In one or more embodiments, ring CY₁ to ring CY₃ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group, each unsubstituted or substituted with Q₁, Z₁, or a combination thereof.

In one or more embodiments, ring CY₁ to ring CY₃ may each independently be a benzene group, a naphthalene group, a phenanthrene group, a pyridine group, a pyrimidine group, a quinoline group, an isoquinoline group, a phthalazine group, a naphthyridine group, a quinoxaline group, or a quinazoline group, each unsubstituted or substituted with Q₁, Z₁, or a combination thereof.

In Formula 1, at least one of ring CY₁ to ring CY₃ is substituted with Q₁.

Q₁ is a group represented by Formula 2.

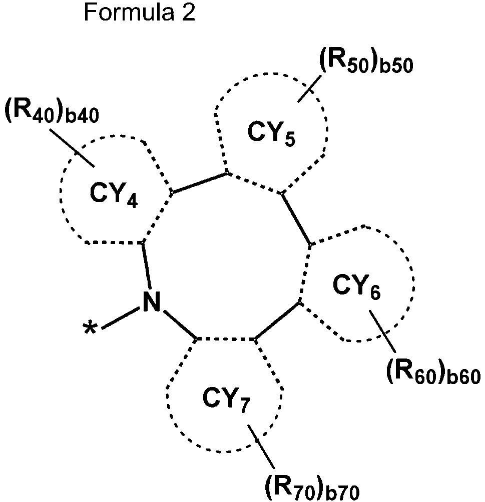

Z₁ is a group represented by Formula 3.

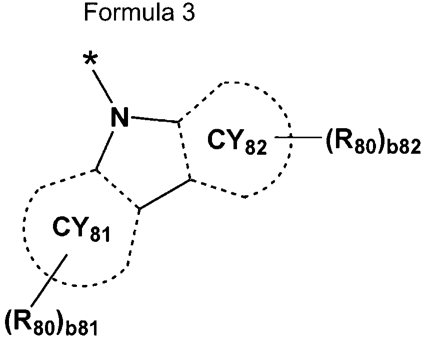

In Formula 1, Ar₁ and Ar₂ are each independently a group represented by Formula 4, hydrogen, deuterium, -F, -Cl, -Br, -I, -SF₅, a hydroxyl group, a cyano group, a nitro group, an amino group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group,-N(Q_{1A})(Q_{2A}), - Si(Q_{1A})(Q_{2A})(Q_{3A}), -Ge(Q_{1A})(Q_{2A})(Q_{3A}), -C(=O)(Q_{1A}), -S(=O)(Q_{1A}), -S(=O)₂(Q_{1A}), - B(Q_{1A})(Q_{2A}), -P(Q_{1A})(Q_{2A}), -P(=O)(Q_{1A})(Q_{2A}), or -P(=S)(Q_{1A})(Q_{2A}).

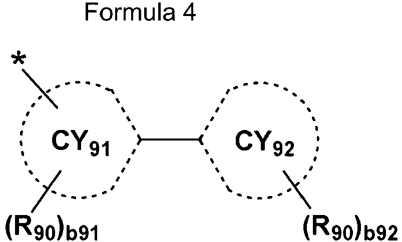

In Formulae 1 to 4, ring CY₄ to ring CY₇, CY₈₁, ring CY₈₂, ring CY₉₁, and ring CY₉₂ may each independently be a C₅-C₃₀ carbocyclic group or a C₁-C₃₀ heterocyclic group.

In one or more embodiments, ring CY₄ to ring CY₇, ring CY₈₁, ring CY₈₂, ring CY₉₁, and ring CY₉₂ may each independently be i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
wherein the first ring and the second ring may each be as described herein.

In one or more embodiments, ring CY₄ to ring CY₇, ring CY₈₁, ring CY₈₂, ring CY₉₁, and ring CY₉₂ may each independently be a C₆-C₃₀ aromatic carbocyclic group or a C₁-C₃₀ aromatic heterocyclic group.

In one or more embodiments, ring CY₄ to ring CY₇, ring CY₈₁, ring CY₈₂, ring CY₉₁, and ring CY₉₂ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group.

In one or more embodiments, ring CY₄ to ring CY₇, ring CY₈₁, ring CY₈₂, ring CY₉₁, and ring CY₉₂ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

In one or more embodiments, ring CY₄ to ring CY₇, ring CY₈₁, ring CY₈₂, ring CY₉₁, and ring CY₉₂ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, or a dibenzosilole group.

In one or more embodiments, ring CY₄ to ring CY₇, ring CY₈₁, ring CY₈₂, ring CY₉₁, and ring CY₉₂ may each independently be a benzene group, a naphthalene group, a phenanthrene group, a pyridine group, a pyrimidine group, a quinoline group, an isoquinoline group, a phthalazine group, a naphthyridine group, a quinoxaline group, or a quinazoline group.

In one or more embodiments, Q₁ may be a group represented by Formula 2A: 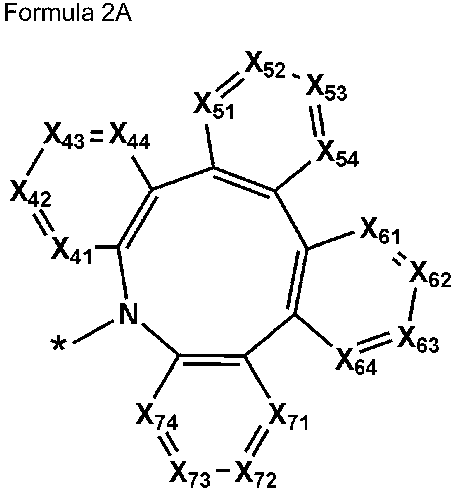 wherein, in Formula 2A,
X₄₁ may be C(R₄₁) or N, X₄₂ may be C(R₄₂) or N, X₄₃ may be C(R₄₃) or N, and X₄₄ may be C(R₄₄) or N,
X₅₁ may be C(R₅₁) or N, X₅₂ may be C(R₅₂) or N, X₅₃ may be C(R₅₃) or N, and X₅₄ may be C(R₅₄) or N,
X₆₁ may be C(R₆₁) or N, X₆₂ may be C(R₆₂) or N, X₆₃ may be C(R₆₃) or N, and X₆₄ may be C(R₆₄) or N,
X₇₁ may be C(R₇₁) or N, X₇₂ may be C(R₇₂) or N, X₇₃ may be C(R₇₃) or N, and X₇₄ may be C(R₇₄) or N,
R₄₁ to R₄₄ may each independently be as described in connection with R₄₀,
R₅₁ to R₅₄ may each independently be as described in connection with R₅₀,
R₆₁ to R₆₄ may each independently be as described in connection with R₆₀,
R₇₁ to R₇₄ may each independently be as described in connection with R₇₀, and
* indicates a binding site to a neighboring atom.

In one or more embodiments, Z₁ may be a group represented by Formula 3A: 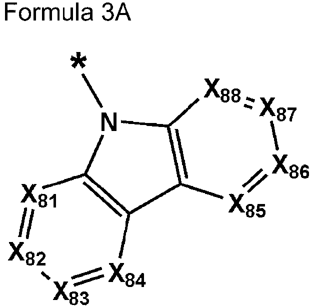 wherein, in Formula 3A,
X₈₁ may be C(R₈₁) or N, X₈₂ may be C(R₈₂) or N, X₈₃ may be C(R₈₃) or N, X₈₄ may be C(R₈₄) or N, X₈₅ may be C(R₈₅) or N, X₈₆ may be C(R₈₆) or N, X₈₇ may be C(R₈₇) or N, and X₈₈ may be C(R₈₈) or N,
R₈₁ to R₈₈ may each independently be as described in connection with R₈₀, and
* indicates a binding site to a neighboring atom.

In one or more embodiments, Ar₁ and Ar₂ may each independently be a group represented by Formula 4.

In one or more embodiments, the group represented by Formula 4 may be a group represented by one of Formulae 4A to 4C: 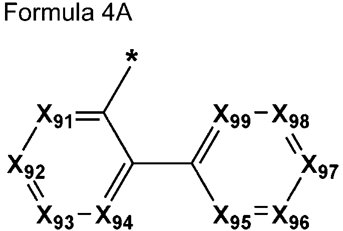 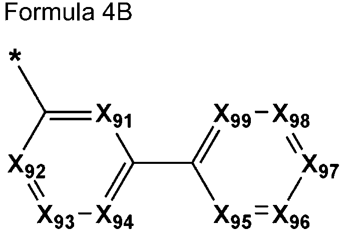 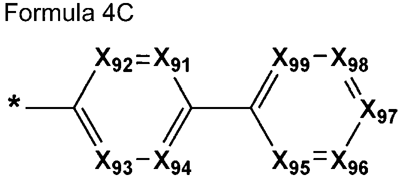 wherein, in Formulae 4A to 4C,
X₉₁ may be C(R₉₁) or N, X₉₂ may be C(R₉₂) or N, X₉₃ may be C(R₉₃) or N, X₉₄ may be C(R₉₄) or N, X₉₅ may be C(R₉₅) or N, X₉₆ may be C(R₉₆) or N, X₉₇ may be C(R₉₇) or N, X₉₈ may be C(R₉₈) or N, and X₉₉ may be C(R₉₉) or N
R₉₁ to R₉₉ may each independently be as described in connection with R₉₀, and
* indicates a binding site to a neighboring atom.

In Formulae 1 to 4, R₁₀, R₂₀, R₃₀, R₄₀, R₅₀, R₆₀, R₇₀, R₈₀, and R₉₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q_{1A})(Q_{2A}), -Si(Q_{1A})(Q_{2A})(Q_{3A}), - Ge(Q_{1A})(Q_{2A})(Q_{3A}), -C(=O)(Q_{1A}), -S(=O)(Q_{1A}), -S(=O)₂(Q_{1A}), -B(Q_{1A})(Q_{2A}), - P(Q_{1A})(Q_{2A}), -P(=O)(Q_{1A})(Q_{2A}), or -P(=S)(Q_{1A})(Q_{2A}).

In one or more embodiments, R₁₀, R₂₀, R₃₀, R₄₀, R₅₀, R₆₀, R₇₀, R₈₀, and R₉₀ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -SF₅, -CD₃, -CD₂H, -CDH₂, - CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (a norbornanyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q_{1A})(Q_{2A}), -Si(Q_{1A})(Q_{2A})(Q_{3A}), -Ge(Q_{1A})(Q_{2A})(Q_{3A}), -C(=O)(Q_{1A}), - S(=O)(Q_{1A}), -S(=O)₂(Q_{1A}), -B(Q_{1A})(Q_{2A}), -P(Q_{1A})(Q_{2A}), -P(=O)(Q_{1A})(Q_{2A}), or - P(=S)(Q_{1A})(Q_{2A}).

In one or more embodiments, R₁₀, R₂₀, R₃₀, R₄₀, R₅₀, R₆₀, R₇₀, R₈₀, and R₉₀ may each independently be:
hydrogen, deuterium, -F, -Cl, -Br, -I, -SF₅, -CD₃, -CD₂H, -CDH₂, -CF₃, - CF₂H, -CFH₂, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group; or
a group represented by one of Formulae 9-1 to 9-61, 9-201 to 9-244, 10-1 to 10-154, or 10-201 to 10-350; or
   -Si(Q_{1A})(Q_{2A})(Q_{3A}) or -Ge(Q_{1A})(Q_{2A})(Q_{3A}): 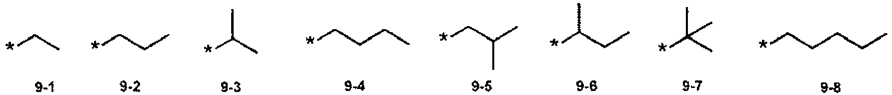 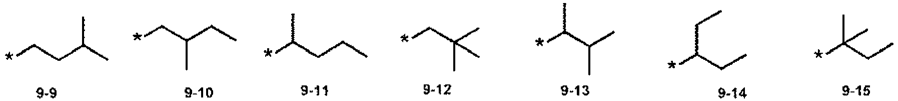 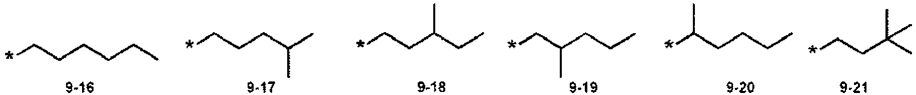 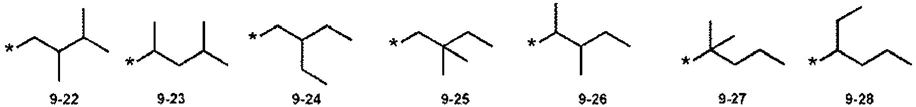 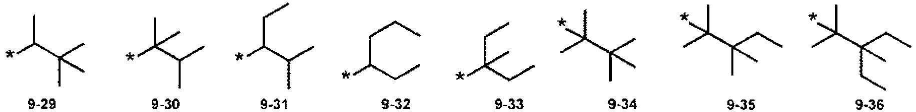 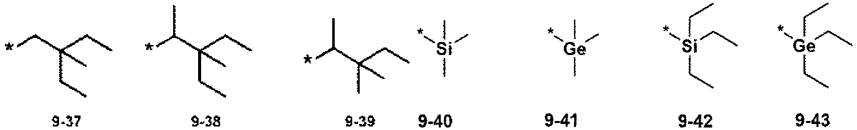 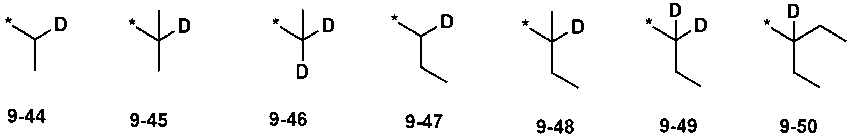 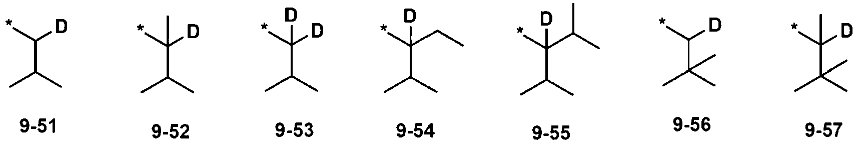 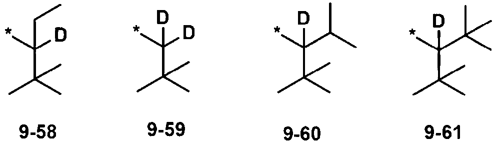 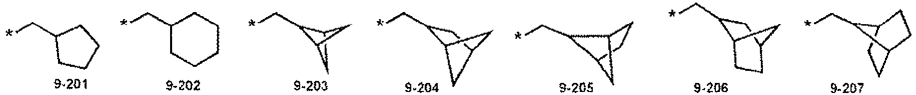 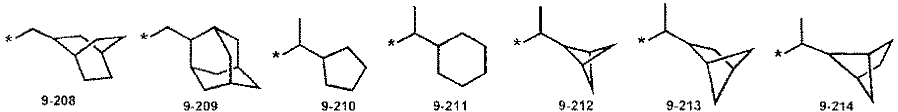 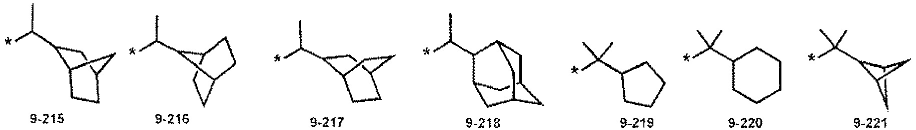 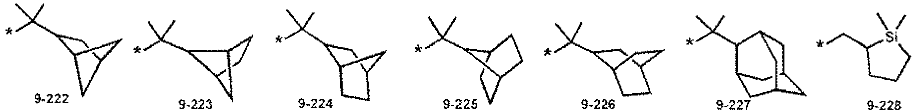 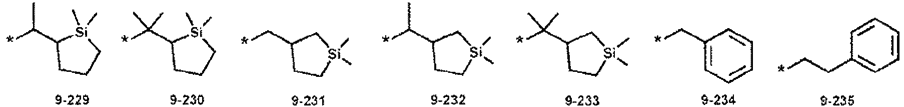 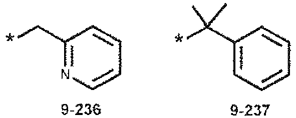 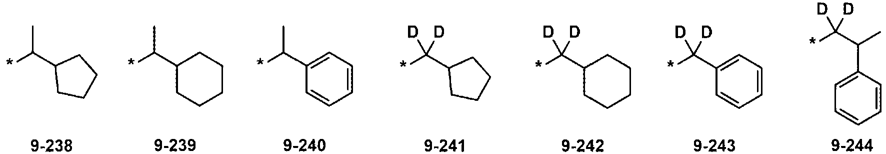 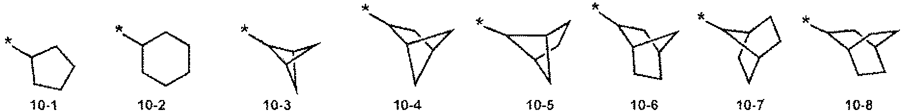 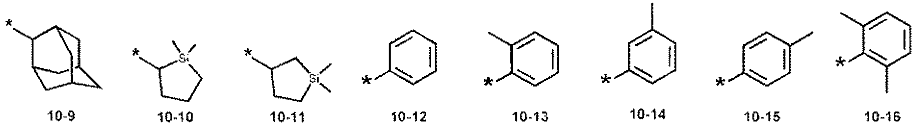 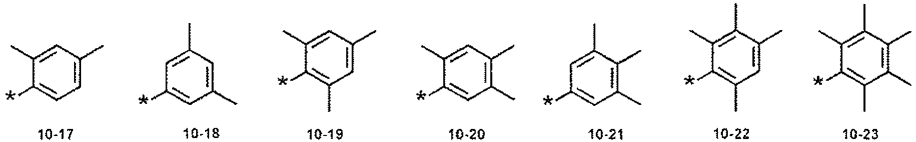 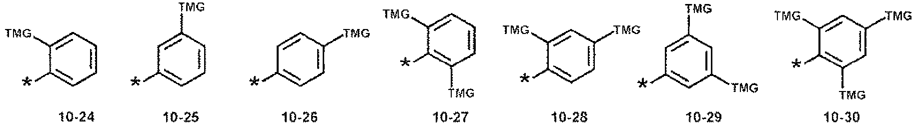 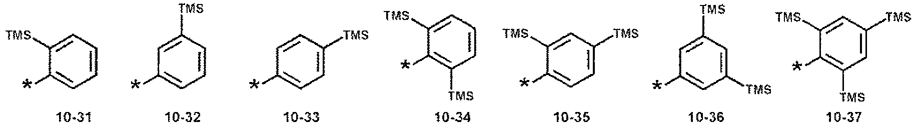 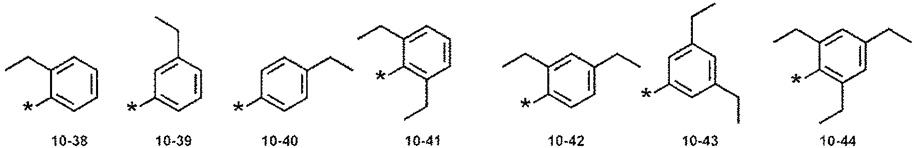 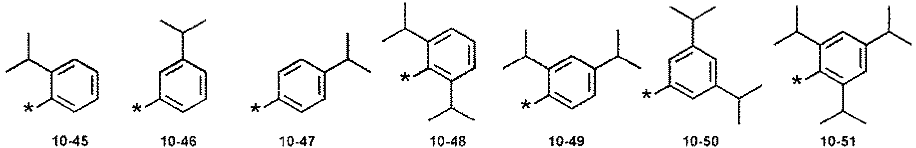 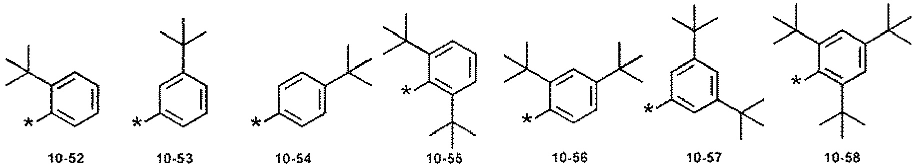 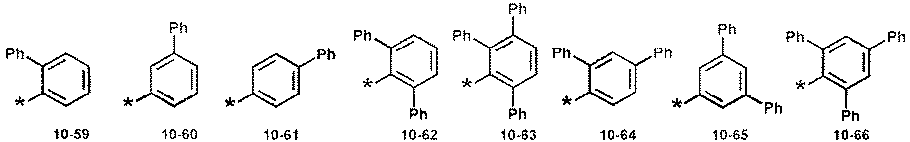 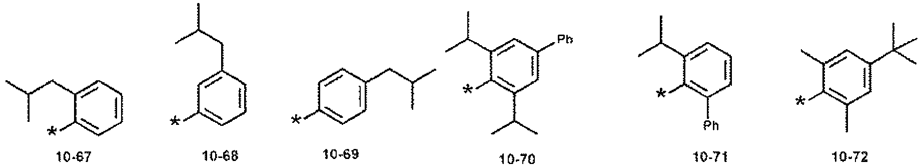 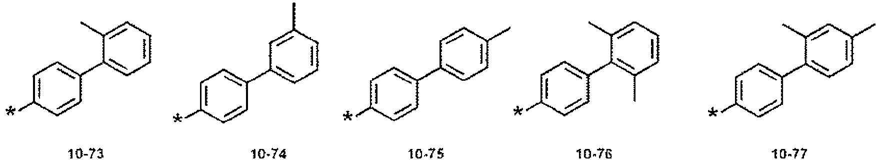 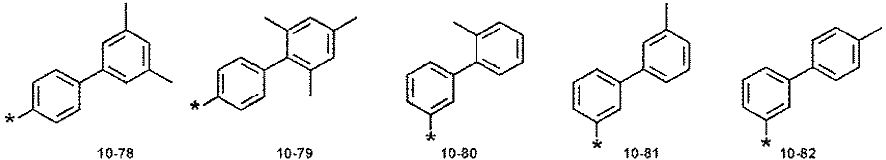 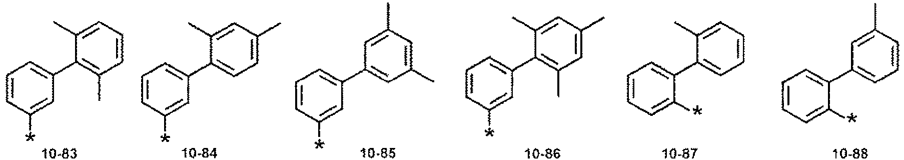 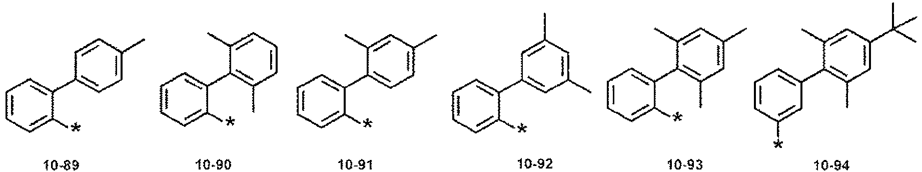 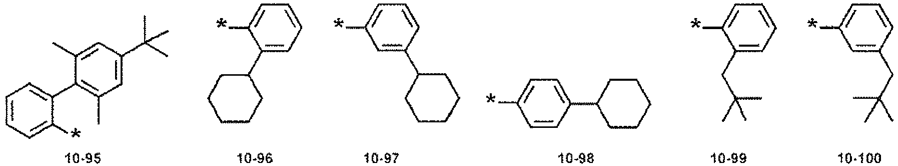 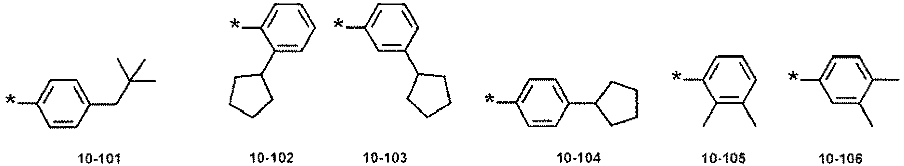 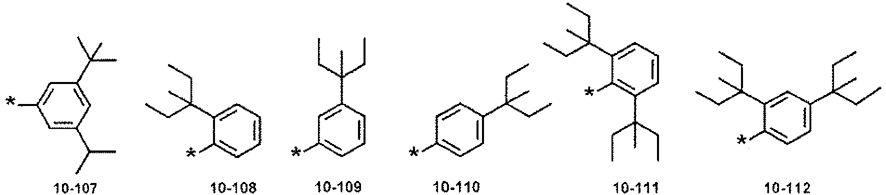 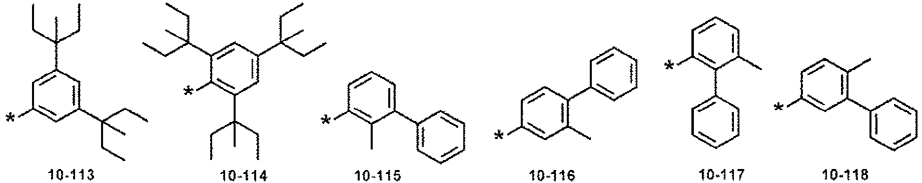 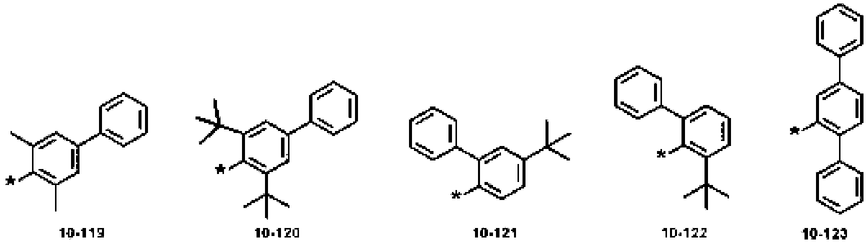 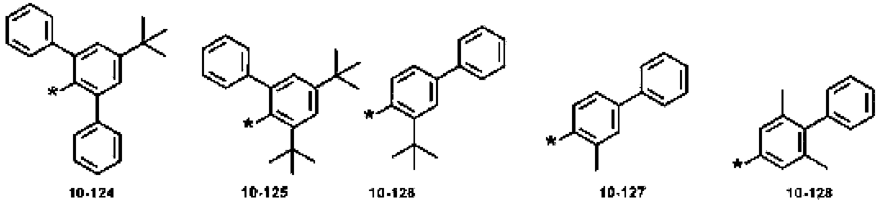 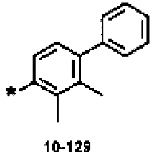 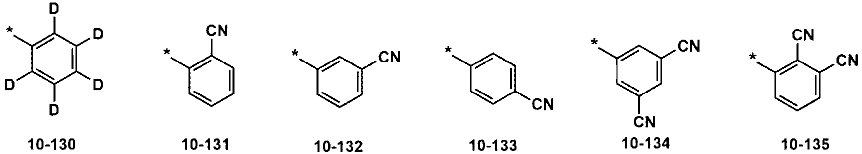 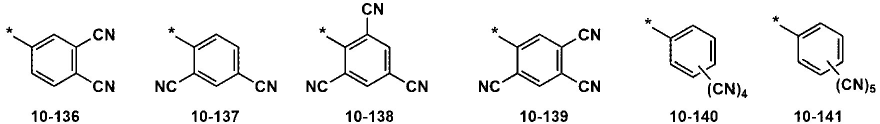 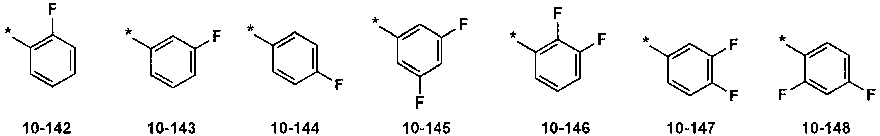 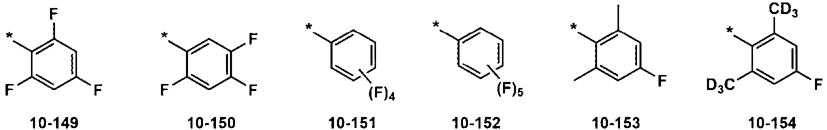 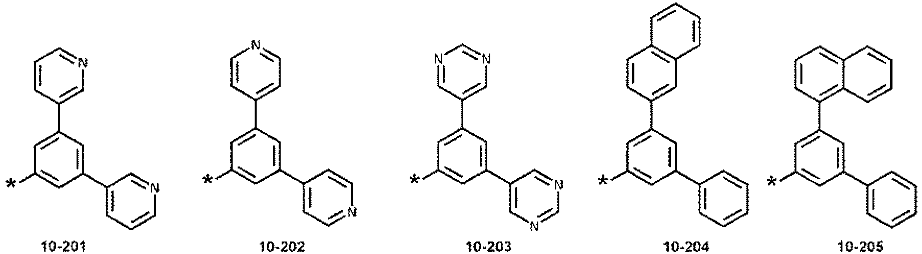 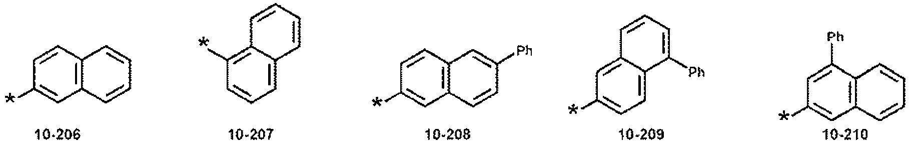 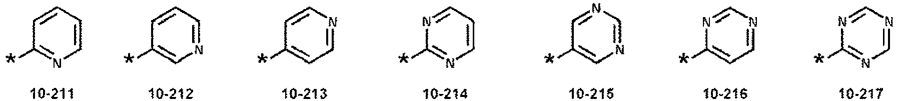 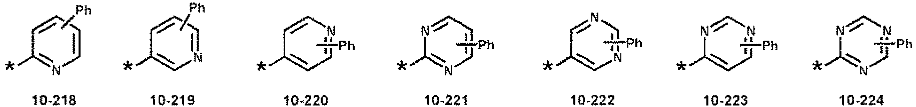 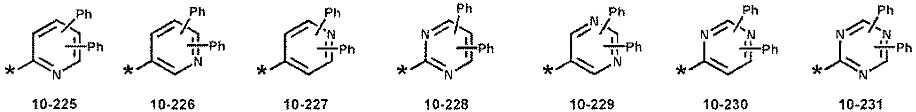 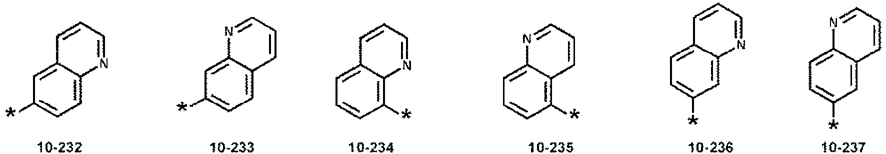 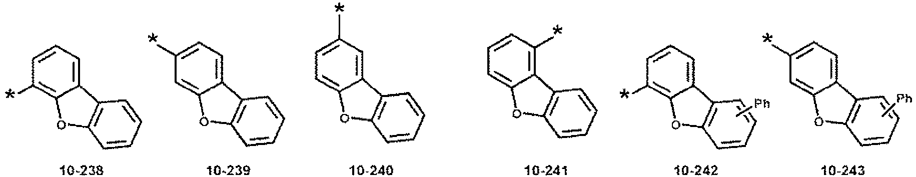 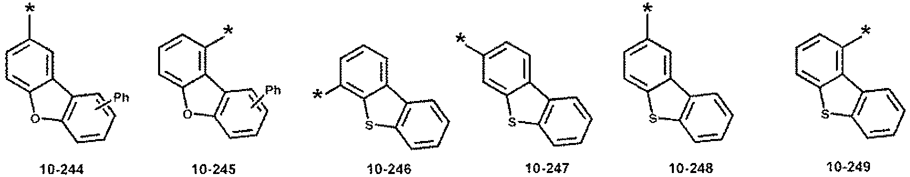 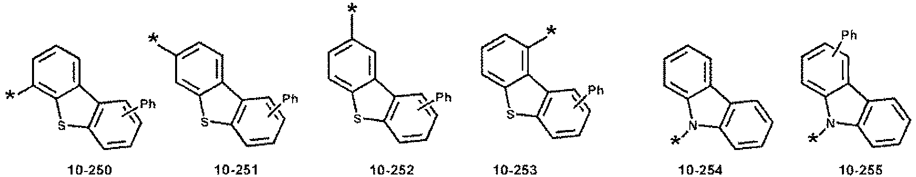 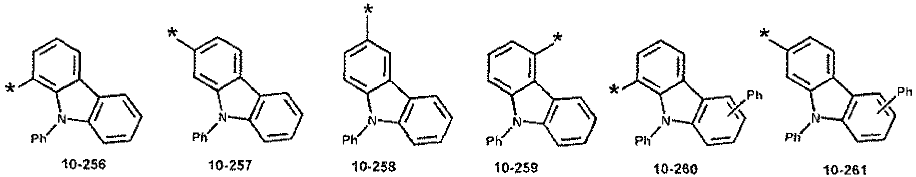 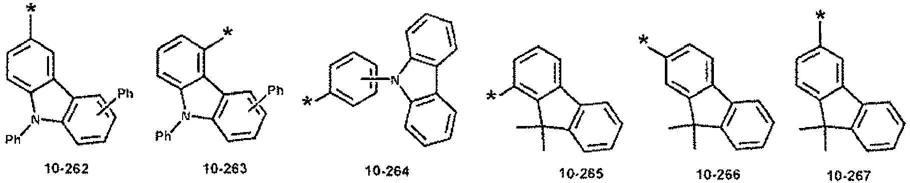 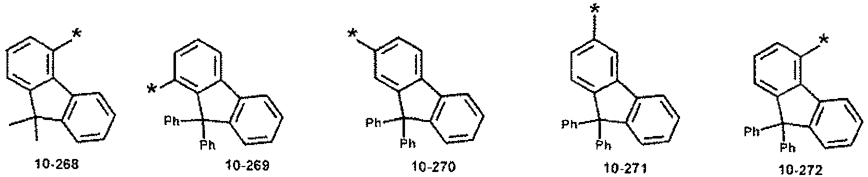 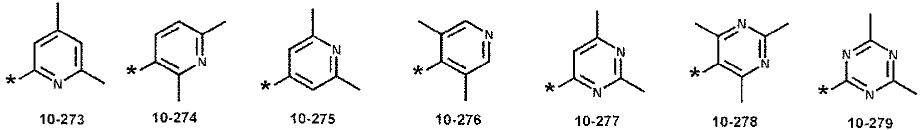 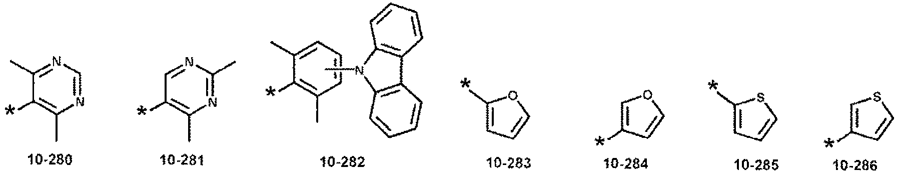 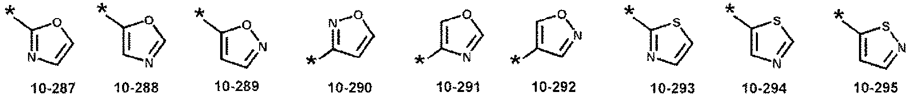 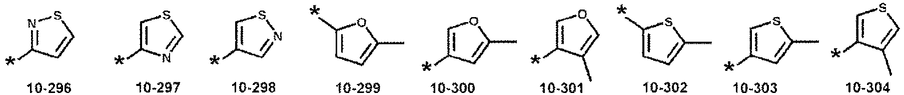 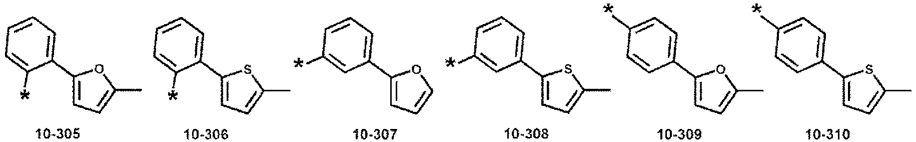 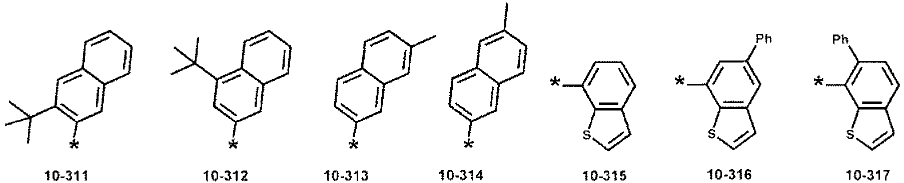 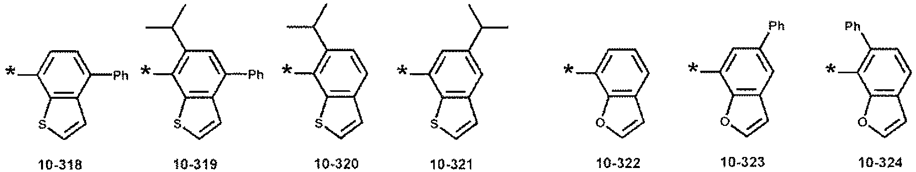 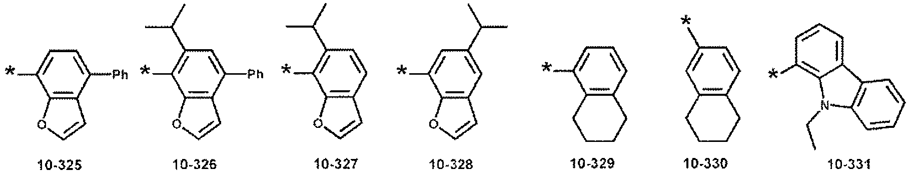 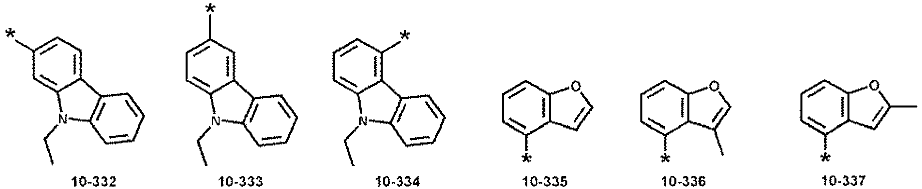 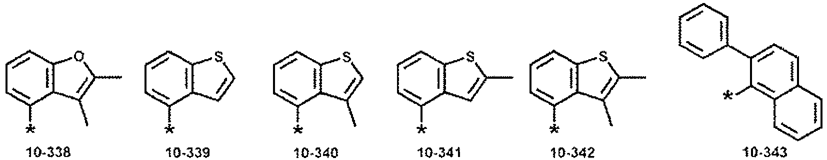 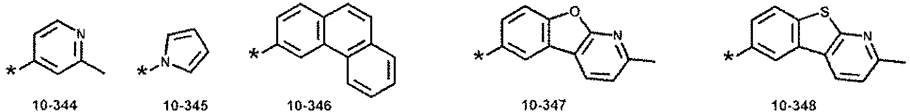 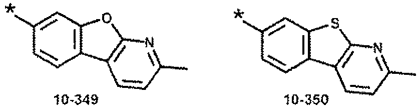
wherein, in Formulae 9-1 to 9-61, 9-201 to 9-244, 10-1 to 10-154, and 10-201 to 10-350, * indicates a binding site to an adjacent atom, "Ph" indicates a phenyl group, "TMS" indicates a trimethylsilyl group, and "TMG" indicates a trimethylgermyl group.

In one or more embodiments, R₁₀, R₂₀, R₃₀, R₄₀, R₅₀, R₆₀, R₇₀, R₈₀, and R₉₀ may each independently be:
hydrogen, deuterium, -F, -Cl, -Br, -I, -SF₅, -CD₃, -CD₂H, -CDH₂, -CF₃, - CF₂H, -CFH₂, a C₁-C₂₀ alkyl group, a C₂-C₂₀ alkenyl group, a C₂-C₂₀ alkynyl group, a C₁-C₂₀ alkoxy group, or a C₁-C₂₀ alkylthio group;
a group represented by one of Formulae 9-1 to 9-61, 9-201 to 9-244, 10-1 to 10-154, or 10-201 to 10-350; or
   -Si(Q_{1A})(Q_{2A})(Q_{3A}) or -Ge(Q_{1A})(Q_{2A})(Q_{3A}).

In Formulae 1 to 4, b10, b20, b30, b40, b50, b60, b70, b81, b82, b91, and b92 are each independently 1, 2, 3, 4, 5, 6, 7, 8, 9, 10, 11, 12, 13, or 14.

In one or more embodiments, b10, b20, b30, b40, b50, b60, b70, b81, b82, b91, and b92 may each independently be 1, 2, 3, 4, 5, 6, 7, or 8.

In one or more embodiments, b10, b20, b40, b50, b60, b70, b81, b82, and b91 may each independently be 1, 2, 3, or 4.

In one or more embodiments, b30 may be 1, 2, or 3.

In one or more embodiments, b92 may be 1, 2, 3, 4, or 5.

In Formulae 1 to 4, neighboring two or more of R₁₀, R₂₀, R₃₀, R₄₀, R₅₀, R₆₀, R₇₀, R₈₀, and R₉₀ are optionally bonded to each other to form a substituted or unsubstituted C₅-C₃₀ carbocyclic group or a substituted or unsubstituted C₁-C₃₀ heterocyclic group,
two or more of a plurality of R₁₀ are optionally bonded to each other to form a substituted or unsubstituted C₅-C₃₀ carbocyclic group or a substituted or unsubstituted C₁-C₃₀ heterocyclic group,
two or more of a plurality of R₂₀ are optionally bonded to each other to form a substituted or unsubstituted C₅-C₃₀ carbocyclic group or a substituted or unsubstituted C₁-C₃₀ heterocyclic group,
two or more of a plurality of R₃₀ are optionally bonded to each other to form a substituted or unsubstituted C₅-C₃₀ carbocyclic group or a substituted or unsubstituted C₁-C₃₀ heterocyclic group,
two or more of a plurality of R₄₀ are optionally bonded to each other to form a substituted or unsubstituted C₅-C₃₀ carbocyclic group or a substituted or unsubstituted C₁-C₃₀ heterocyclic group,
two or more of a plurality of R₅₀ are optionally bonded to each other to form a substituted or unsubstituted C₅-C₃₀ carbocyclic group or a substituted or unsubstituted C₁-C₃₀ heterocyclic group,
two or more of a plurality of R₆₀ are optionally bonded to each other to form a substituted or unsubstituted C₅-C₃₀ carbocyclic group or a substituted or unsubstituted C₁-C₃₀ heterocyclic group,
two or more of a plurality of R₇₀ are optionally bonded to each other to form a substituted or unsubstituted C₅-C₃₀ carbocyclic group or a substituted or unsubstituted C₁-C₃₀ heterocyclic group,
two or more of a plurality of R₈₀ are optionally bonded to each other to form a substituted or unsubstituted C₅-C₃₀ carbocyclic group or a substituted or unsubstituted C₁-C₃₀ heterocyclic group, and
two or more of a plurality of R₉₀ are optionally bonded to each other to form a substituted or unsubstituted C₅-C₃₀ carbocyclic group or a substituted or unsubstituted C₁-C₃₀ heterocyclic group.

In one or more embodiments, two or more of R₁₀, R₂₀, R₃₀, R₄₀, R₅₀, R₆₀, R₇₀, R₈₀, and R₉₀; two or more of a plurality of R₁₀; two or more of a plurality of R₂₀; two or more of a plurality of R₃₀; two or more of a plurality of R₄₀; two or more of a plurality of R₅₀; two or more of a plurality of R₆₀; two or more of a plurality of R₇₀; two or more of a plurality of R₈₀; and/or two or more of a plurality of R₉₀ may optionally be bonded to each other via a single bond, a double bond, or a first linking group to form a C₅-C₃₀ carbocyclic group unsubstituted or substituted with at least one R₁₀ₐ or a C₁-C₃₀ heterocyclic group unsubstituted or substituted with at least one R₁₀ₐ (e.g., a fluorene group, a xanthene group, an acridine group, or an azaborinane group, each unsubstituted or substituted with at least one R₁₀ₐ). The C₅-C₃₀ carbocyclic group and the C₁-C₃₀ heterocyclic group may each be as described herein. R₁₀ₐ may be as described herein in connection with R₁₀.

In one or more embodiments, non-limiting examples of the "C₅-C₃₀ carbocyclic group unsubstituted or substituted with at least one R₁₀ₐ or C₁-C₃₀ heterocyclic group unsubstituted or substituted with at least one R₁₀ₐ" include a benzene group, a naphthalene group, a cyclopentane group, a cyclopentadiene group, a cyclohexane group, a cycloheptane group, a bicyclo[2.2.1]heptane group, a fluorene group, a xanthene group, an acridine group, an azaborinane group, a furan group, a thiophene group, a pyrrole group, a silole group, an azaborinane group, an indene group, a benzofuran group, a benzothiophene group, an indole group, or a benzosilole group, each unsubstituted or substituted with at least one R₁₀ₐ. R₁₀ₐ may be as described herein in connection with R₁₀.

The first linking group may be *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C≡C-*', wherein R₈ and R₉ may each be as described in connection with R₁₀, and * and *' each indicate a binding site to a neighboring atom.

In one or more embodiments, the heterocyclic compound represented by Formula 1 may be represented by one of Formulae 11 to 17: 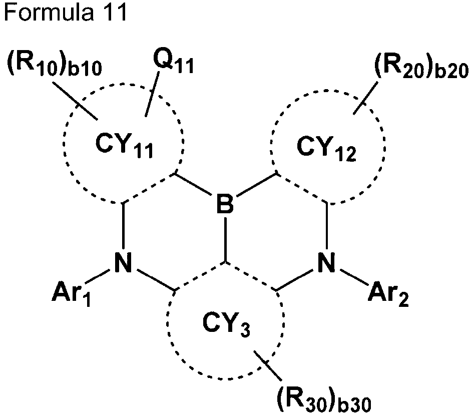 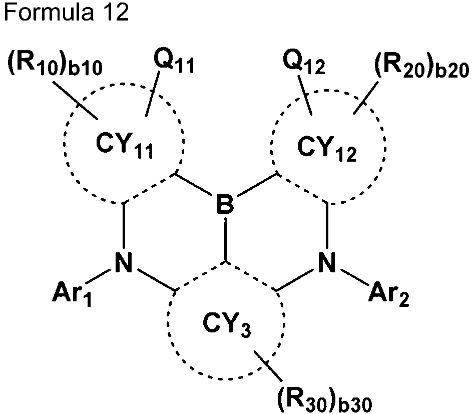 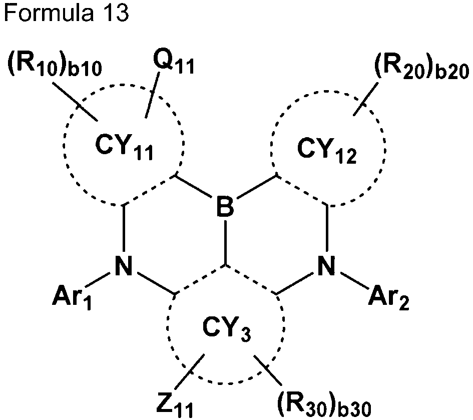 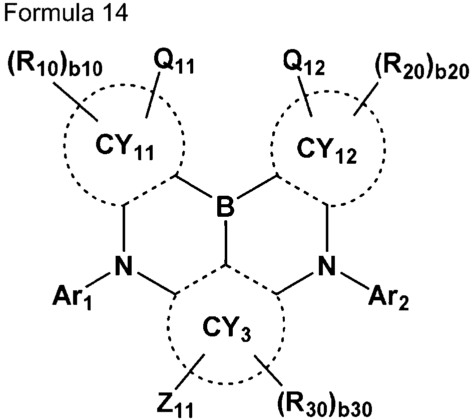 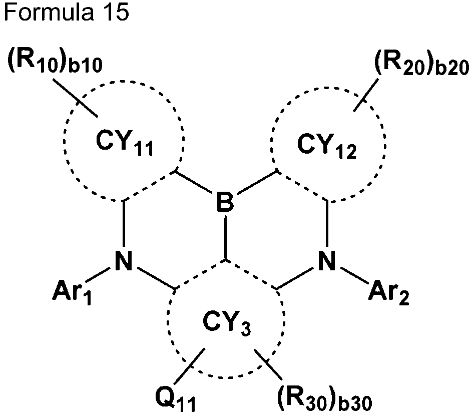 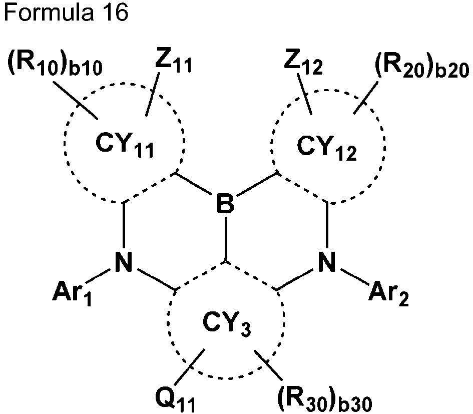 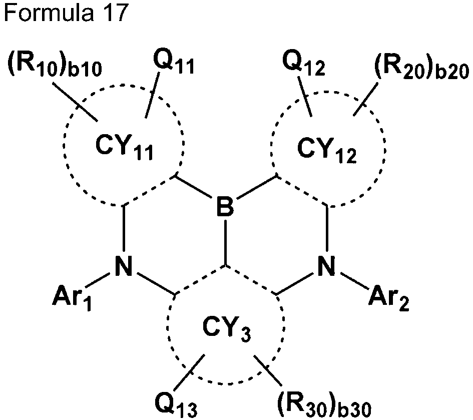 wherein, in Formulae 11 to 17,
ring CY₃, Ar₁, Ar₂, R₁₀, R₂₀, R₃₀, b10, b20, and b30 may each be as described herein,
ring CY₁₁ and ring CY₁₂ may each independently be a C₅-C₃₀ carbocyclic group or a C₁-C₃₀ heterocyclic group,
Q₁₁ to Q₁₃ may each independently be as described in connection with Q₁, and
Z₁₁ and Z₁₂ may each independently be as described in connection with Z₁.

In one or more embodiments, the heterocyclic compound represented by Formula 1 may be represented by one of Formulae 21 to 23: 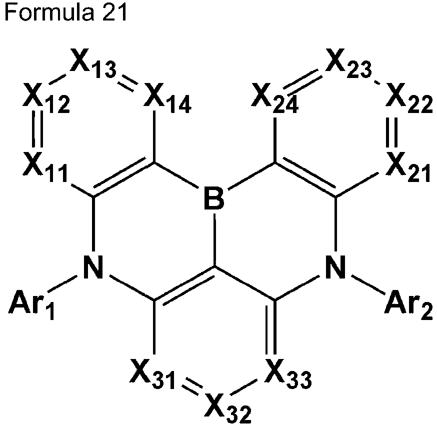 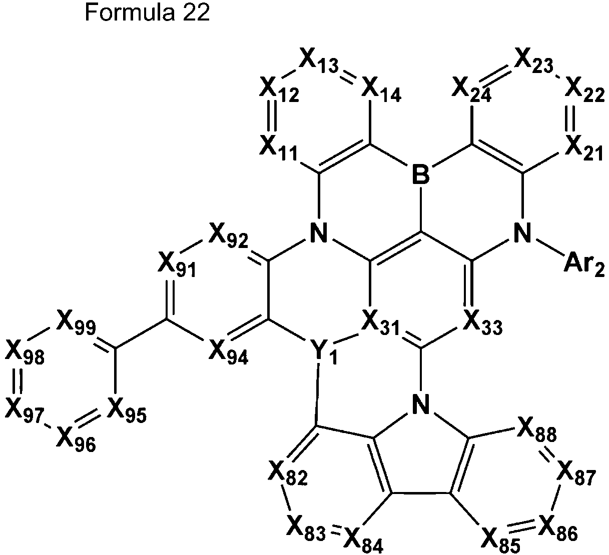 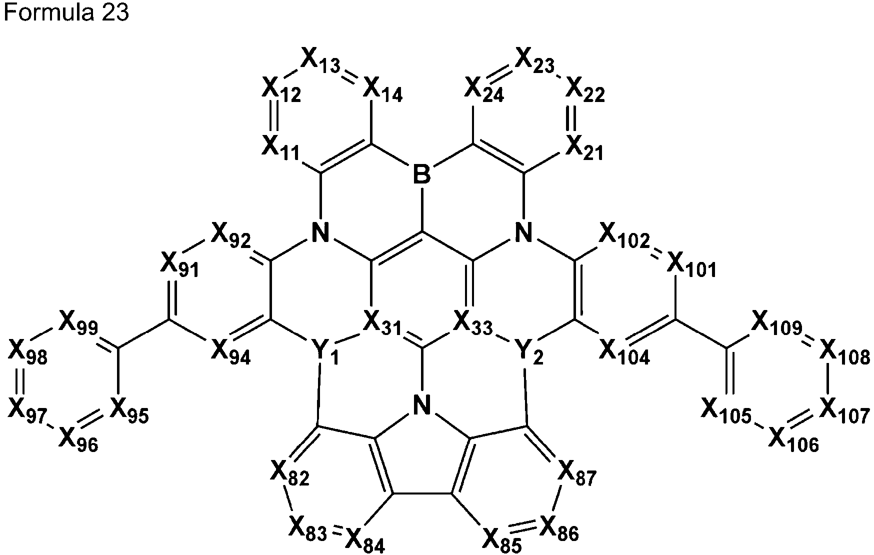 wherein, in Formulae 21 to 23,
Ar₁ and Ar₂ may each be as described herein,
Y₁ and Y₂ may each independently be B, N, P, P(=O), or P(=S),
X₁₁ may be C(Q₁), C(Z₁), C(R₁₁), or N, X₁₂ may be C(Q₁), C(Z₁), C(R₁₂), or N, X₁₃ may be C(Q₁), C(Z₁), C(R₁₃), or N, and X₁₄ may be C(Q₁), C(Z₁), C(R₁₄), or N,
X₂₁ may be C(Q₁), C(Z₁), C(R₂₁), or N, X₂₂ may be C(Q₁), C(Z₁), C(R₂₂), or N, X₂₃ may be C(Q₁), C(Z₁), C(R₂₃), or N, and X₂₄ may be C(Q₁), C(Z₁), C(R₂₄), or N,
in Formula 21, X₃₁ may be C(Q₁), C(Z₁), C(R₃₁), or N, X₃₂ may be C(Q₁), C(Z₁), C(R₃₂), or N, and X₃₃ may be C(Q₁), C(Z₁), C(R₃₃), or N; in Formula 22, X₃₁ may be C, and X₃₃ may be C(Q₁), C(Z₁), C(R₃₃), or N; in Formula 23, X₃₁ and X₃₃ may each be C,
X₈₂ may be C(R₈₂) or N, X₈₃ may be C(R₈₃) or N, X₈₄ may be C(R₈₄) or N, X₈₅ may be C(R₈₅) or N, X₈₆ may be C(R₈₆) or N, X₈₇ may be C(R₈₇) or N, and X₈₈ may be C(R₈₈) or N,
X₉₁ may be C(R₉₁) or N, X₉₂ may be C(R₉₂) or N, X₉₄ may be C(R₉₄) or N, X₉₅ may be C(R₉₅) or N, X₉₆ may be C(R₉₆) or N, X₉₇ may be C(R₉₇) or N, X₉₈ may be C(R₉₈) or N, and X₉₉ may be C(R₉₉) or N,
X₁₀₁ may be C(R₁₀₁) or N, X₁₀₂ may be C(R₁₀₂) or N, X₁₀₄ may be C(R₁₀₄) or N, X₁₀₅ may be C(R₁₀₅) or N, X₁₀₆ may be C(R₁₀₆) or N, X₁₀₇ may be C(R₁₀₇) or N, X₁₀₈ may be C(R₁₀₈) or N, and X₁₀₉ may be C(R₁₀₉) or N,
at least one of X₁₁ to X₁₄, X₂₁ to X₂₄, or X₃₁ to X₃₃ in Formula 21 may be C(Q₁),
at least one of X₁₁ to X₁₄ or X₂₁ to X₂₄ in Formulae 22 and 23 may be C(Q₁),
R₁₁ to R₁₄ may each independently be as described in connection with R₁₀,
R₂₁ to R₂₄ may each independently be as described in connection with R₂₀,
R₃₁ to R₃₃ may each independently be as described in connection with R₃₀,
R₈₂ to R₈₈ may each independently be as described in connection with R₈₀, and
R₉₁, R₉₂, R₉₄ to R₉₉, R₁₀₁, R₁₀₂, and R₁₀₄ to R₁₀₉ may each independently be as described in connection with R₉₀.

In one or more embodiments, Y₁ and Y₂ in Formulae 22 and 23 may each be B.

In one or more embodiments, the heterocyclic compound represented by Formula 1 may be represented by one of Formulae 31 to 42: 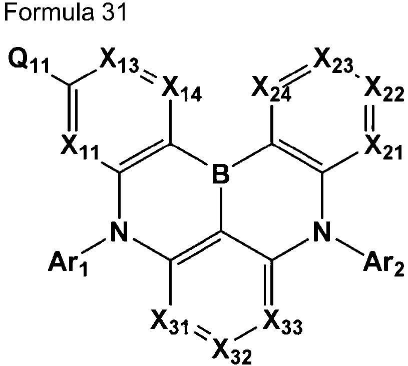 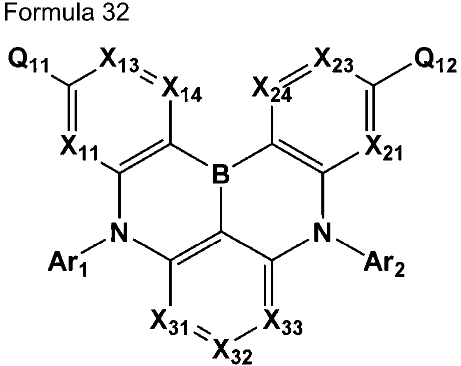 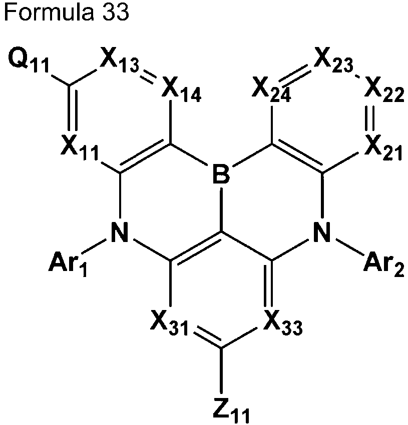 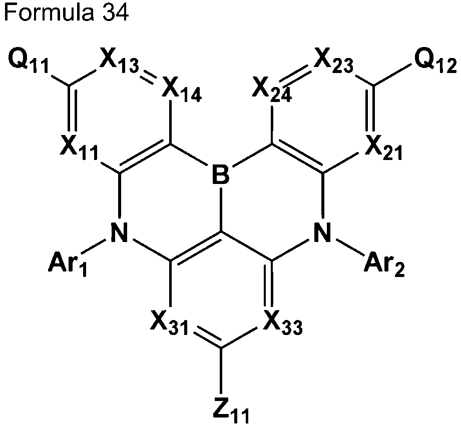 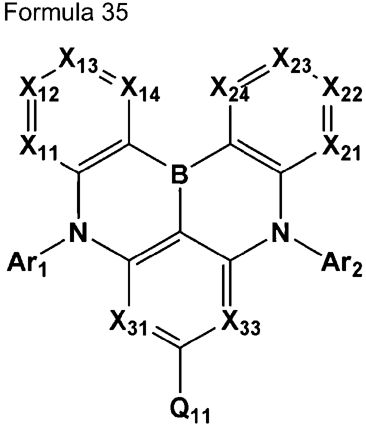 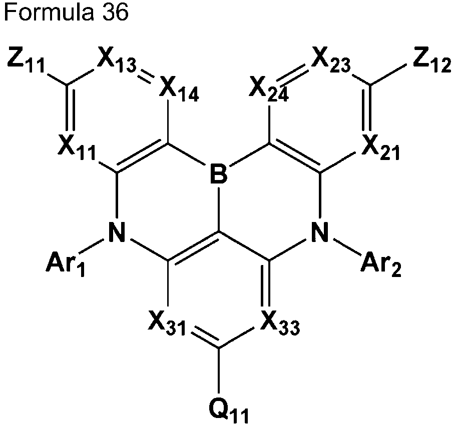 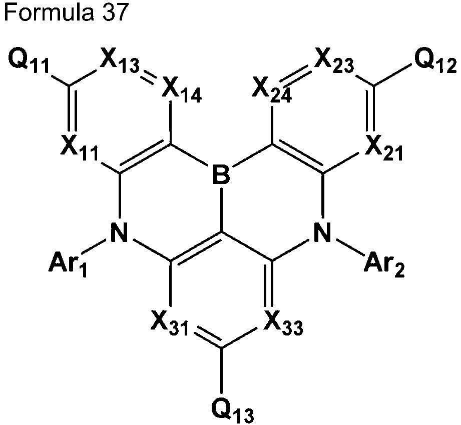 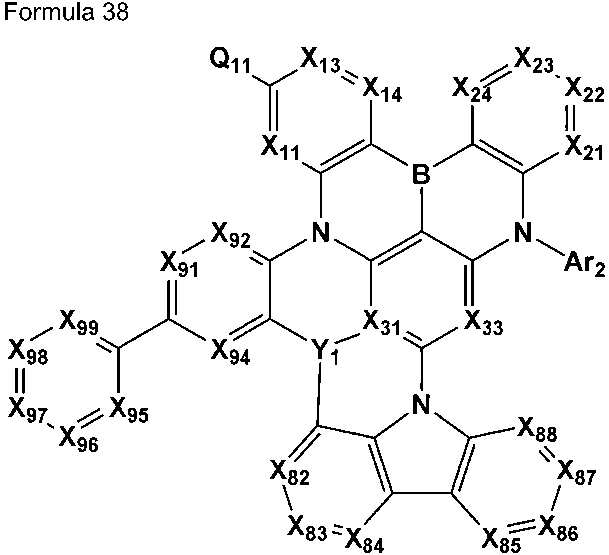 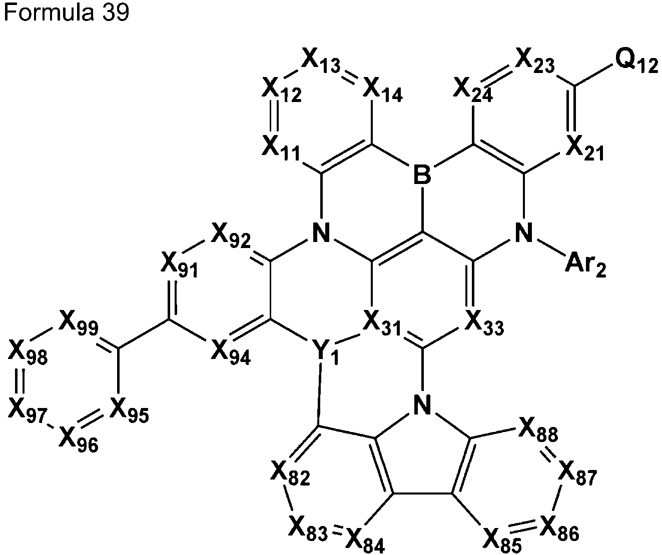 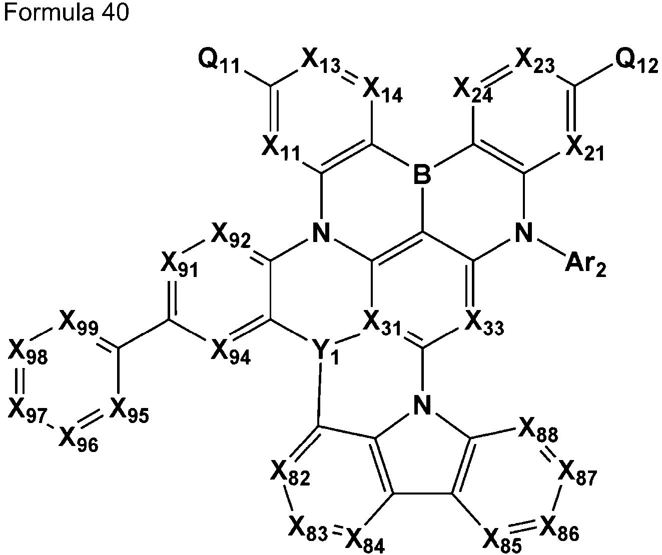 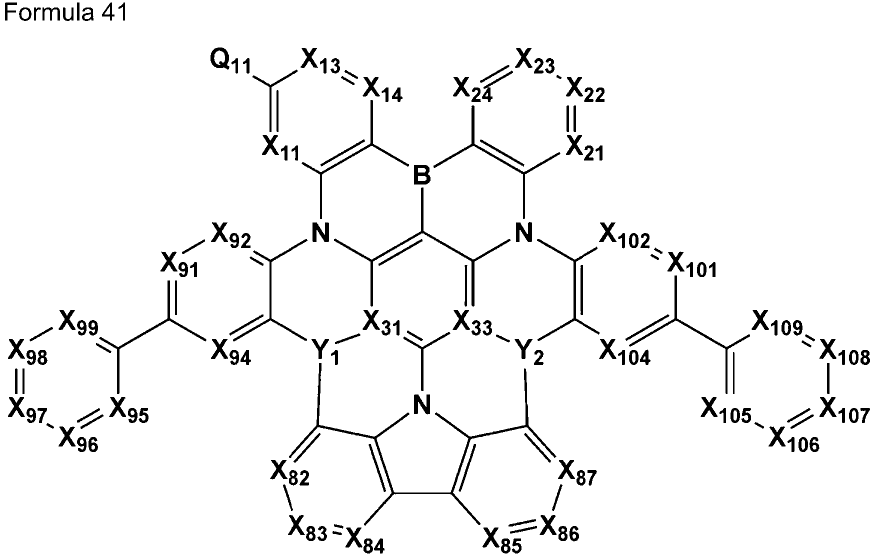 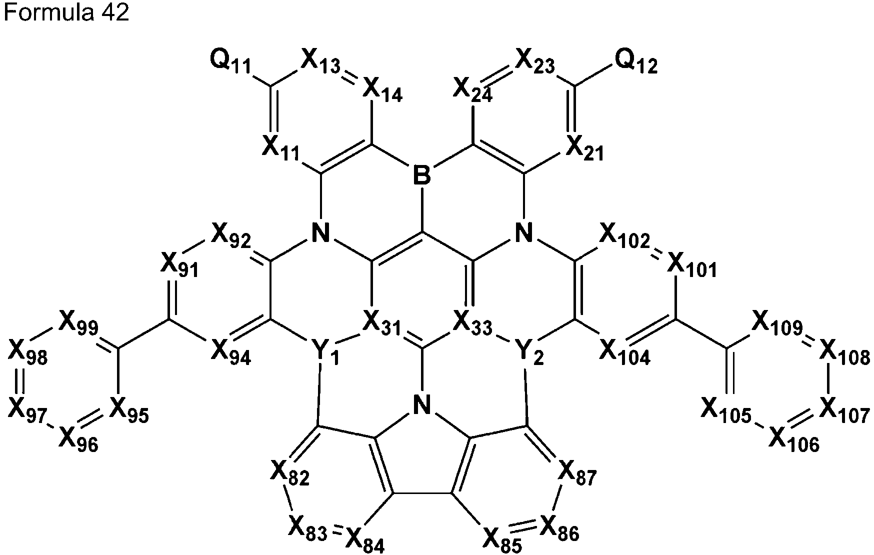 wherein, in Formulae 31 to 42,
Ar₁ and Ar₂ may each be as described herein,
Y₁ and Y₂ may each independently be B, N, P, P(=O), or P(=S),
Q₁₁ to Q₁₃ may each independently be as described in connection with Q_{A},
Z₁₁ and Z₁₂ may each independently be as described in connection with Z₁,
X₁₁ may be C(R₁₁) or N, X₁₂ may be C(R₁₂) or N, X₁₃ may be C(R₁₃) or N, and X₁₄ may be C(R₁₄) or N,
X₂₁ may be C(R₂₁) or N, X₂₂ may be C(R₂₂) or N, X₂₃ may be C(R₂₃) or N, and X₂₄ may be C(R₂₄) or N,
in Formulae 31 to 37, X₃₁ may be C(R₃₁) or N, X₃₂ may be C(R₃₂) or N, and X₃₃ may be C(R₃₃) or N; in Formulae 38 to 40, X₃₁ may be C, and X₃₃ may be C(R₃₃) or N; in Formulae 41 and 42, X₃₁ and X₃₃ may be each C,
X₈₂ may be C(R₈₂) or N, X₈₃ may be C(R₈₃) or N, X₈₄ may be C(R₈₄) or N, X₈₅ may be C(R₈₅) or N, X₈₆ may be C(R₈₆) or N, X₈₇ may be C(R₈₇) or N, and X₈₈ may be C(R₈₈) or N,
X₉₁ may be C(R₉₁) or N, X₉₂ may be C(R₉₂) or N, X₉₄ may be C(R₉₄) or N, X₉₅ may be C(R₉₅) or N, X₉₆ may be C(R₉₆) or N, X₉₇ may be C(R₉₇) or N, X₉₈ may be C(R₉₈) or N, and X₉₉ may be C(R₉₉) or N,
X₁₀₁ may be C(R₁₀₁) or N, X₁₀₂ may be C(R₁₀₂) or N, X₁₀₄ may be C(R₁₀₄) or N, X₁₀₅ may be C(R₁₀₅) or N, X₁₀₆ may be C(R₁₀₆) or N, X₁₀₇ may be C(R₁₀₇) or N, X₁₀₈ may be C(R₁₀₈) or N, and X₁₀₉ may be C(R₁₀₉) or N,
R₁₁ to R₁₄ may each independently be as described in connection with R₁₀,
R₂₁ to R₂₄ may each independently be as described in connection with R₂₀,
R₃₁ to R₃₃ may each independently be as described in connection with R₃₀,
R₈₂ to R₈₈ may each independently be as described in connection with R₈₀, and
R₉₁, R₉₂, R₉₄ to R₉₉, R₁₀₁, R₁₀₂, and R₁₀₄ to R₁₀₉ may each independently be as described in connection with R₉₀.

In one or more embodiments, Y₁ and Y₂ in Formulae 36 to 40 may each be B.

Q_{1A} to Q_{3A}, Q_{11A} to Q_{13A}, Q_{21A} to Q_{23A}, and Q_{31A} to Q_{33A} as used herein are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group; or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

In one or more embodiments, Q_{1A} to Q_{3A}, Q_{11A} to Q_{13A}, Q_{21A} to Q_{23A}, and Q_{31A} to Q_{33A} may each independently be:
hydrogen; deuterium; -F; -Cl; -Br; -I; -SF₅, a hydroxyl group; a cyano group; a nitro group; an amino group, an amidino group; a hydrazine group; a hydrazone group; a carboxylic acid group or a salt thereof; a sulfonic acid group or a salt thereof; a phosphoric acid group or a salt thereof; a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, or a C₁-C₁₀ heterocycloalkenyl group, each unsubstituted or substituted with deuterium, -F, -Cl, -Br, -I, -SF₅, a cyano group, a C₁-C₆₀ alkyl group, a C₆-C₆₀ aryl group, or a combination thereof; a C₆-C₆₀ aryl group, a C₆-C₆₀ aryloxy group, or a C₆-C₆₀ arylthio group, each unsubstituted or substituted with deuterium, -F, -Cl, -Br, -I, -SF₅, a cyano group, a C₁-C₆₀ alkyl group, a C₆-C₆₀ aryl group, or a combination thereof; a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -SF₅, a cyano group, a C₁-C₆₀ alkyl group, a C₆-C₆₀ aryl group, or a combination thereof.

In one or more embodiments, Q_{1A} to Q_{3A}, Q_{11A} to Q_{13A}, Q_{21A} to Q_{23A}, and Q_{31A} to Q_{33A} may each independently be:
hydrogen, deuterium, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, - CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

In one or more embodiments, the heterocyclic compound represented by Formula 1 may include one or more boron (B) atoms.

In one or more embodiments, the heterocyclic compound represented by Formula 1 may include one to three B atoms.

In one or more embodiments, the heterocyclic compound represented by Formula 1 may have a symmetrical structure or an asymmetrical structure.

In one or more embodiments, the heterocyclic compound represented by Formula 1 may be at least one of Compounds 1 to 75:

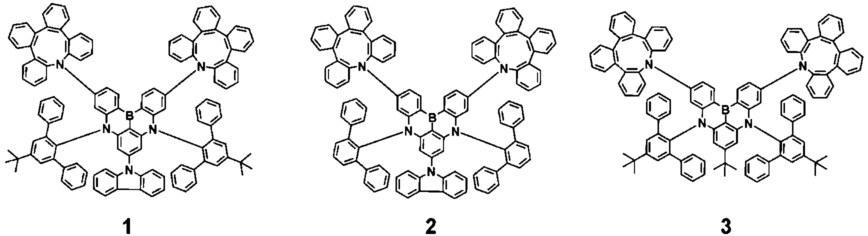

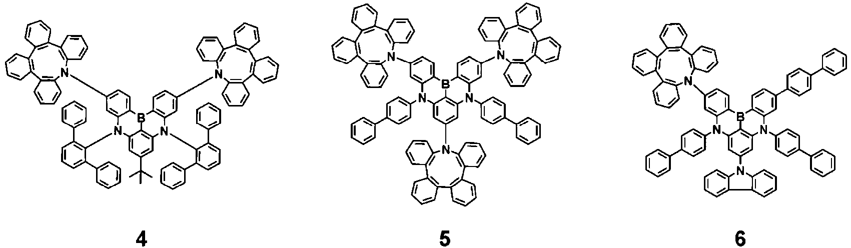

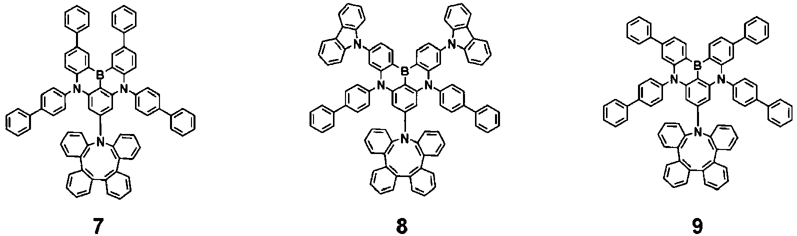

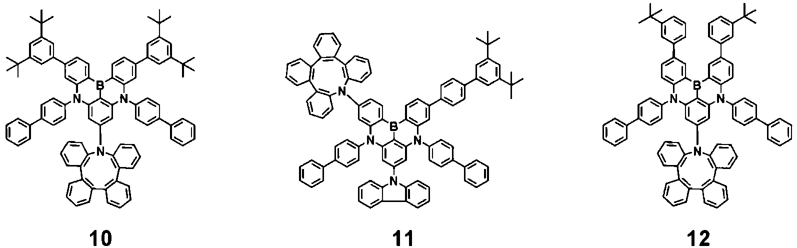

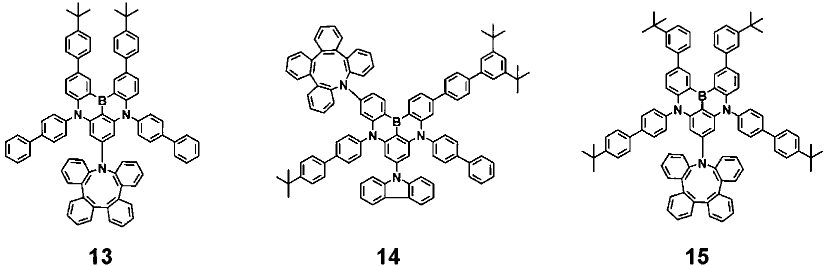

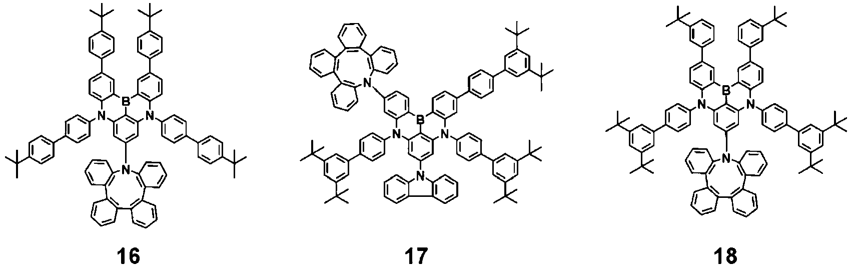

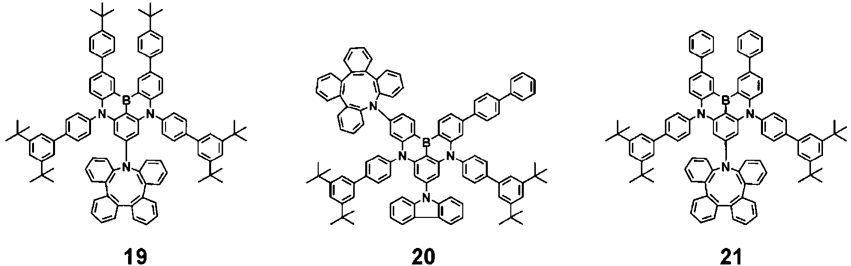

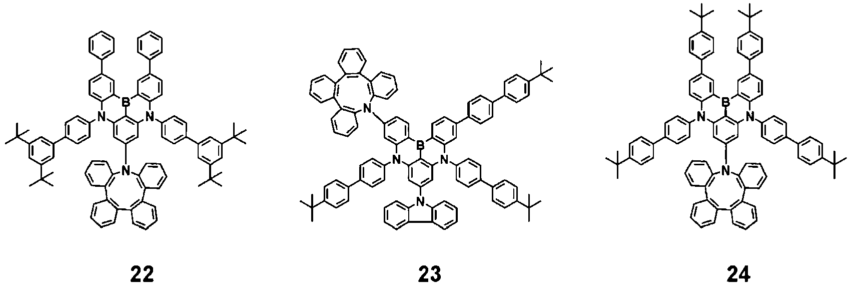

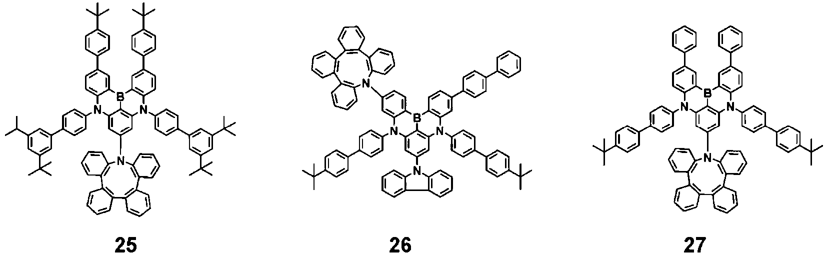

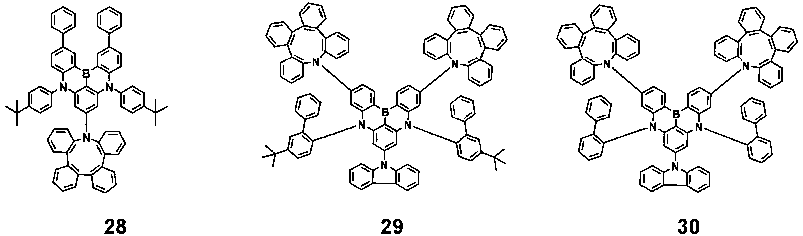

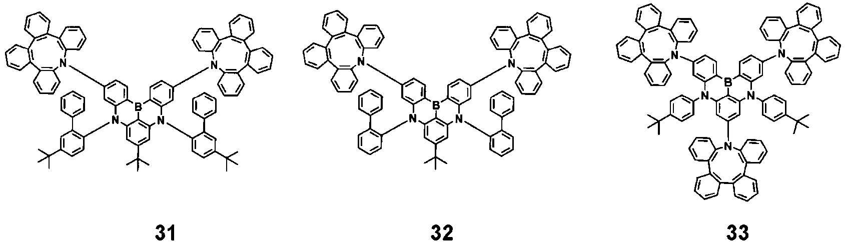

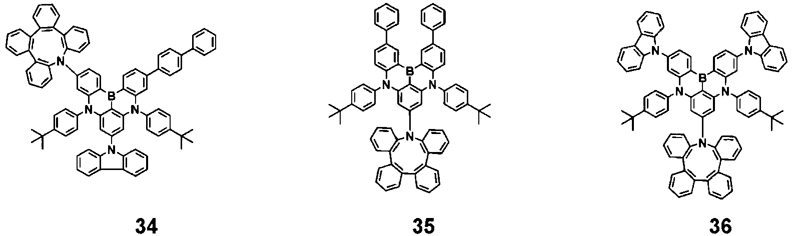

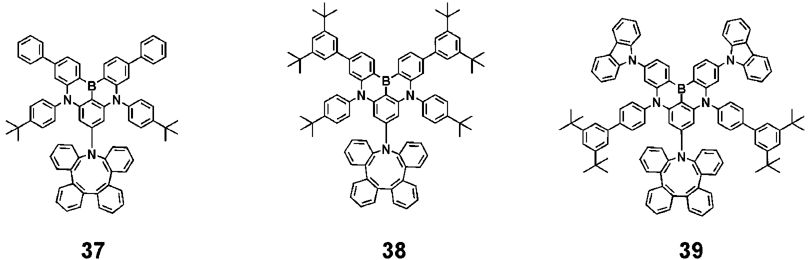

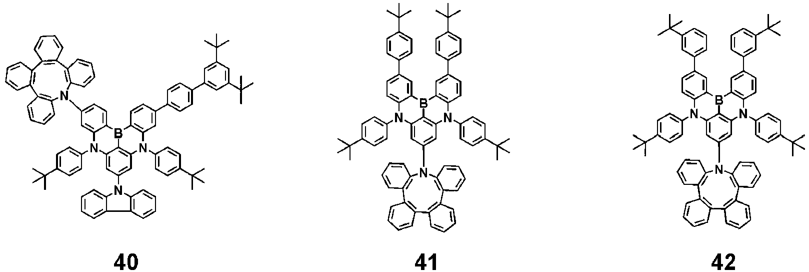

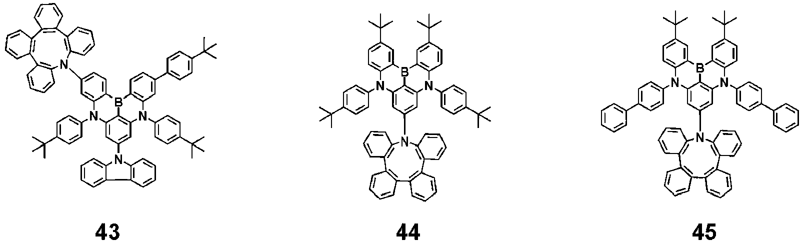

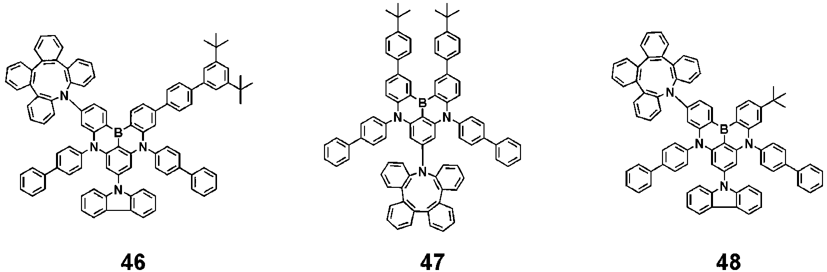

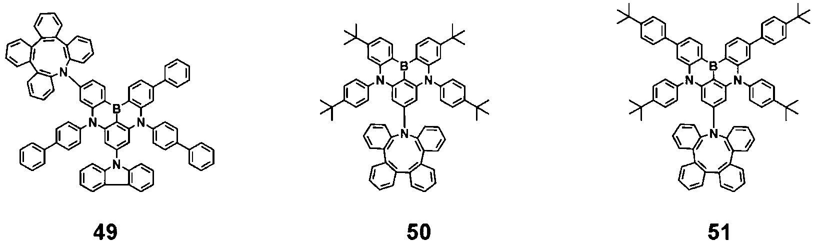

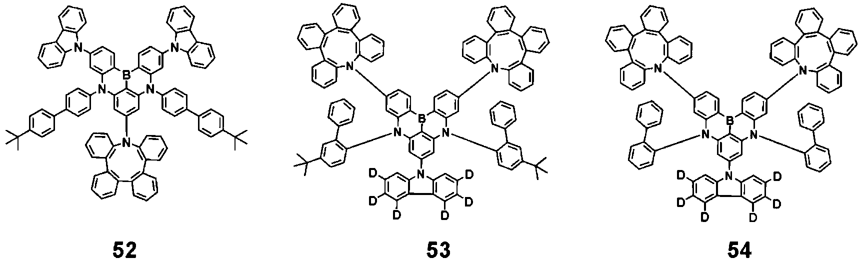

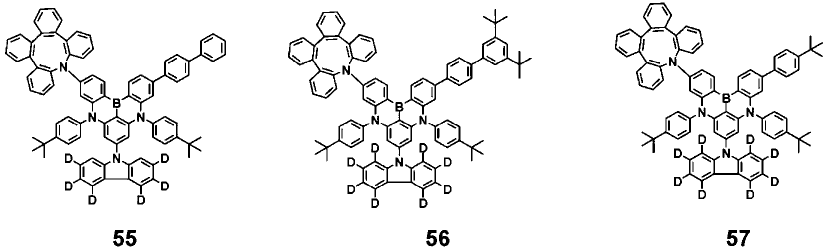

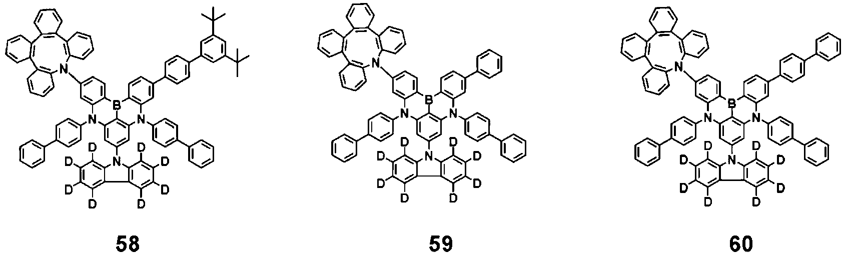

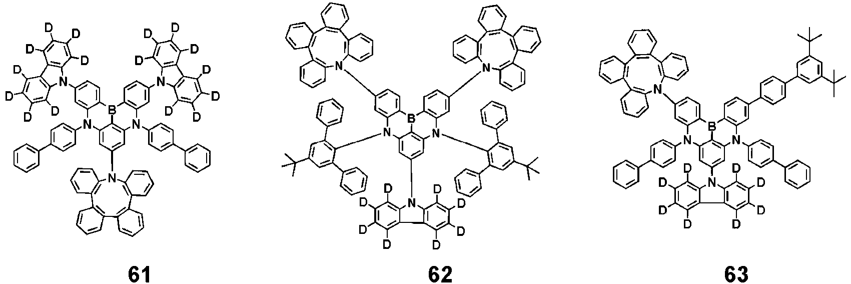

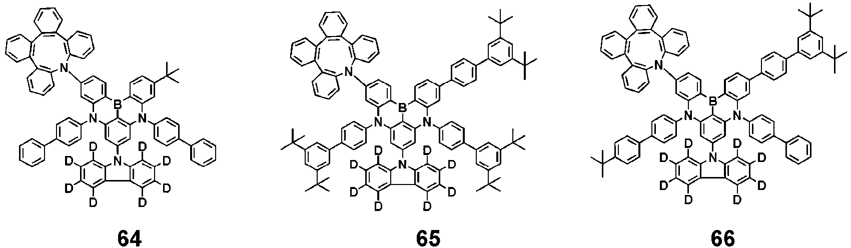

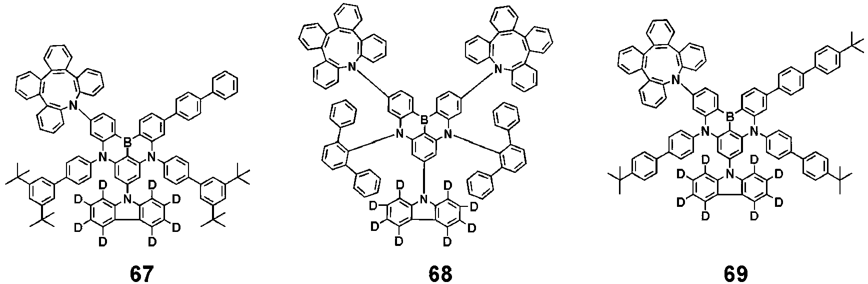

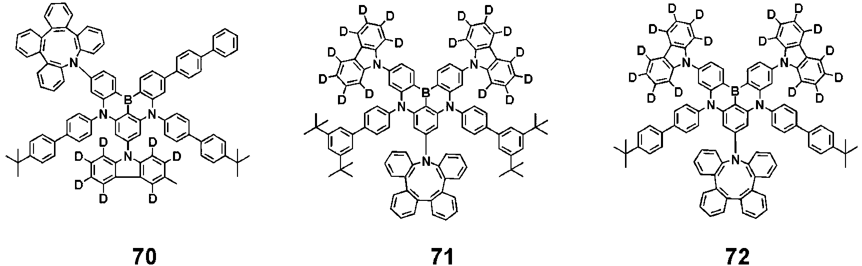

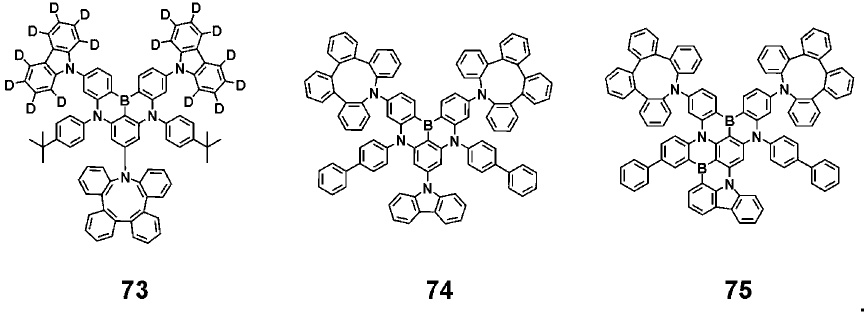

The heterocyclic compound represented by Formula 1 satisfies the structure of Formula 1 as described above, and has excellent luminescence efficiency due to this structure.

Although not limited by any particular theory, the heterocyclic compound represented by Formula 1 may have a structure in which at least one Q₁ having a bulky structure represented by Formula 2 is substituted in a skeleton represented by Formula 1, resulting in increased shielding of boron atoms. Also, the heterocyclic compound represented by Formula 1 may have a high S₁ energy level due to an electron donating effect, may achieve a high color purity due to suppression of intermolecular interactions, and may have high optical orientation. Thus, when the heterocyclic compound represented by Formula 1 is used as a luminescent material, Dexter energy transfer may be suppressed, resulting in excellent lifespan and efficiency characteristics.

Accordingly, an electronic device, for example, an organic light-emitting device, including the heterocyclic compound represented by Formula 1 may exhibit high efficiency, high color purity, and/or long lifespan.

In one or more embodiments, the full width at half maximum (FWHM) of the emission peak in an emission spectrum or an electroluminescence (EL) spectrum of the heterocyclic compound represented by Formula 1 may be about 60 nanometers (nm) or less. For example, the FWHM of the emission peak in the emission spectrum or the EL spectrum of the heterocyclic compound represented by Formula 1 may be about 5 nm to about 50 nm, about 7 nm to about 40 nm, or about 10 nm to about 30 nm.

Synthesis methods of the heterocyclic compound represented by Formula 1 may be recognizable by one of ordinary skill in the art by referring to Synthesis Examples to be described herein.

Methods for confirming the structure of the heterocyclic compound represented by Formula 1 are not particularly limited. In one or more embodiments, the structure of the heterocyclic compound represented by Formula 1 may be confirmed by known methods (e.g., NMR, LC-MS, etc.).

### Organic light-emitting device

Another aspect provides an organic light-emitting device including the heterocyclic compound represented by Formula 1.

In one or more embodiments, the organic light-emitting device may include a first electrode; a second electrode; and an organic layer arranged between the first electrode and the second electrode, wherein the organic layer includes an emission layer, and
wherein the organic layer further includes the heterocyclic compound represented by Formula 1.

In one or more embodiments, the emission layer may include the heterocyclic compound represented by Formula 1.

In one or more embodiments, the emission layer may include a host and an emitter, and the emitter may include the heterocyclic compound represented by Formula 1.

In one or more embodiments, on a weight basis, the amount of the host in emission layer may be greater than the amount of the heterocyclic compound represented by Formula 1 in the emission layer.

In one or more embodiments, the emission layer may further include a sensitizer.

In one or more embodiments, the sensitizer may include a phosphorescent compound (e.g., an organometallic compound), a delayed fluorescence compound, or a combination thereof.

The host, the emitter, and the sensitizer may each be as described herein.

The organic light-emitting device may have a relatively narrow EL spectrum emission peak FWHM and excellent efficiency and lifespan characteristics, by including the emission layer including the heterocyclic compound represented by Formula 1 as described herein.

In one or more embodiments, the heterocyclic compound represented by Formula 1 may act as a dopant (e.g., an emitter or a sensitizer) in the emission layer, and the emission layer may further include a host (i.e., in the emission layer, the amount of the heterocyclic compound represented by Formula 1 may be less than the amount of the host, based on weight).

In one or more embodiments, the emission layer may emit a blue light. For example, the emission layer may emit a blue light having a maximum emission wavelength of about 410 nm to about 490 nm.

In one or more embodiments, the emission layer may emit a deep blue light having a maximum emission wavelength of about 410 nm to about 465 nm. For example, the emission layer may emit a deep blue light having a maximum emission wavelength of about 410 nm to about 450 nm.

The expression "(an emission layer) includes at least one heterocyclic compound represented by Formula 1" as used herein may include a case in which "(an emission layer) includes identical heterocyclic compounds represented by Formula 1" and a case in which "(an emission layer) includes two or more different heterocyclic compounds represented by Formula 1."

In one or more embodiments, the emission layer may include, as the heterocyclic compound represented by Formula 1, only Compound 1. In this regard, Compound 1 may be present in the emission layer of the organic light-emitting device. In one or more embodiments, the emission layer may include, as the heterocyclic compound represented by Formula 1, Compound 1 and Compound 2.

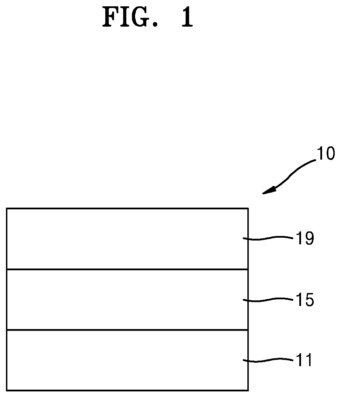

### Description of FIG. 1

FIG. 1 is a schematic cross-sectional view of an organic light-emitting device 10 according to one or more embodiments. Hereinafter, the structure of an organic light-emitting device according to one or more embodiments and a method of manufacturing an organic light-emitting device according to one or more embodiments will be described in further detail with reference to FIG. 1.

The organic light-emitting device 10 of FIG. 1 includes a first electrode 11, a second electrode 19 facing the first electrode 11, and an organic layer 15 arranged between the first electrode 11 and the second electrode 19.

The organic layer 15 may include an emission layer, a hole transport region may be arranged between the first electrode 11 and the emission layer, and an electron transport region may be arranged between the emission layer and the second electrode 19.

A substrate may be additionally arranged under the first electrode 11 or above the second electrode 19. For use as the substrate, any suitable substrate that is used in organic light-emitting devices available in the art may be used, and the substrate may be a glass substrate or a transparent plastic substrate, each having excellent mechanical strength, thermal stability, transparency, surface smoothness, ease of handling, and/or water resistance.

### First electrode 11

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a transflective electrode, or a transmissive electrode. When the first electrode 11 is a transmissive electrode, the material for forming the first electrode 11 may be indium tin oxide (ITO), indium zinc oxide (IZO), tin oxide (SnO₂), zinc oxide (ZnO), or a combination thereof, but embodiments are not limited thereto. In one or more embodiments, when the first electrode 11 is a transflective electrode or a reflective electrode, the material for forming the first electrode 11 may be magnesium (Mg), silver (Ag), aluminum (Al), aluminum-lithium (Al-Li), calcium (Ca), magnesium-indium (Mg-In), magnesium-silver (Mg-Ag), or a combination thereof, but embodiments are not limited thereto.

The first electrode 11 may have a single-layer structure or a multi-layer structure including two or more layers.

### Emission layer

The emission layer may include the heterocyclic compound represented by Formula 1.

The thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

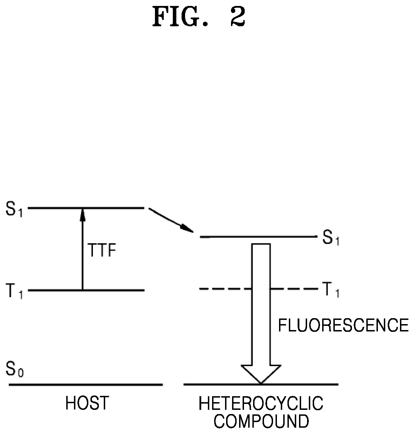

### Description of FIG. 2

In one or more embodiments, the heterocyclic compound represented by Formula 1 may be a fluorescent emitter.

In one or more embodiments, the emission layer may further include a host (hereinafter, referred to as "Host A", and Host A may not be identical to the heterocyclic compound represented by Formula 1). Host A may be understood by referring to host materials to be described herein, but embodiments are not limited thereto. Host A may be a fluorescent host.

Energy transfer according to one or more embodiments will be described with reference to FIG. 2.

Singlet excitons are formed in Host A in the emission layer, and the singlet excitons formed in Host A are transferred to a fluorescent emitter through Förster energy transfer (or Förster resonance energy transfer (FRET)).

Since the proportion of singlet excitons formed in Host A is only 25 %, the efficiency of the organic light-emitting device may be further improved by allowing 75 % of triplet excitons formed in Host A to be fused with each other and converted into singlet excitons. That is, the efficiency of the organic light-emitting device may be further improved by using a triplet-triplet fusion (TTF) mechanism.

In one or more embodiments, the proportion of emission components emitted from the heterocyclic compound represented by Formula 1, among the total emission components emitted from the emission layer, may be about 80 % or more, for example, about 90 % or more. For example, the proportion of emission components emitted from the heterocyclic compound represented by Formula 1, among the total emission components emitted from the emission layer, may be about 95 % or more.

In this regard, the heterocyclic compound represented by Formula 1 may emit fluorescence, and the host may not emit light.

In one or more embodiments, when the emission layer further includes Host A, in addition to the heterocyclic compound represented by Formula 1, the amount of the heterocyclic compound represented by Formula 1 may be about 50 parts by weight or less, for example, about 30 parts by weight or less, based on 100 parts by weight of the emission layer, and the amount of Host A in the emission layer may be about 50 parts by weight or more, for example, about 70 parts by weight or more, based on 100 parts by weight of the emission layer, but embodiments are not limited thereto.

In one or more embodiments, when the emission layer further includes Host A, in addition to the heterocyclic compound represented by Formula 1, Host A and the heterocyclic compound represented by Formula 1 may satisfy Condition A: $E {\left({H}_{A}\right)}_{S 1} > {E}_{S 1}$ Condition a wherein, in Condition A,
E(H_{A})_{S1} indicates the lowest excited singlet energy level of Host A, and
E_{S1} indicates the lowest excited singlet energy level of the heterocyclic compound represented by Formula 1.

E(H_{A})_{S1} and E_{S1} may be evaluated using the density functional theory (DFT) method of the Gaussian program, which is structure-optimized at the B3LYP/6-31G(d,p) level.

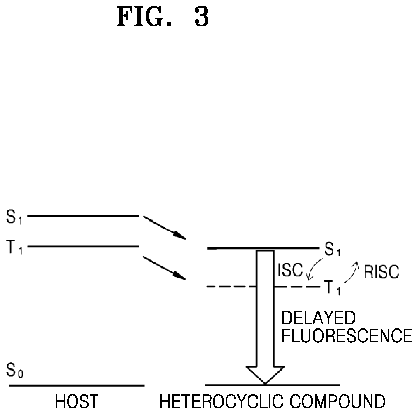

### Description of FIG. 3

In one or more embodiments, the heterocyclic compound represented by Formula 1 may be a delayed fluorescence emitter.

In one or more embodiments, the emission layer may further include a host (hereinafter, referred to as "Host B", and Host B may not be identical to the heterocyclic compound represented by Formula 1). Host B may be understood by referring to host materials to be described herein, but embodiments are not limited thereto.

Energy transfer according to one or more embodiments will be described with reference to FIG. 3.

25 % of singlet excitons formed in Host B in the emission layer are transferred to a delayed fluorescence emitter through FRET. In addition, 75 % of triplet excitons formed in Host B in the emission layer are transferred to the delayed fluorescence emitter through Dexter energy transfer. At least a portion of the singlet energy of the delayed fluorescence emitter may be transferred to the triplet state by intersystem crossing (ISC). The energy transferred to the triplet state of the delayed fluorescence emitter may undergo reverse intersystem crossing (RISC) to the singlet state. Accordingly, by transferring all the singlet excitons and triplet excitons generated in the emission layer to the heterocyclic compound represented by Formula 1, an organic light-emitting device having improved efficiency may be obtained.

In one or more embodiments, the proportion of emission components emitted from the heterocyclic compound represented by Formula 1, among the total emission components emitted from the emission layer, may be about 80 % or more, for example, about 90 % or more. For example, the proportion of emission components emitted from the heterocyclic compound represented by Formula 1, among the total emission components emitted from the emission layer, may be about 95 % or more.

In this regard, the heterocyclic compound represented by Formula 1 may emit fluorescence and/or delayed fluorescence, and the emission components of the heterocyclic compound represented by Formula 1 are the sum of prompt emission components of the heterocyclic compound represented by Formula 1 and delayed fluorescence components resulting from RISC of the heterocyclic compound represented by Formula 1. In addition, Host B may not emit light.

In one or more embodiments, when the emission layer further includes Host B, in addition to the heterocyclic compound represented by Formula 1, the amount of the heterocyclic compound represented by Formula 1 may be about 50 parts by weight or less, for example, about 30 parts by weight or less, based on 100 parts by weight of the emission layer, and the amount of Host B in the emission layer may be about 50 parts by weight or more, for example, about 70 parts by weight or more, based on 100 parts by weight of the emission layer, but embodiments are not limited thereto.

In one or more embodiments, when the emission layer further includes Host B, in addition to the heterocyclic compound represented by Formula 1, Host B and the heterocyclic compound represented by Formula 1 may satisfy Condition B: $E {\left({H}_{B}\right)}_{S 1} > {E}_{S 1}$ Condition b wherein, in Condition B,
E(H_{B})_{S1} indicates the lowest excited singlet energy level of Host B, and
E_{S1} indicates the lowest excited singlet energy level of the heterocyclic compound represented by Formula 1.

E(H_{B})_{S1} and E_{S1} may be evaluated using the DFT method of the Gaussian program, which is structure-optimized at the B3LYP/6-31G(d,p) level.

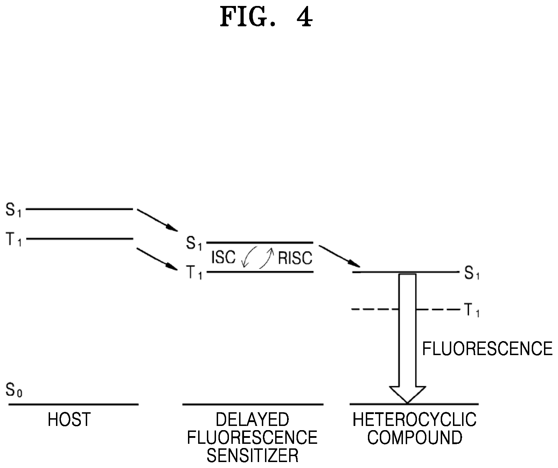

### Description of FIG. 4

In one or more embodiments, the heterocyclic compound represented by Formula 1 may be used as a fluorescent emitter, and the emission layer may include a sensitizer, for example, a delayed fluorescence sensitizer. In one or more embodiments, the emission layer may further include a host (hereinafter, referred to as "Host C", and Host C may not be identical to the heterocyclic compound represented by Formula 1 or the sensitizer) and a sensitizer (hereinafter, referred to as "Sensitizer A", and Sensitizer A may not be identical to Host C or the heterocyclic compound represented by Formula 1). Host C and Sensitizer A may respectively be understood by referring to host materials and sensitizer materials to be described herein, but embodiments are not limited thereto.

In one or more embodiments, the proportion of emission components of the heterocyclic compound represented by Formula 1, among the total emission components emitted from the emission layer, may be about 80 % or more, for example, about 90 % or more (e.g., about 95 % or more). For example, the heterocyclic compound represented by Formula 1 may emit fluorescence. In addition, each of Host C and Sensitizer A may not emit light.

Energy transfer according to one or more embodiments will be described with reference to FIG. 4.

Singlet and triplet excitons are formed in Host C in the emission layer, and the singlet and triplet excitons formed in Host C are transferred to Sensitizer A and then transferred to the heterocyclic compound through FRET. 25 % of singlet excitons formed in Host C are transferred to Sensitizer A through FRET, and the energy of 75 % of triplet excitons formed in Host C is transferred to the singlet and triplet states of Sensitizer A. At least a portion of the singlet energy of Sensitizer A may be transferred to the triplet state by ISC. The energy transferred to the triplet state of Sensitizer A undergoes RISC to the singlet state, and then, the singlet energy of Sensitizer A is transferred to the heterocyclic compound represented by Formula 1 through FRET.

Accordingly, by transferring all of the singlet excitons and triplet excitons generated in the emission layer to a dopant (e.g., an emitter), an organic light-emitting device having improved efficiency may be obtained. In addition, since an organic light-emitting device with significantly reduced energy loss may be obtained, the lifespan characteristics of the organic light-emitting device may be improved.

Referring to FIG. 4, when the emission layer further includes Host C and Sensitizer A, in addition to the heterocyclic compound represented by Formula 1, Host C, Sensitizer A and the heterocyclic compound represented by Formula 1 may satisfy Condition C-1 and/or C-2: ${S}_{1} \left({H}_{C}\right) \geq {S}_{1} \left({S}_{A}\right)$ Condition c-1 ${S}_{1} \left({S}_{A}\right) \geq {S}_{1} \left(HC\right)$ Condition c-2 wherein, in Conditions C-1 and C-2,
S₁(H_{C}) indicates the lowest excited singlet energy level of Host C,
S₁(S_{A}) indicates the lowest excited singlet energy level of Sensitizer A, and
S₁(HC) indicates the lowest excited singlet energy level of the heterocyclic compound represented by Formula 1.

S₁(H_{C}), S₁(S_{A}), and S₁(HC) may be evaluated using the DFT method of the Gaussian program, which is structure-optimized at the B3LYP/6-31G(d,p) level.

When Host C, Sensitizer A, and the heterocyclic compound represented by Formula 1 satisfy Condition C-1 and/or C-2, FRET from Sensitizer A to the heterocyclic compound represented by Formula 1 may be facilitated, and thus, the organic light-emitting device may have improved luminescence efficiency.

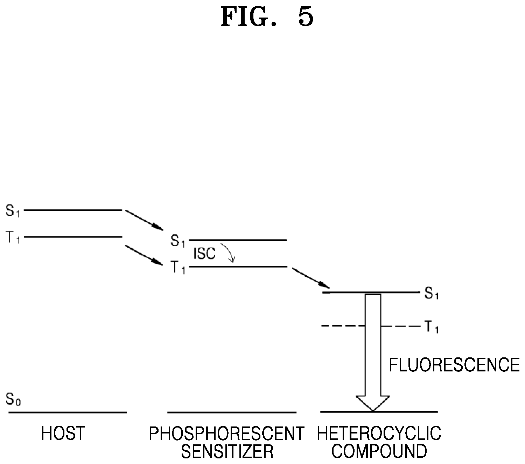

### Description of FIG. 5

In one or more embodiments, the heterocyclic compound represented by Formula 1 may be used as a fluorescent emitter, and the emission layer may include a sensitizer, for example, a phosphorescent sensitizer.

In one or more embodiments, the emission layer may further include a host (hereinafter, referred to as "Host D", and Host D may not be identical to the heterocyclic compound represented by Formula 1 or the sensitizer) and a sensitizer (hereinafter, referred to as "Sensitizer B", and Sensitizer B may not be identical to Host D or the heterocyclic compound represented by Formula 1). Host D and Sensitizer B may respectively be understood by referring to host materials and sensitizer materials to be described herein, but embodiments are not limited thereto.

In one or more embodiments, the proportion of emission components of the heterocyclic compound represented by Formula 1, among the total emission components emitted from the emission layer, may be about 80 % or more, for example, about 90 % or more (e.g., about 95 % or more). For example, the heterocyclic compound represented by Formula 1 may emit fluorescence. In addition, each of the host and the sensitizer may not emit light.

Energy transfer according to one or more embodiments will be described with reference to FIG. 5.

75 % of triplet excitons formed in Host D in the emission layer are transferred to Sensitizer B through Dexter energy transfer, and the energy of 25 % of singlet excitons formed in Host D is transferred to the singlet and triplet states of Sensitizer B. The energy transferred to the singlet state of Sensitizer B undergoes ISC to the triplet state, and then, the triplet energy of Sensitizer B is transferred to the heterocyclic compound represented by Formula 1 through FRET.

Accordingly, by transferring all of the singlet excitons and triplet excitons generated in the emission layer to a dopant (e.g., an emitter), an organic light-emitting device having improved efficiency may be obtained. In addition, since an organic light-emitting device with significantly reduced energy loss may be obtained, the lifespan characteristics of the organic light-emitting device may be improved.

In one or more embodiments, when the emission layer further includes Host D and Sensitizer B, in addition to the heterocyclic compound represented by Formula 1, Host D, Sensitizer B and the heterocyclic compound represented by Formula 1 may satisfy Condition D-1 and/or D-2: ${T}_{1} \left({H}_{D}\right) \geq {T}_{1} \left({S}_{B}\right)$ Condition d-1 ${T}_{1} \left({S}_{B}\right) \geq {S}_{1} \left(HC\right)$ Condition d-2 wherein, in Conditions D-1 and D-2,
T₁(H_{D}) indicates the lowest excited triplet energy level of Host D,
T₁(S_{B}) indicates the lowest excited triplet energy level of Sensitizer B, and
S₁(HC) indicates the lowest excited singlet energy level of the heterocyclic compound represented by Formula 1.

T₁(H_{D}), T₁(S_{B}), and S₁(HC) may be evaluated using the DFT method of the Gaussian program, which is structure-optimized at the B3LYP/6-31G(d,p) level.

When Host D, Sensitizer B, and the heterocyclic compound represented by Formula 1 satisfy Condition D-1 and/or D-2, FRET from Sensitizer B to the heterocyclic compound represented by Formula 1 may be facilitated, and thus, the organic light-emitting device may have improved luminescence efficiency.

In one or more embodiments, the amount of the sensitizer in the emission layer may be about 5 wt% to about 50 wt%, for example, about 10 wt% to about 30 wt%. When the range described above is satisfied, effective energy transfer in the emission layer may be achieved, and thus, the organic light-emitting device may have high efficiency and long lifespan.

In one or more embodiments, the amount of the heterocyclic compound represented by Formula 1 in the emission layer may be about 0.01 wt% to about 15 wt%, for example, about 0.05 wt% to about 3 wt%, but embodiments are not limited thereto.

In one or more embodiments, the heterocyclic compound represented by Formula 1 may further satisfy Condition 5: $0 μs < {T}_{decay} \left(HC\right) < 5 μs$ Condition 5 wherein, in Condition 5,
T_{decay}(HC) indicates the decay time of the heterocyclic compound represented by Formula 1.

The decay time of the heterocyclic compound represented by Formula 1 is calculated from a time-resolved photoluminescence (TRPL) spectrum at room temperature with respect to a film (hereinafter, referred to as "Film (HC)") having a thickness of 40 nm obtained by vacuum-codepositing, on a quartz substrate, a host and the heterocyclic compound represented by Formula 1 included in the emission layer at a weight ratio of 90:10 at a vacuum degree of 10⁻⁷ torr.

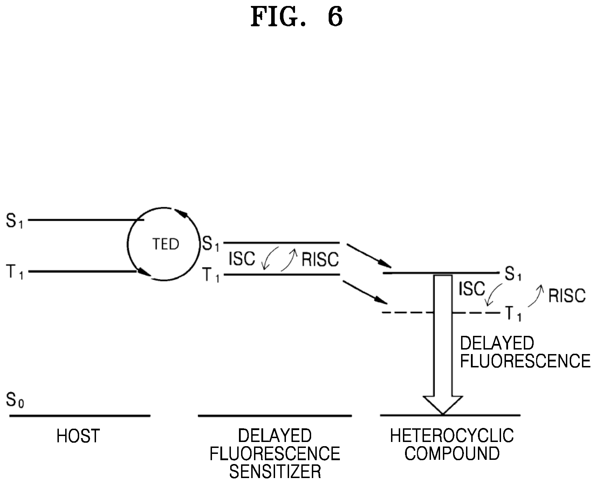

### Description of FIG. 6

In one or more embodiments, the heterocyclic compound represented by Formula 1 may be used as a delayed fluorescence emitter, and the emission layer may include a sensitizer, for example, a delayed fluorescence sensitizer.

In one or more embodiments, the emission layer may further include a host (hereinafter, referred to as "Host E", and Host E may not be identical to the heterocyclic compound represented by Formula 1 or the sensitizer) and a sensitizer (hereinafter, referred to as "Sensitizer C", and Sensitizer C may not be identical to Host E or the heterocyclic compound represented by Formula 1). Host E and Sensitizer C may respectively be understood by referring to host materials and sensitizer materials to be described herein, but embodiments are not limited thereto.

In one or more embodiments, the proportion of emission components of the heterocyclic compound represented by Formula 1, among the total emission components emitted from the emission layer, may be about 80 % or more, for example, about 90 % or more (e.g., about 95 % or more). In one or more embodiments, the heterocyclic compound represented by Formula 1 may emit fluorescence and/or delayed fluorescence. In addition, each of Host E and Sensitizer C may not emit light.

In this regard, the heterocyclic compound represented by Formula 1 may emit fluorescence and/or delayed fluorescence, and the emission components of the heterocyclic compound represented by Formula 1 are the sum of prompt emission components of the heterocyclic compound represented by Formula 1 and delayed fluorescence components resulting from RISC of the heterocyclic compound represented by Formula 1.

Energy transfer according to one or more embodiments will be described with reference to FIG. 6.

25 % of singlet excitons formed in Host E in the emission layer are transferred to the singlet state of Sensitizer C through FRET, and the energy of 75 % of triplet excitons formed in Host E are transferred to the triplet state of Sensitizer C. Then, the singlet energy of Sensitizer C is transferred to the heterocyclic compound represented by Formula 1 through FRET, and the triplet energy of Sensitizer C is transferred to the heterocyclic compound represented by Formula 1 through Dexter energy transfer. The energy transferred to the triplet state of Sensitizer C may undergo RISC to the singlet state. In addition, in the case of Sensitizer C, the triplet energy formed in Sensitizer C may be reversely transferred to Host E (triplet exciton distributing (TED)) and then transferred to the heterocyclic compound represented by Formula 1 to emit light through RISC.

Accordingly, by transferring all the singlet excitons and triplet excitons generated in the emission layer to a dopant (e.g., an emitter), an organic light-emitting device having improved efficiency may be obtained. In addition, since an organic light-emitting device with significantly reduced energy loss may be obtained, the lifespan characteristics of the organic light-emitting device may be improved.

In one or more embodiments, when the emission layer further includes Host E and Sensitizer C, in addition to the heterocyclic compound represented by Formula 1, Host E, Sensitizer C and the heterocyclic compound represented by Formula 1 may satisfy Conditions E-1, E-2, and/or E-3: ${S}_{1} \left({H}_{E}\right) \geq {S}_{1} \left({S}_{C}\right)$ Condition e-1 ${S}_{1} \left({S}_{C}\right) \geq {S}_{1} \left(HC\right)$ Condition e-2 ${T}_{1} \left({S}_{C}\right) \geq {T}_{1} \left(HC\right)$ Condition e-3 wherein, in Conditions E-1, E-2, and E-3,
S₁(H_{E}) indicates the lowest excited singlet energy level of Host E,
S₁(S_{C}) indicates the lowest excited singlet energy level of Sensitizer C,
S₁(HC) indicates the lowest excited singlet energy level of the heterocyclic compound represented by Formula 1,
T₁(S_{C}) indicates the lowest excited triplet energy level of Sensitizer C, and
T₁(HC) indicates the lowest excited triplet energy level of the heterocyclic compound represented by Formula 1.

S₁(H_{E}), S₁(S_{C}), S₁(HC), T₁(S_{C}), and T₁(HC) may be evaluated using the DFT method of the Gaussian program, which is structure-optimized at the B3LYP/6-31G(d,p) level.

When Host E, Sensitizer C, and the heterocyclic compound represented by Formula 1 satisfy Condition E-1, E-2, and/or E-3, Dexter transfer and FRET from Sensitizer C to the heterocyclic compound represented by Formula 1 may be facilitated, and thus, the organic light-emitting device may have improved luminescence efficiency.

In one or more embodiments, the amount of Sensitizer C in the emission layer may be about 5 wt% to about 50 wt%, for example, about 10 wt% to about 30 wt%, based on total weight of the emission layer. When the range described above is satisfied, effective energy transfer in the emission layer may be achieved, and thus, the organic light-emitting device may have high efficiency and long lifespan.

In one or more embodiments, the amount of the heterocyclic compound represented by Formula 1 in the emission layer may be about 0.01 wt% to about 15 wt%, for example, about 0.05 wt% to about 3 wt%, but embodiments are not limited thereto.

### Host in emission layer

In one or more embodiments, the host may not include metal atoms.

In one or more embodiments, the host may include at least one compound that is a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, or a sulfonyl-containing compound.

In one or more embodiments, the host may be a compound including at least one carbazole ring and at least one cyano group, or a phosphine oxide-containing compound.

In one or more embodiments, the host may consist of one host. When the host consists of one host, the one host may be a bipolar host, an electron-transporting host, or a hole-transporting host, which will be described herein.

In one or more embodiments, the host may be a mixture of two or more different hosts. For example, the host may be a mixture of an electron-transporting host and a hole-transporting host, a mixture of two different electron-transporting hosts, or a mixture of two different hole-transporting hosts. The electron-transporting host and the hole-transporting host may each be as described herein.

In one or more embodiments, the host may include an electron-transporting host including at least one electron-transporting moiety, and a hole-transporting host that does not include an electron-transporting moiety.

The electron-transporting moiety used herein may be a cyano group, a π electron-deficient nitrogen-containing cyclic group, or a group represented by one of the following formulae: 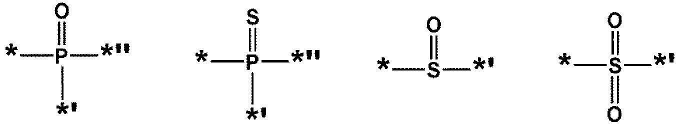 wherein, in the formulae above, *, *', and *" each indicate a binding site to a neighboring atom.

In one or more embodiments, the electron-transporting host in the emission layer may include at least one of a cyano group or a π electron-deficient nitrogen-containing cyclic group.

In one or more embodiments, the electron-transporting host in the emission layer may include at least one cyano group.

In one or more embodiments, the electron-transporting host in the emission layer may include at least one cyano group and at least one π electron-deficient nitrogen-containing cyclic group.

In one or more embodiments, the host may include an electron-transporting host and a hole-transporting host, wherein the electron-transporting host may include at least one π electron-deficient nitrogen-free cyclic group and at least one electron-transporting moiety, and the hole-transporting host may include at least one π electron-deficient nitrogen-free cyclic group and may not include an electron-transporting moiety.

The term "π electron-deficient nitrogen-containing cyclic group" as used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an benzoisothiazole group, a benzoxazole group, an benzoisoxazole group, a triazole group, a tetrazole group, an oxadiazole group, a triazine group, a thiadiazole group, an imidazopyridine group, an imidazopyrimidine group, an azacarbazole group; or a condensed cyclic group of two or more π electron-deficient nitrogen-containing cyclic groups.

In one or more embodiments, the π electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more π electron-deficient nitrogen-free cyclic groups, but embodiments are not limited thereto.

In one or more embodiments, when the host is a mixture of an electron-transporting host and a hole-transporting host, the weight ratio of the electron-transporting host to the hole-transporting host may be about 1:9 to about 9:1, for example, about 2:8 to about 8:2, for example, about 4:6 to about 6:4, for example, about 5:5. When the weight ratio of the electron-transporting host to the hole-transporting host satisfies the range described above, a balance in hole transport and electron transport in the emission layer may be achieved.

The host may include at least one of 1 ,3,5-tri(1-phenyl-1H-benzo[d]imidazol-2-yl)benzene (TPBi), 3-tert-butyl-9,10-di(naphth-2-yl)anthracene (TBADN), 9,10-di(naphth-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl)benzene (TCP), 1,3-bis(N-carbazolyl)benzene (mCP), Compound H50, or Compound H51, but embodiments are not limited thereto:

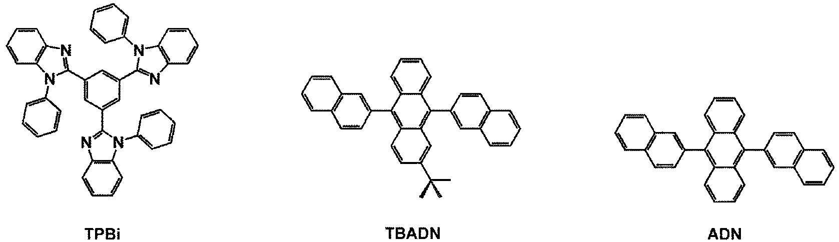

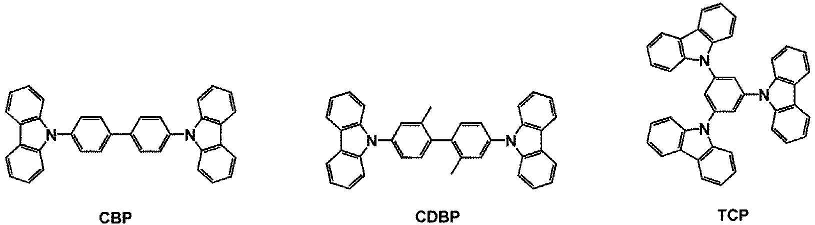

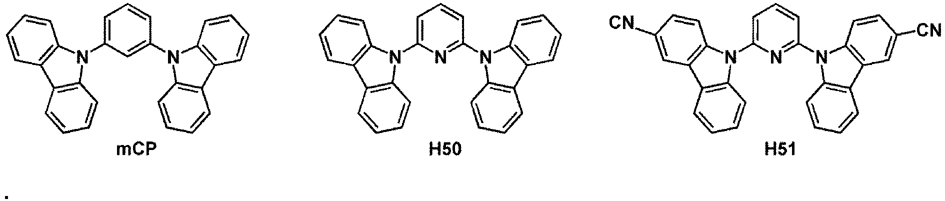

In one or more embodiments, the host may further include a compound represented by Formula 301: 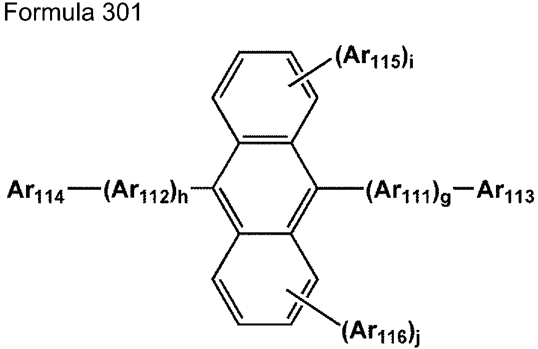 wherein, in Formula 301, Ar₁₁₁ and Ar₁₁₂ may each independently be:
a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, an anthracenyl group, or a combination thereof.

In Formula 301, Ar₁₁₃ to Ar₁₁₆ may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

In Formula 301, g, h, i, and j may each independently be an integer from 0 to 4, and g, h, i, and j may each independently be, for example, 0, 1, or 2.

In Formula 301, Ar₁₁₃ to Ar₁₁₆ may each independently be:
a C₁-C₁₀ alkyl group substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or 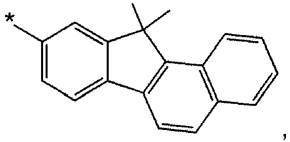
but embodiments are not limited thereto.

In one or more embodiments, the host may include a compound represented by Formula 302: 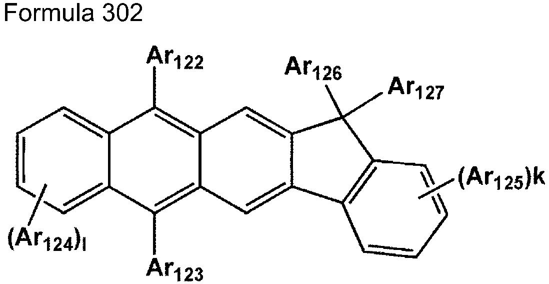 wherein, in Formula 302, Ar₁₂₂ to Ar₁₂₅ may each be as described in connection with Ar₁₁₃ in Formula 301.

In Formula 302, Ar₁₂₆ and Ar₁₂₇ may each independently be a C₁-C₁₀ alkyl group (e.g., a methyl group, an ethyl group, a propyl group, or the like).

In Formula 302, k and I may each independently be an integer from 0 to 4. For example, k and I may each independently be 0, 1, or 2.

In one or more embodiments, the host may include at least one compound among Compounds H1 to H26, but embodiments are not limited thereto:

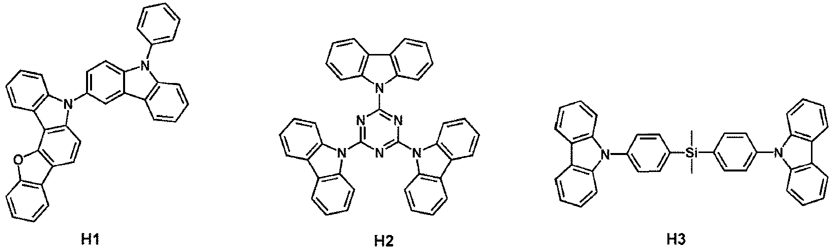

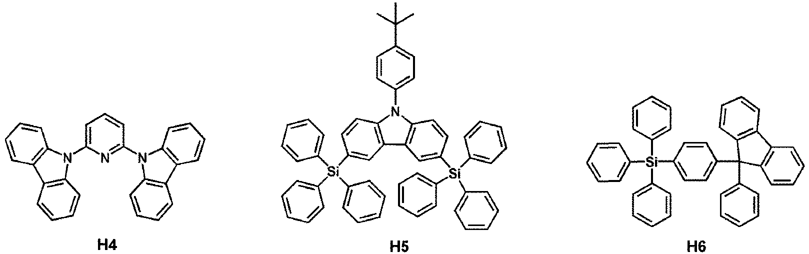

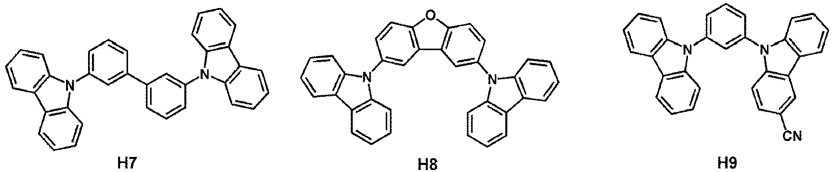

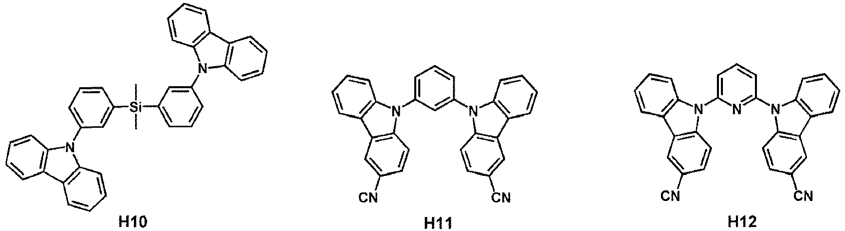

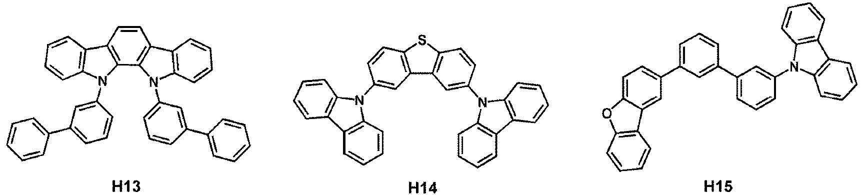

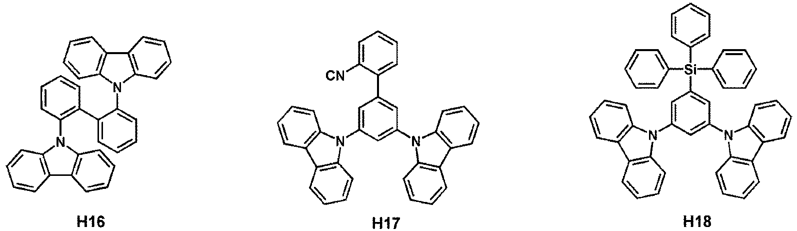

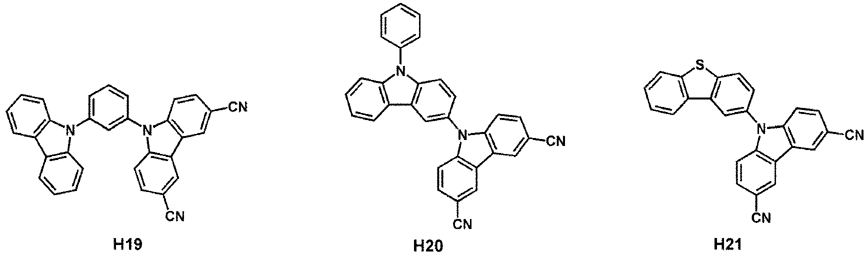

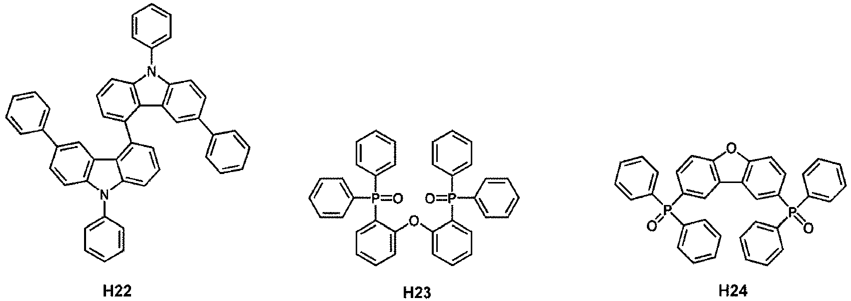

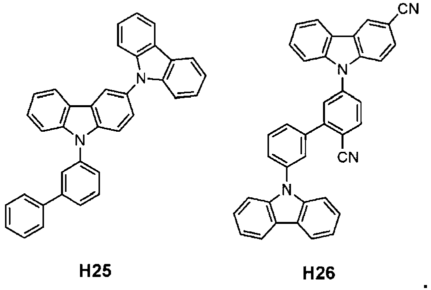

In one or more embodiments, the host may be one of the following compounds:

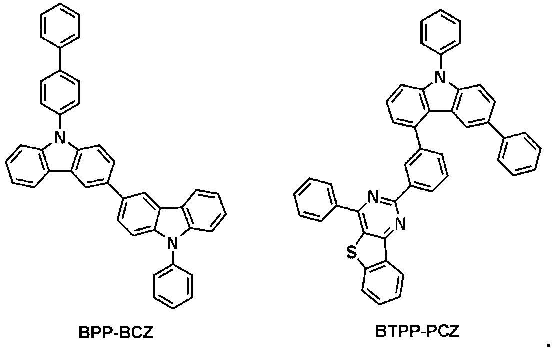

In one or more embodiments, the host may consist of one compound. For example, the one compound may be selected from a first material (hole-transporting host) or a second material (electron-transporting host) as described herein.

In one or more embodiments, the host may include two or more compounds. For example, the host may include two or more different hole-transporting hosts, two or more different electron-transporting hosts, or a combination of at least one hole-transporting host and at least one electron-transporting host.

### Emitter in emission layer

The emitter includes the heterocyclic compound represented by Formula 1.

### Sensitizer in emission layer

In one or more embodiments, the sensitizer may include a phosphorescent compound.

In one or more embodiments, the phosphorescent compound may include an organometallic compound including at least one metal.

In one or more embodiments, the organometallic compound may include at least one metal (M₁₁) selected from transition metals, and an organic ligand (L₁₁), wherein L₁₁ and M₁₁ may form one cyclometallated ring, two cyclometallated rings, three cyclometallated rings, or four cyclometallated rings.

In one or more embodiments, the organometallic compound may be represented by Formula 101:

Formula 101 M11(L11)n11(L12)n12

wherein, in Formula 101,
M₁₁ may be a transition metal,
L₁₁ may be a ligand represented by one of Formulae 1-1 to 1-4,
L₁₂ may be a monodentate ligand or a bidentate ligand,
n11 may be 1, and
n12 may be 0, 1, or 2, 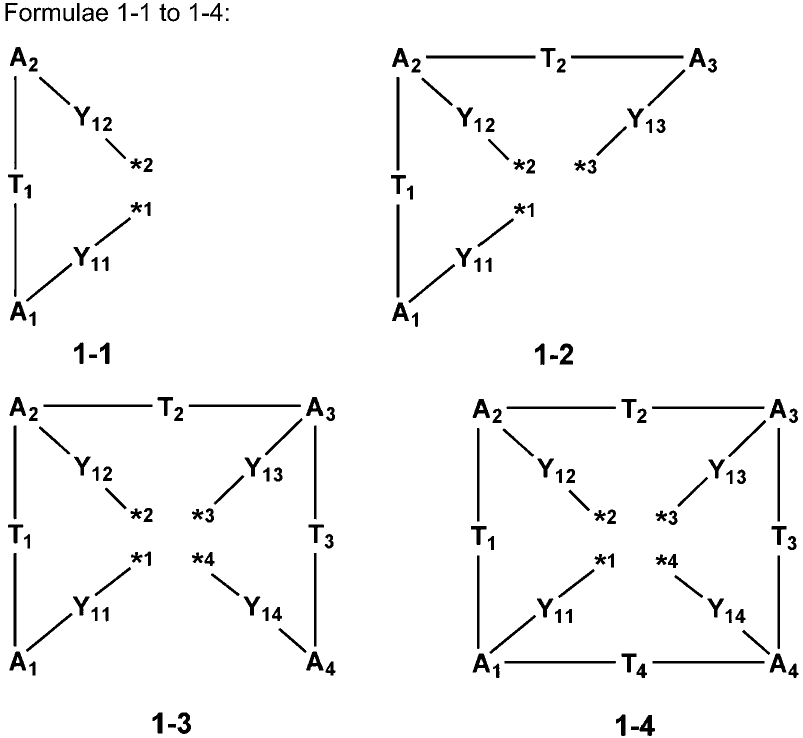
wherein, in Formulae 1-1 to 1-4,
A₁ to A₄ may each independently be a substituted or unsubstituted C₅-C₃₀ carbocyclic group, a substituted or unsubstituted C₁-C₃₀ heterocyclic group, or a non-cyclic group,
Y₁₁ to Y₁₄ may each independently be a chemical bond, O, S, N(R₉₁), B(R₉₁), P(R₉₁), or C(R₉₁)(R₉₂),
T₁ to T₄ may each independently be a single bond, a double bond, *-N(R₉₃)-*', *-B(R₉₃)-*', *-P(R₉₃)-*', *-C(R₉₃)(R₉₄)-*', *-Si(R₉₃)(R₉₄)-*', *-Ge(R₉₃)(R₉₄)-*', *-S-*', *-Se-*', *-O-*', *-C(=O)-*', *-S(=O)-*', *-S(=O)₂-*', *-C(R₉₃)=*', *=C(R₉₃)-*', *-C(R₉₃)=C(R₉₄)-*', *-C(=S)-*', or *-C≡C-*',
a substituent of the substituted C₅-C₃₀ carbocyclic group, a substituent of the substituted C₁-C₃₀ heterocyclic group, and R₉₁ to R₉₄ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - C(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), or -P(=S)(Q₁)(Q₂), wherein the substituent of the substituted C₅-C₃₀ carbocyclic group and the substituent of the substituted C₁-C₃₀ heterocyclic group may not be hydrogen,
*₁, *₂, *₃, and *₄ each indicate a binding site to M₁₁, and
Q₁ to Q₃ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group; or
   a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, - F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

In one or more embodiments, the transition metal may be platinum (Pt), palladium (Pd), gold (Au), iridium (Ir), osmium (Os), titanium (Ti), zirconium (Zr), hafnium (Hf), europium (Eu), terbium (Tb), thulium (Tm), or rhodium (Rh).

In one or more embodiments, the sensitizer may include at least one of Compounds P1 to P52:

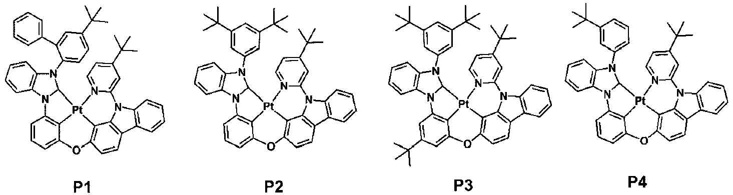

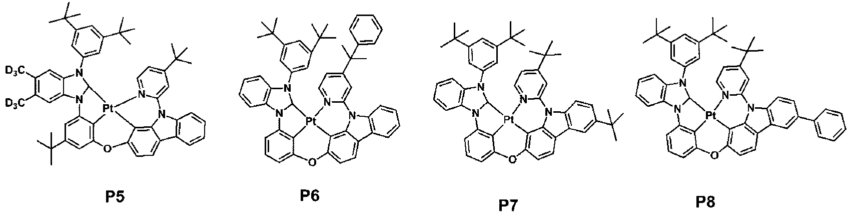

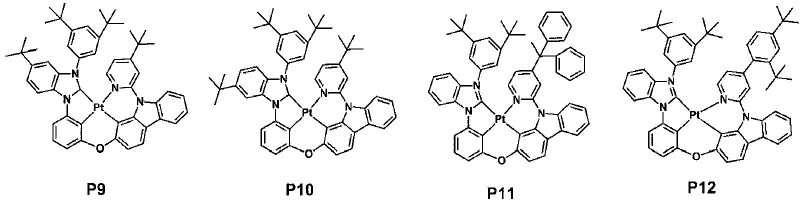

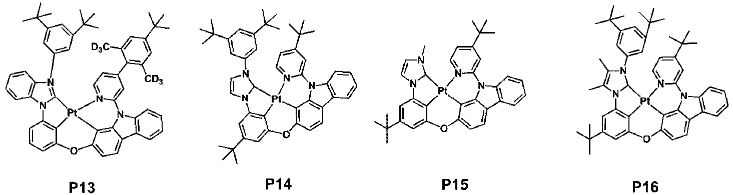

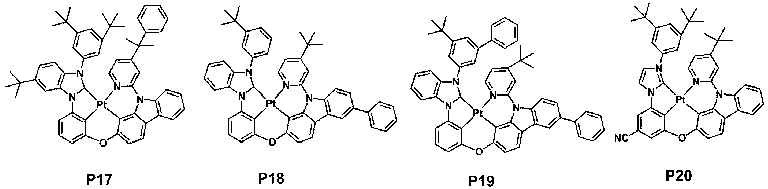

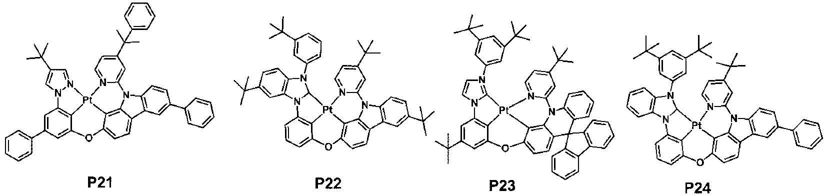

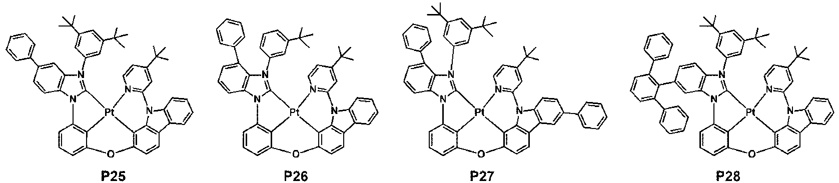

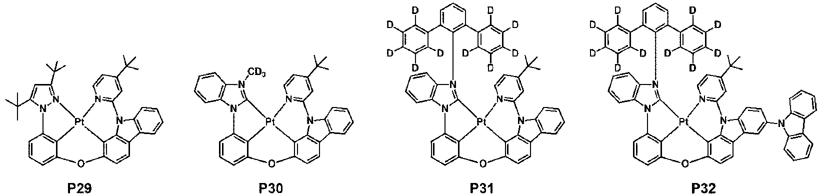

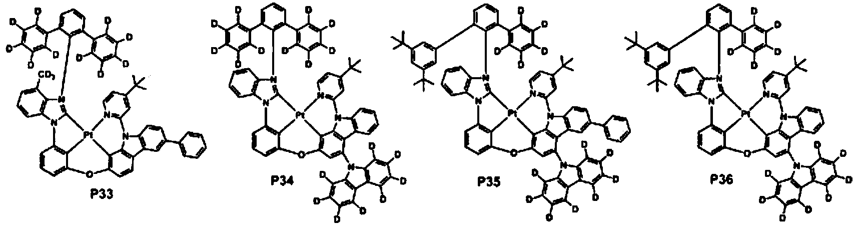

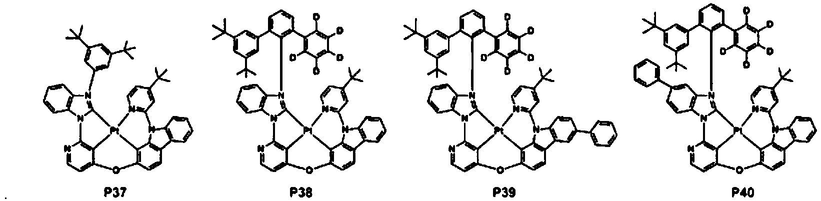

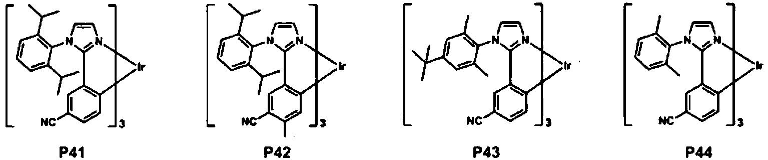

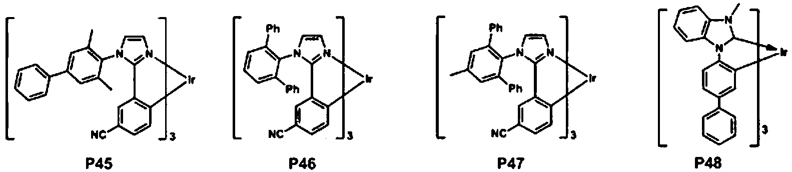

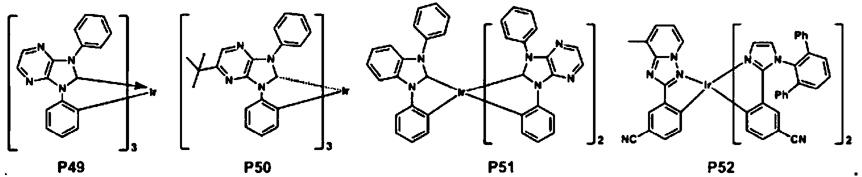

In one or more embodiments, the sensitizer may include the following compound:

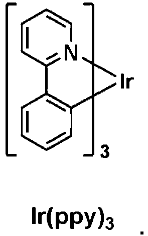

In one or more embodiments, the sensitizer may include a delayed fluorescence compound.

In one or more embodiments, the delayed fluorescence compound may be represented by Formula 101 or 102. 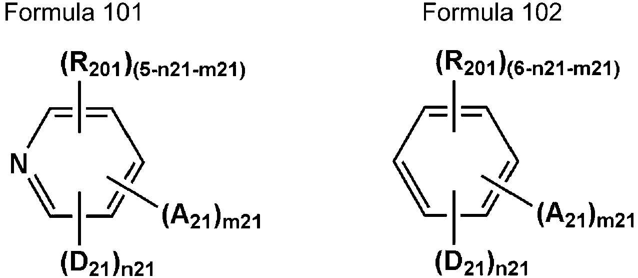 wherein, in Formulae 101 and 102,
A₂₁ may be an acceptor group,
D₂₁ may be a donor group,
m21 may be 1, 2, or 3, and n21 may be 1, 2, or 3,
a sum of n21 and m21 in Formula 101 may be 5 or less, and a sum of n21 and m21 in Formula 102 may be 6 or less,
R₂₀₁ may be hydrogen, deuterium, -F, -Cl, -Br, -I, -SF₅, a hydroxyl group, a cyano group, a nitro group, an amino group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -C(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), or -P(=S)(Q₁)(Q₂), wherein a plurality of R₂₀₁ may optionally be bonded to each other to form a substituted or unsubstituted C₅-C₃₀ carbocyclic group or a substituted or unsubstituted C₁-C₃₀ heterocyclic group, and
Q₁ to Q₃ may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group; or
   a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, - F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

In one or more embodiments, in Formulae 101 and 102, D₂₁ may be a substituted or unsubstituted π electron-deficient nitrogen-free cyclic group.

The π electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group; or a condensed cyclic group of two or more π electron-deficient nitrogen-free cyclic groups, but embodiments are not limited thereto.

In one or more embodiments, in Formulae 101 and 102, A₂₁ may be -F, a cyano group, or a π electron-deficient nitrogen-containing cyclic group;
a C₁-C₆₀ alkyl group, a π electron-deficient nitrogen-containing cyclic group, or a π electron-deficient nitrogen-free cyclic group, each substituted with -F, a cyano group, or a combination thereof; or
a π electron-deficient nitrogen-containing cyclic group substituted with deuterium, a C₁-C₆₀ alkyl group, a π electron-deficient nitrogen-containing cyclic group, a π electron-deficient nitrogen-free cyclic group, or a combination thereof.

A detailed description of the π electron-deficient nitrogen-free cyclic group is as provided herein.

The term "π electron-deficient nitrogen-containing cyclic group" as used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an benzoisothiazole group, a benzoxazole group, an benzoisoxazole group, a triazole group, a tetrazole group, an oxadiazole group, a triazine group, a thiadiazole group, an imidazopyridine group, an imidazopyrimidine group, an azacarbazole group, a benzimidazolobenzimidazole group; or a condensed cyclic group of two or more π electron-deficient nitrogen-containing cyclic groups.

In one or more embodiments, the amount of the sensitizer in the organic layer may be greater than the amount of the emitter. For example, the volume ratio of the sensitizer to the emitter may be about 30:0.1 to about 10:3, or about 10:0.1 to about 20:5. For example, the weight ratio of the sensitizer to the emitter may be about 10:0.1 to about 20:5. In one or more embodiments, the volume ratio of the host to the sensitizer in the organic layer may be about 60:40 to about 95:5, or about 70:30 to about 90:10. In one or more embodiments, the weight ratio of the host to the sensitizer may be about 60:40 to about 95:5. By satisfying the amount ranges described above, the organic light-emitting device may have improved luminescence efficiency and/or lifespan characteristics.

FIG. 1 is a schematic cross-sectional view of an organic light-emitting device 10 according to one or more embodiments. Hereinafter, the structure of an organic light-emitting device according to one or more embodiments and a method of manufacturing an organic light-emitting device according to one or more embodiments will be described with reference to FIG. 1. The organic light-emitting device 10 has a structure in which a first electrode 11, an organic layer 15, and a second electrode 19 are sequentially stacked.

A substrate may be additionally arranged under the first electrode 11 or above the second electrode 19. For use as the substrate, any suitable substrate that is used in organic light-emitting devices available in the art may be used, and the substrate may be a glass substrate or a transparent plastic substrate, each having excellent mechanical strength, thermal stability, transparency, surface smoothness, ease of handling, and/or water resistance.

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a transflective electrode, or a transmissive electrode. The material for forming the first electrode 11 may be indium tin oxide (ITO), indium zinc oxide (IZO), tin oxide (SnO₂), zinc oxide (ZnO), or a combination thereof. In one or more embodiments, the material for forming the first electrode 11 may be a metal, such as magnesium (Mg), aluminum (Al), aluminum-lithium (Al-Li), calcium (Ca), magnesium-indium (Mg-In), magnesium-silver (Mg-Ag), or a combination thereof.

The first electrode 11 may have a single-layer structure or a multi-layer structure including two or more layers. For example, the first electrode 11 may have a three-layer structure of ITO/Ag/ITO, but embodiments are not limited thereto.

The organic layer 15 is arranged on the first electrode 11.

The organic layer 15 may include a hole transport region, an emission layer, and an electron transport region.

The hole transport region may be arranged between the first electrode 11 and the emission layer.

The hole transport region may include a hole injection layer, a hole transport layer, an electron-blocking layer, a buffer layer, or a combination thereof.

The hole transport region may include only either a hole injection layer or a hole transport layer. In one or more embodiments, the hole transport region may have a hole injection layer/hole transport layer structure, a hole injection layer/hole transport layer/electron-blocking layer structure or a hole injection layer/first hole transport layer/second hole transport layer/electron-blocking layer structure, wherein respective layers of each structure are sequentially stacked in the stated order from the first electrode 11.

When the hole transport region includes a hole injection layer, the hole injection layer may be formed on the first electrode 11 by using one or more suitable methods, for example, vacuum deposition, spin coating, casting, Langmuir-Blodgett (LB) deposition, or the like, but embodiments are not limited thereto.

When the hole injection layer is formed by vacuum deposition, the deposition conditions may vary depending on a compound that is used as a material for forming the hole injection layer, and the structure and thermal characteristics of the hole injection layer, and may include a deposition temperature of about 100°C to about 500°C, a vacuum degree in a range of about 10⁻⁸ torr to about 10⁻³ torr, and a deposition rate of about 0.01 angstroms per second (Å/sec) to about 100 Å/sec, but embodiments are not limited thereto.

When the hole injection layer is formed by spin coating, the coating conditions may vary depending on a compound that is used as a material for forming the hole injection layer, and the structure and thermal characteristics of the hole injection layer, and may include a coating speed of about 2,000 revolutions per minute (rpm) to about 5,000 rpm and a heat treatment temperature for removing a solvent after coating of about 80°C to about 200°C, but embodiments are not limited thereto.

Conditions for forming the hole transport layer and the electron-blocking layer may be understood by referring to the conditions for forming the hole injection layer.

The hole transport region may include, for example, at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto: 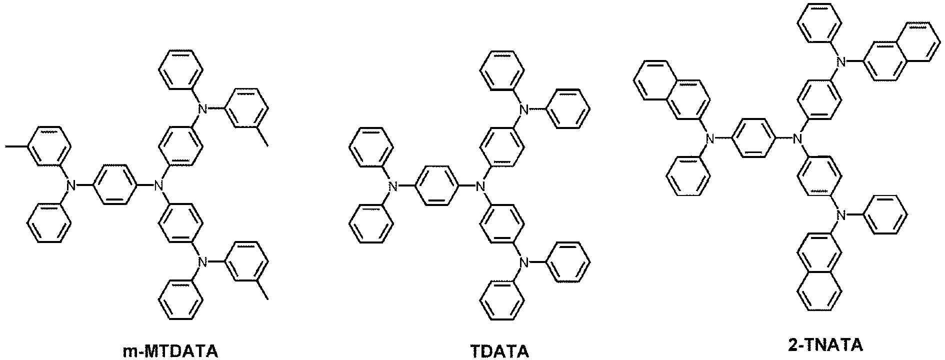 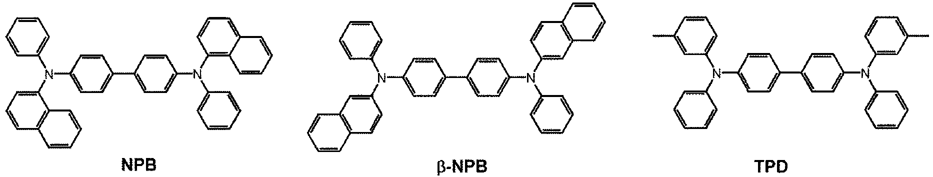 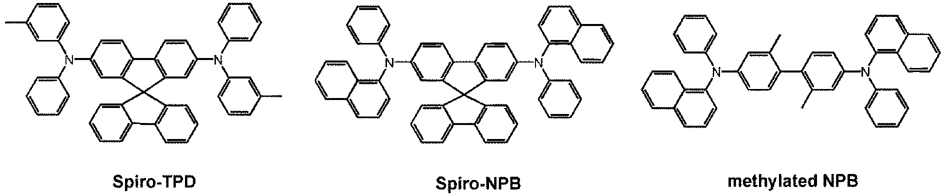 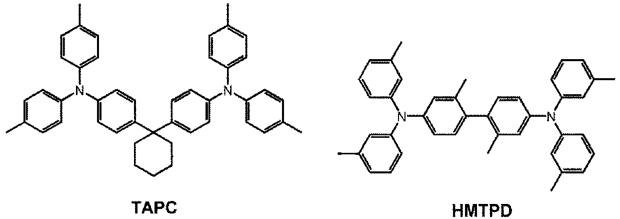 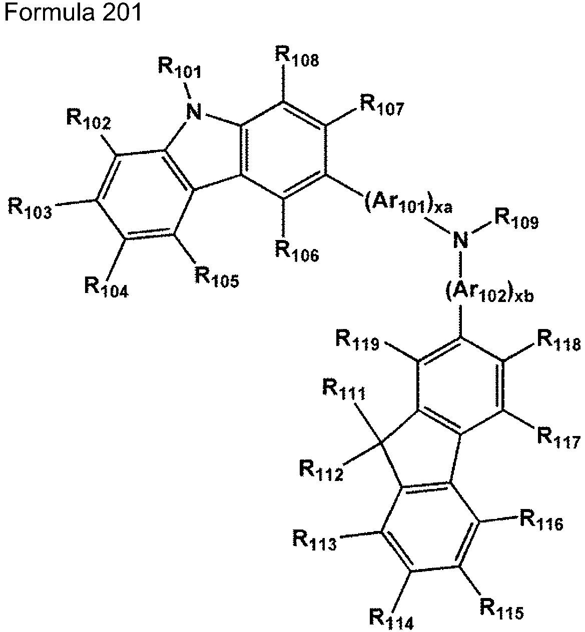 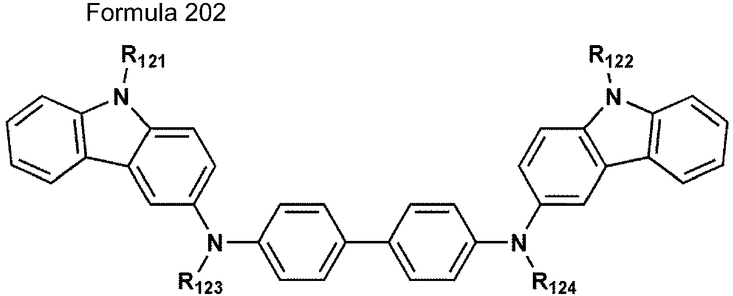 wherein, in Formula 201, Ar₁₀₁ and Ar₁₀₂ may each independently be:
a phenylene group, a pentalenylene group, an indenylene group, a naphthylene group, an azulenylene group, a heptalenylene group, an acenaphthenylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

In Formula 201, xa and xb may each independently be an integer from 0 to 5, or xa and xb may each independently be 0, 1, or 2. For example, xa may be 1, and xb may be 0, but embodiments are not limited thereto.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, a pentyl group, a hexyl group, or the like), a C₁-C₁₀ alkoxy group (e.g., a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof, but embodiments are not limited thereto. In Formula 201, R₁₀₉ may be:
   a phenyl group, a naphthyl group, an anthracenyl group, or a pyridinyl group; or
   a phenyl group, a naphthyl group, an anthracenyl group, or a pyridinyl group, each substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A, but embodiments are not limited thereto: 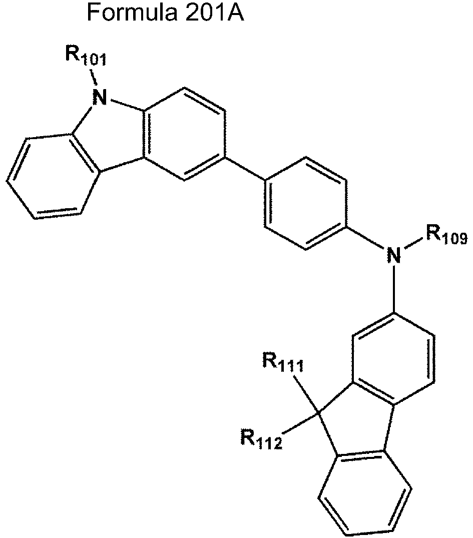 wherein, in Formula 201A, R₁₀₁, R₁₁₁, R₁₁₂, and R₁₀₉ may each be as described herein.

In one or more embodiments, the compound represented by Formula 201 and the compound represented by Formula 202 may include Compounds HT1 to HT20, but embodiments are not limited thereto:

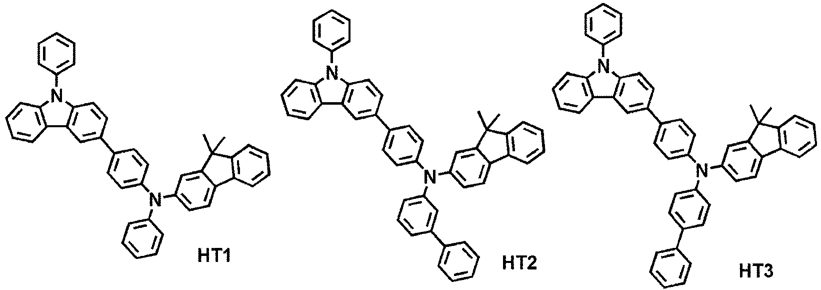

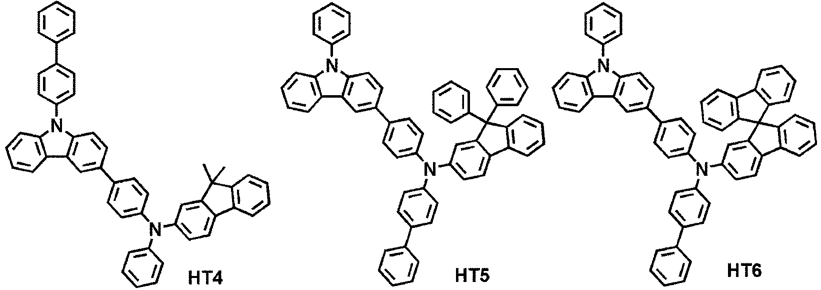

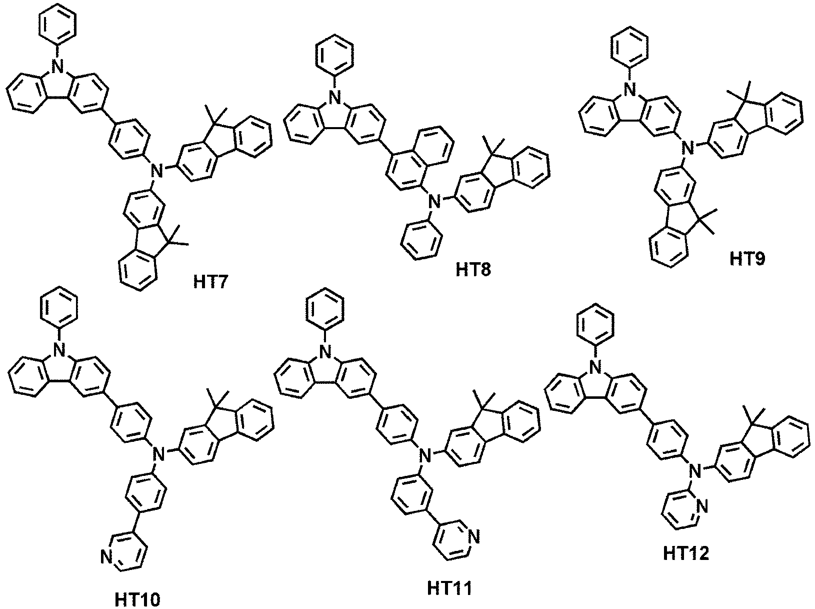

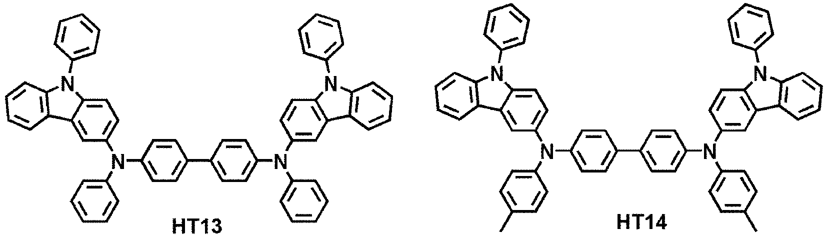

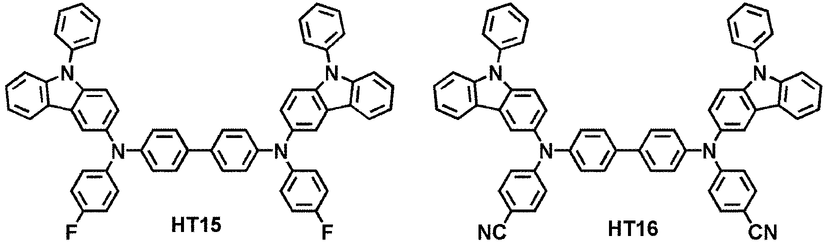

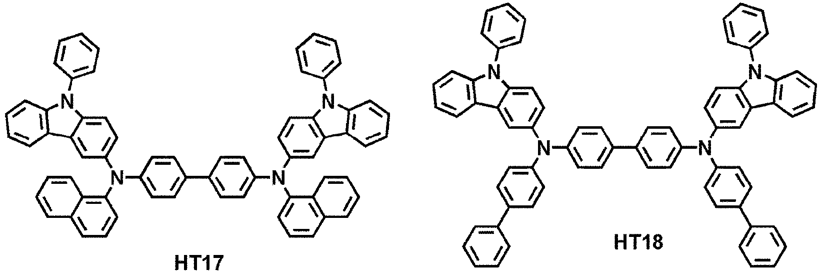

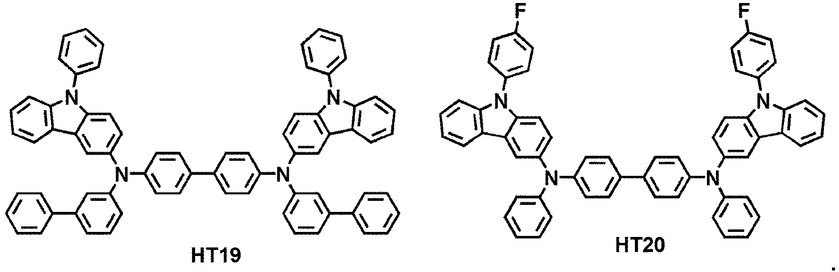

The thickness of the hole transport region may be about 50 Å to about 10,000 Å, for example, about 100 Å to about 1,000 Å. When the hole transport region includes at least one of a hole injection layer and a hole transport layer, the thickness of the hole injection layer may be about 100 Å to about 10,000 Å, for example, about 100 Å to about 1,000 Å, and the thickness of the hole transport layer may be about 50 Å to about 2,000 Å, for example, about 100 Å to about 1,500 Å. When the thicknesses of the hole transport region, the hole injection layer, and the hole transport layer are within the ranges described above, satisfactory hole-transporting characteristics may be obtained without a substantial increase in driving voltage.

The hole transport region may further include, in addition to the above-described materials, a charge-generation material for improving conductivity. The charge-generation material may be homogeneously or non-homogeneously dispersed in the hole transport region.

The charge-generation material may be, for example, a p-dopant. The p-dopant may be one of a quinone derivative, a metal oxide, or a cyano group-containing compound, but embodiments are not limited thereto. Non-limiting examples of the p-dopant include a quinone derivative, such as tetracyanoquinonedimethane (TCNQ) or 2,3,5,6-tetrafluoro-tetracyano-1,4-benzoquinonedimethane (F4-TCNQ); a metal oxide, such as tungsten oxide or molybdenum oxide; or a cyano group-containing compound, such as Compound HT-D1 or F12, but embodiments are not limited thereto:

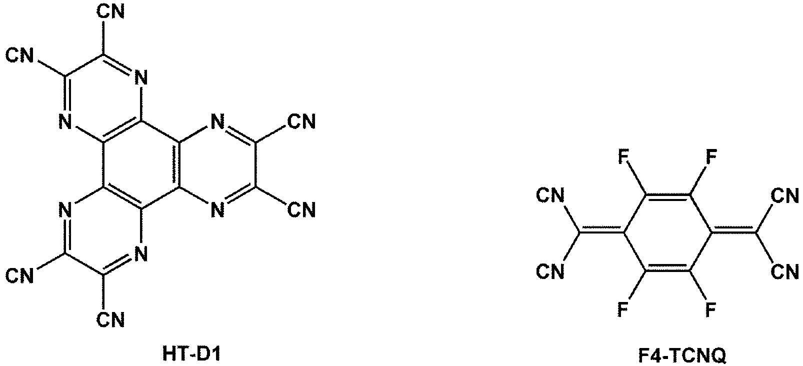

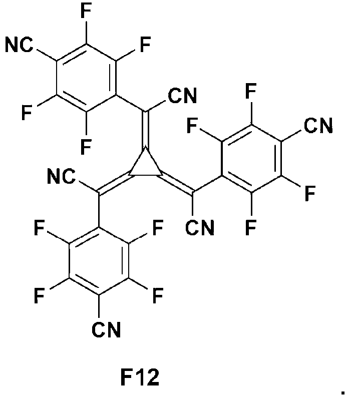

The hole transport region may further include a buffer layer.

The buffer layer may compensate for an optical resonance distance according to a wavelength of light emitted from the emission layer to increase efficiency.

The emission layer may be formed on the hole transport region by vacuum deposition, spin coating, casting, **LB** deposition, or the like. When the emission layer is formed by vacuum deposition or spin coating, the deposition or coating conditions may be similar to those applied in forming the hole injection layer although the deposition or coating conditions may vary depending on a material to be used.

In one or more embodiments, when the hole transport region includes an electron-blocking layer, a material for forming the electron-blocking layer may be selected from the above-described materials for forming the hole transport region and host materials to be described herein, but embodiments are not limited thereto. For example, when the hole transport region includes an electron-blocking layer, a material for forming the electron-blocking layer may be mCP, which will be described below.

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light, and various modifications may be made.

When the emission layer includes a host and a dopant, the amount of the dopant in the emission layer may be about 0.01 parts by weight to about 15 parts by weight, based on 100 parts by weight of the host in the emission layer, but embodiments are not limited thereto.

The thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

Next, an electron transport region may be arranged on the emission layer.

The electron transport region may include a hole-blocking layer, an electron transport layer, an electron injection layer, or a combination thereof.

In one or more embodiments, the electron transport region may have a hole-blocking layer/electron transport layer/electron injection layer structure or an electron transport layer/electron injection layer structure, but embodiments are not limited thereto. The electron transport layer may have a single-layer structure or a multi-layer structure including two or more different materials.

Conditions for forming the hole-blocking layer, the electron transport layer, and the electron injection layer, which constitute the electron transport region, may be understood by referring to the conditions for forming the hole injection layer.

When the electron transport region includes a hole-blocking layer, the hole-blocking layer may include, for example, at least one of DBFPO, 2,9-dimethyl-4,7-diphenyl-1,10-phenanthroline (BCP), 4,7-diphenyl-1,10-phenanthroline (Bphen), or bis(2-methyl-8-quinolinolato-N1,O8)-(1,1'-biphenyl-4-olato)aluminum (BAlq), but embodiments are not limited thereto:

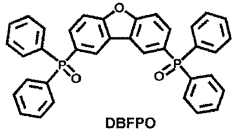

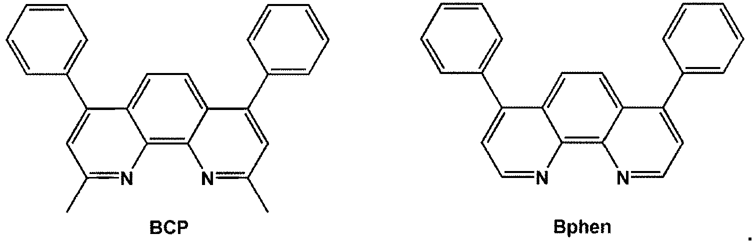

The thickness of the hole-blocking layer may be about 20 Å to about 1,000 Å, for example, about 30 Å to about 300 Å. When the thickness of the hole-blocking layer is within the range described above, excellent hole-blocking characteristics may be obtained without a substantial increase in driving voltage.

The electron transport layer may further include at least one of DBFPO, 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

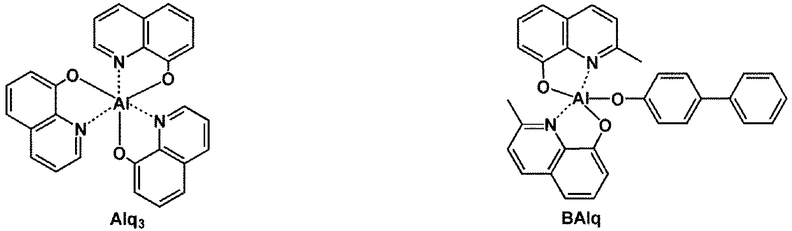

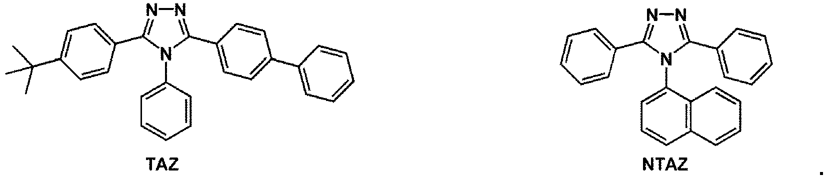

In one or more embodiments, the electron transport layer may include at least one of Compounds ET1 to ET25, but embodiments are not limited thereto:

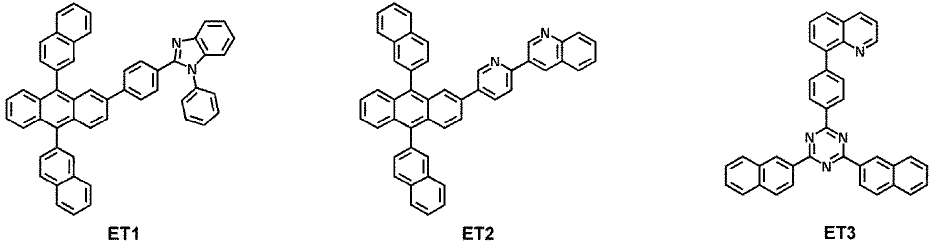

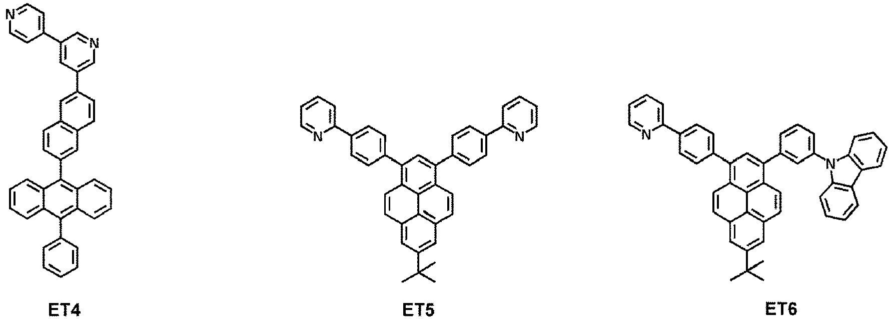

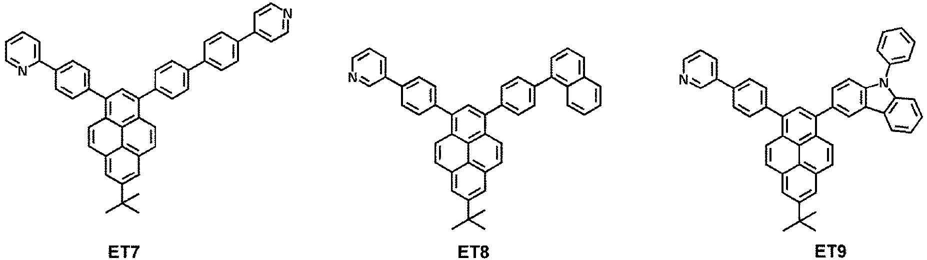

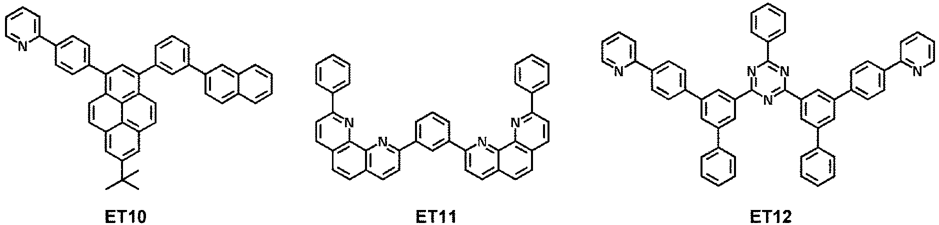

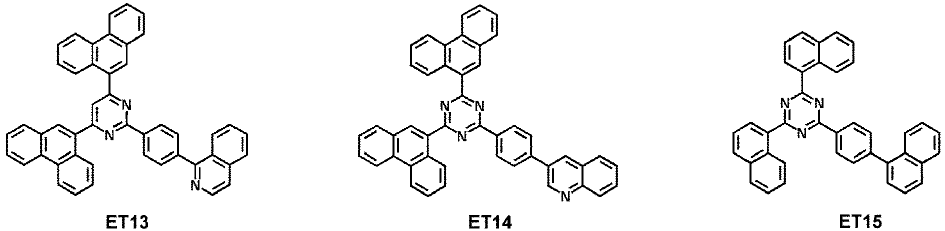

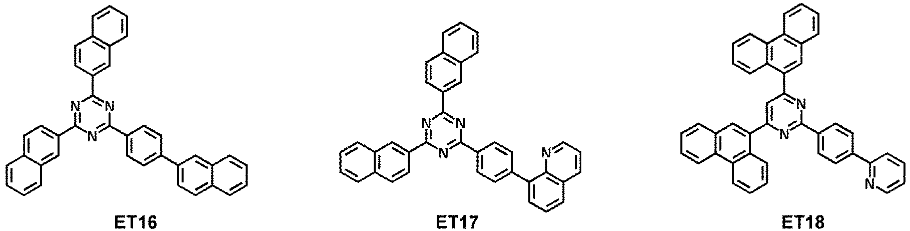

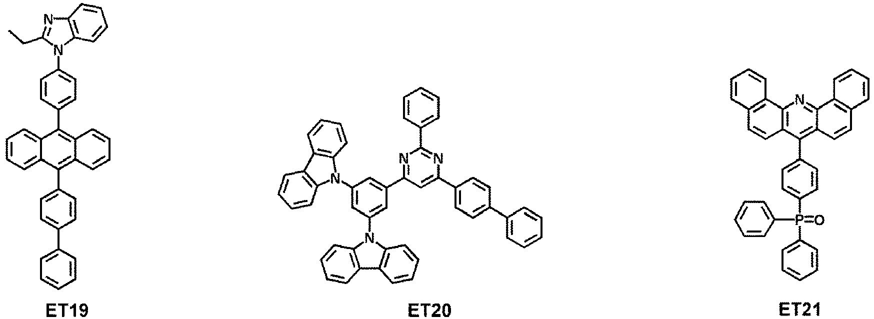

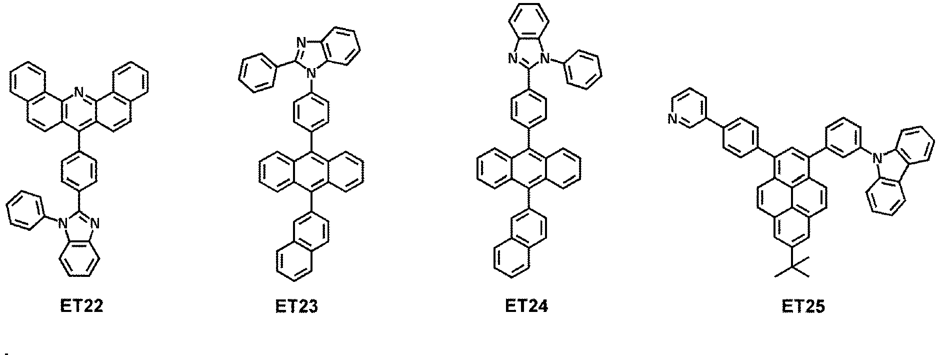

The thickness of the electron transport layer may be about 100 Å to about 1,000 Å, for example, about 150 Å to about 500 Å. When the thickness of the electron transport layer is within the range described above, satisfactory electron-transporting characteristics may be obtained without a substantial increase in driving voltage.

The electron transport layer may further include, in addition to the materials described above, a metal-containing material.

The metal-containing material may include a Li complex. The Li complex may include, for example, Compound ET-D1 (lithium 8-hydroxyquinolate, LiQ or Liq) or ET-D2, but embodiments are not limited thereto:

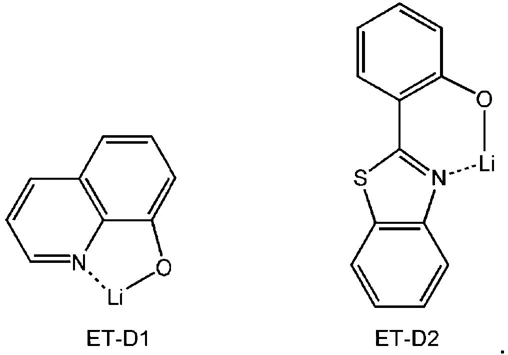

The electron transport region may include an electron injection layer that facilitates the injection of electrons from the second electrode 19.

The electron injection layer may include LiQ, LiF, NaCl, CsF, Li₂O, BaO, or a combination thereof.

The thickness of the electron injection layer may be about 1 Å to about 100 Å, for example, about 3 Å to about 90 Å. When the thickness of the electron injection layer is within the range described above, satisfactory electron injection characteristics may be obtained without a substantial increase in driving voltage.

The second electrode 19 is arranged on the organic layer 15. The second electrode 19 may be a cathode. A material for forming the second electrode 19 may be a metal, an alloy, an electrically conductive compound, or a combination thereof, each having a relatively low work function. For example, lithium (Li), magnesium (Mg), aluminum (Al), aluminum-lithium (Al-Li), calcium (Ca), magnesium-indium (Mg-In), magnesium-silver (Mg-Ag), or a combination thereof may be used as the material for forming the second electrode 19. In one or more embodiments, to manufacture a top-emission type light-emitting device, a transmissive electrode formed using ITO or IZO may be used as the second electrode 19, and various modifications may be made.

Hereinbefore, the organic light-emitting device has been described with reference to FIG. 1, but embodiments are not limited thereto.

Another aspect provides an electronic apparatus including the organic light-emitting device.

The electronic apparatus may further include a thin-film transistor in addition to the organic light-emitting device as described herein. The thin-film transistor may include a source electrode, a drain electrode, and an active layer, wherein any one of the source electrode and the drain electrode may be electrically connected to any one of the first electrode and the second electrode of the organic light-emitting device.

Another aspect provides a diagnostic composition including the heterocyclic compound represented by Formula 1.

The diagnostic composition may include at least one of the heterocyclic compounds represented by Formula 1.

The heterocyclic compound represented by Formula 1 may provide high luminescence efficiency, and thus, the diagnostic composition including the heterocyclic compound represented by Formula 1 may have high diagnostic efficiency.

The diagnostic composition may be used in various applications including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, a hexyl group, or the like. The term "C₁-C₆₀ alkylene group" as used herein refers to a divalent group having the same structure as the C₁-C₆₀ alkyl group.

Further non-limiting examples of the C₁-C₆₀ alkyl group, the C₁-C₂₀ alkyl group, and/or the C₁-C₁₀ alkyl group as used herein include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched C₆ alkyl group, and an example thereof is a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group).

Non-limiting examples of the C₁-C₆₀ alkoxy group, the C₁-C₂₀ alkoxy group, or the C₁-C₁₀ alkoxy group as used herein include a methoxy group, an ethoxy group, a propoxy group, an isopropyloxy group, a butoxy group, a pentoxy group, or the like.

The term "C₁-C₆₀ alkylthio group" as used herein refers to a monovalent group represented by -SA_{101'} (wherein A_{101'} is the C₁-C₆₀ alkyl group).

The term "C₂-C₆₀ alkenyl group" as used herein has a structure including at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein has a structure including at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon group having 3 to 10 carbon atoms, and non-limiting examples thereof include a cyclopropyl group, a cyclobutyl group, a cyclopentyl group, a cyclohexyl group, a cycloheptyl group, or the like. The term "C₃-C₁₀ cycloalkylene group" as used herein refers to a divalent group having the same structure as the C₃-C₁₀ cycloalkyl group.

Non-limiting examples of the C₃-C₁₀ cycloalkyl group as used herein include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, or the like.

The term "C₁-C₁₀ heterocycloalkyl group" as used herein refers to a monovalent group having at least one heteroatom selected from B, N, O, P, Si, S, Se, and Ge as a ring-forming atom and 1 to 10 carbon atoms as ring-forming atom(s), and non-limiting examples thereof include a tetrahydrofuranyl group, a tetrahydrothiophenyl group, or the like. The term "C₁-C₁₀ heterocycloalkylene group" as used herein refers to a divalent group having the same structure as the C₁-C₁₀ heterocycloalkyl group.

Other examples of the C₁-C₁₀ heterocycloalkyl group as used herein include a silolanyl group, a silinanyl group, a tetrahydrofuranyl group, a tetrahydro-2H-pyranyl group, a tetrahydrothiophenyl group, or the like.

The term "C₃-C₁₀ cycloalkenyl group" as used herein refers to a monovalent group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent group that has at least one heteroatom selected from B, N, O, P, Si, S, Se, and Ge as a ring-forming atom, 1 to 10 carbon atoms as ring-forming atom(s), and at least one double bond in the ring thereof. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the two or more rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having a heterocyclic aromatic system having at least one heteroatom selected from B, N, O, P, Si, S, Se, and Ge as a ring-forming atom and 1 to 60 carbon atoms as ring-forming atom(s). The term "C₁-C₆₀ heteroarylene group" as used herein refers to a divalent group having a heterocyclic aromatic system having at least one heteroatom selected from B, N, O, P, Si, S, Se, and Ge as a ring-forming atom and 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the two or more rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₁-C₆₀ heteroaryloxy group" as used herein refers to -OA₁₀₄ (wherein A₁₀₄ is the C₁-C₆₀ heteroaryl group), and the term "C₁-C₆₀ heteroarylthio group" as used herein refers to -SA₁₀₅ (wherein A₁₀₅ is the C₁-C₆₀ heteroaryl group).

The term "monovalent non-aromatic condensed polycyclic group" as used herein refers to a monovalent group (e.g., having 8 to 60 carbon atoms) having two or more rings condensed with each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (e.g., having 1 to 60 carbon atoms) having two or more rings condensed with each other, a heteroatom selected from B, N, O, P, Si, S, Se, and Ge, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having 5 to 30 carbon atoms only as ring-forming atoms. The C₅-C₃₀ carbocyclic group may be a monocyclic group or a polycyclic group. Non-limiting examples of the "C₅-C₃₀ carbocyclic group (unsubstituted or substituted with at least one R₁₀ₐ)" as used herein include an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a silole group, a fluorene group, or the like (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from B, N, O, Si, P, S, Se, and Ge other than 1 to 30 carbon atoms as ring-forming atom(s). The C₁-C₃₀ heterocyclic group may be a monocyclic group or a polycyclic group. Non-limiting examples of the "C₁-C₃₀ heterocyclic group (unsubstituted or substituted with at least one R₁₀ₐ)" as used herein include a thiophene group, a furan group, a pyrrole group, a silole group, borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

The term "TMS" as used herein refers to *-Si(CH₃)₃, and the term "TMG" as used herein refers to *-Ge(CH₃)₃. A term "(C₁-C₂₀ alkyl) X group" (e.g., (C₁-C₂₀ alkyl) phenyl group) as used herein refers to an X group (e.g., a phenyl group) substituted with at least one C₁-C₂₀ alkyl group.

At least one substituent of the substituted C₅-C₃₀ carbocyclic group, the substituted C₁-C₃₀ heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may each independently be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q_{11A})(Q_{12A}), -Si(Q_{11A})(Q_{12A})(Q_{13A}), -Ge(Q_{11A})(Q_{12A})(Q_{13A}), - C(=O)(Q_{11A}), -S(=O)(Q_{11A}), -S(=O)2(Q_{11A}), -B(Q_{11A})(Q_{12A}), -P(Q_{11A})(Q_{12A}), - P(=O)(Q_{11A})(Q_{12A}), -P(=S)(Q_{11A})(Q_{12A}), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q_{21A})(Q_{22A}), -Si(Q_{21A})(Q_{22A})(Q_{23A}), -Ge(Q_{21A})(Q_{22A})(Q_{23A}), - C(=O)(Q_{21A}), -S(=O)(Q_{21A}), -S(=O)₂(Q_{21A}), -B(Q_{21A})(Q_{22A}), -P(Q_{21A})(Q_{22A}), - P(=O)(Q_{21A})(Q_{22A}), -P(=S)(Q_{21A})(Q_{22A}), or a combination thereof;
-N(Q_{31A})(Q_{32A}), -Si(Q_{31A})(Q_{32A})(Q_{33A}), -Ge(Q_{31A})(Q_{32A})(Q_{33A}), - C(=O)(Q_{31A}), -S(=O)(Q_{31A}), -S(=O)₂(Q_{31A}), -B(Q_{31A})(Q_{32A}), -P(Q_{31A})(Q_{32A}), - P(=O)(Q_{31A})(Q_{32A}), or -P(=S)(Q_{31A})(Q_{32A}); or
a combination thereof, and
Q_{1A} to Q_{3A}, Q_{11A} to Q_{13A}, Q_{21A} to Q_{23A}, and Q_{31A} to Q_{33A} may each independently be:
   hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group; or
   a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof.

Hereinafter, heterocyclic compounds represented by Formula 1 and an organic light-emitting devices according to exemplary embodiments will be described in detail with reference to Synthesis Example and Examples. However, the embodiments are not limited thereto. The wording "'B' was used instead of 'A'" used in describing Synthesis Examples means that an amount of 'A' used was identical to an amount of 'B' used, in terms of a molar equivalent.

### EXAMPLES

### Synthesis Examples

### Synthesis Example 1: Synthesis of Compound 74

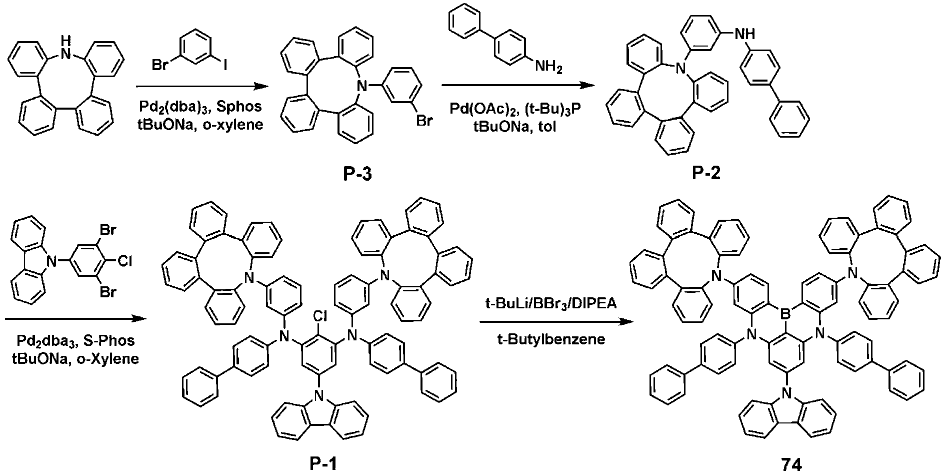

### (1) Synthesis of Compound P-3

Under a nitrogen atmosphere, 9H-tetrabenzo[b,d,f,h]azonine (8 grams (g), 25.05 millimoles (mmol)), 1-bromo-3-iodobenzene (8.58 g, 25.05 mmol), tris(dibenzylideneacetone)dipalladium(0) (Pd₂(dba)₃) (0.230 g, 0.251 mmol), 2-dicyclohexylphosphino-2',6'-dimethoxybiphenyl (SPhos) (0.206 g, 0.501 mmol), and sodium t-butoxide (3.61 g, 37.58 mmol) were added to 250 milliliters (mL) of o-xylene, and heated to 120°C. After cooling to room temperature for 12 hours, the reaction was terminated by using an aqueous ammonium chloride solution. The reaction mixture was subjected to an extraction process by using ethyl acetate, and the organic layer was separated and dried by using MgSO₄. After filtration, the solvent was removed therefrom, and the resulting product was purified by column chromatography using methylene chloride (MC):hexane (at a volume ratio of 1:3) to thereby obtain 7.1 g of a white solid (yield: 60 %).

Liquid chromatography mass spectrometry (LCMS) (m/z) calculated: 473.08 grams per mole (g/mol), found: [M+] 473.89 g/mol.

### (2) Synthesis of Compound P-2

Under a nitrogen atmosphere, Compound P-3 (7 g, 14.76 mmol), [1,1'-biphenyl]-4-amine (2.5 g, 14.76 mmol), palladium(II) acetate (Pd(OAc)₂) (0.33 g, 1.48 mmol), tri-tert-butylphoshine (0.6 g, 2.96 mmol), and sodium t-butoxide (2.13 g, 22.14 mmol) were added to 150 mL of toluene, and heated at reflux at 100 °C. After cooling to room temperature for 2 hours, the reaction was terminated by using an aqueous ammonium chloride solution. The reaction mixture was subjected to an extraction process by using ethyl acetate, and the organic layer was separated and then dried by using MgSO₄. The solution was filtered, the solvent was removed therefrom under reduced pressure, and the resulting product was purified by column chromatography using MC:hexane (at a volume ratio of 1:3) to thereby obtain 6.0 g of a white solid (yield: 73 %).

LCMS (m/z) calculated: 562.24 g/mol, found: [M+] 561.97 g/mol.

### (3) Synthesis of Compound P-1

Under a nitrogen atmosphere, Compound P-2 (6 g, 10.66 mmol), 9-(3,5-dibromo-4-chlorophenyl)-9H-carbazole (2.32 g, 5.33 mmol), Pd₂(dba)₃ (0.12 g, 0.53 mmol), Sphos (0.44 g, 1.06 mmol), and sodium t-butoxide (0.77 g, 8.0 mmol) were added to 100 mL of o-xylene, and heated at reflux at 120 °C. After cooling to room temperature for 1 hour, the reaction was terminated by using an aqueous ammonium chloride solution. The reaction mixture was subjected to an extraction process by using ethyl acetate, and the organic layer was separated and dried by using MgSO₄. The solution was filtered, the solvent was removed therefrom under reduced pressure, and the resulting product was purified by column chromatography using MC:hexane (at a volume ratio of 1:3) to thereby obtain 4.03 g of a white solid (yield: 54 %).

LCMS (m/z) calculated: 1397.52 g/mol, found: [M+] 1399.54 g/mol.

### (4) Synthesis of Compound 74

Under a nitrogen atmosphere, Compound P-1 (3 g, 2.14 mmol) was dissolved in 30 mL of t-butylbenzene, and cooled to -78°C. Then, tertiary butyl lithium (t-BuLi) (5.54 ml, 9.42 mmol) was added thereto, and the temperature was raised to 60°C, followed by stirring for 1 hour and 30 minutes. After cooling to 0 °C, boron tribromide (0.89 ml, 9.42 mmol) was added thereto, followed by stirring at room temperature for 1 hour and 30 minutes. After cooling to 0°C, N,N-diisopropylethyl acetate (1.62 ml, 9.42 mmol) was added thereto, followed by heating at 120°C for 4 hours. Then, the solution was cooled to room temperature, and the reaction was terminated by using an aqueous sodium acetate solution (1.0 M). An organic layer was extracted from the reaction mixture, and the organic layer was dried by using MgSO₄. The solution was filtered, the solvent was removed therefrom under reduced pressure, and the resulting product was purified by column chromatography using MC:hexane (at a volume ratio of 1:4) to thereby obtain 0.5 g of a yellow solid as Compound 74 (yield: 17 %).

LCMS (m/z) calculated: 1371.54 g/mol, found: [M+] 1373.6153 g/mol.

### Example 1

An ITO glass substrate was cut to a size of 50 millimeters (mm) x 50 mm x 0.5 mm, sonicated in acetone, isopropyl alcohol, and deionized (DI) water, each for 15 minutes, and then cleaned by exposure to UV ozone for 30 minutes. The ITO glass substrate was loaded onto a vaccum deposition apparatus.

Then, HAT-CN was deposited on the ITO electrode (anode) on the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron-blocking layer having a thickness of 50 Å.

A first host (H25), a second host (H26), a sensitizer (PT1), and an emitter (Compound 74) were co-deposited on the electron-blocking layer to form an emission layer having a thickness of 400 Å. In this regard, the first host and the second host were mixed at a weight ratio of 65:35, and the amounts of the sensitizer and the emitter were adjusted to be 13 wt% and 1.2 wt%, respectively, based on the total weight of the first host, the second host, the sensitizer, and the emitter.

DBFPO was deposited on the emission layer to form a hole-blocking layer having a thickness of 100 Å, DBFPO and LiQ were co-deposited thereon at a weight ratio of 5:5 to form an electron transport layer having a thickness of 300 Å, LiQ was deposited on the electron transport layer to form an electron injection layer having a thickness of 10 Å, and AI was deposited on the electron injection layer to form a cathode having a thickness of 1,000 Å, thereby completing the manufacture of an organic light-emitting device.

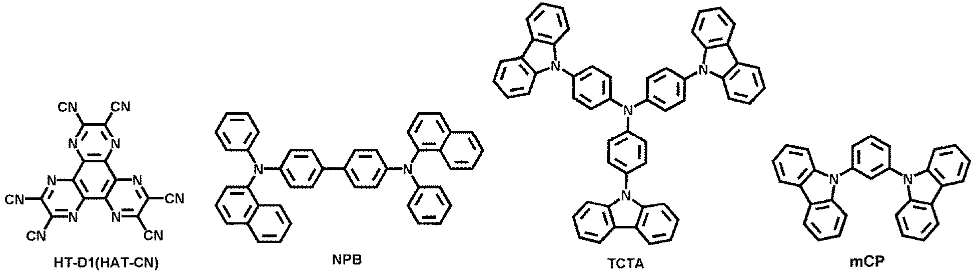

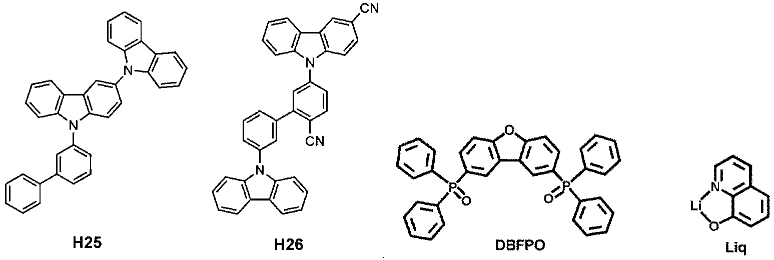

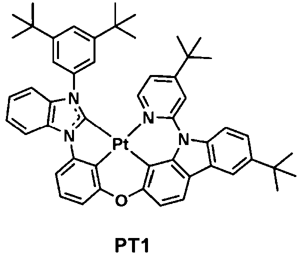

### Example 2 and Comparative Examples 1 to 3

Organic light-emitting devices were manufactured in the same manner as in Example 1, except that compounds shown in Table 1 were each used instead of Compound 74 as an emitter in forming an emission layer.

For each of the organic light-emitting devices manufactured in Examples 1 and 2 and Comparative Examples 1 to 3, the relative efficiency (%) and maximum emission wavelength (λₘₐₓ, nm) of the emission spectrum were measured and evaluated by using a current-voltage meter (Keithley 2400) and a luminance meter (Minolta Cs-1000A), and the results thereof are shown in Table 1. The relative efficiency is reported relative to Comparative Example 1.

In addition, for each of the compounds used as an emitter in the emission layer, shown in Table 1, the compound was dissolved in dichloromethane (MC) together with polymethyl methacrylate (PMMA) to a concentration of 1 wt%, and spin-coated on a quartz substrate (20 mm X 20 mm) to form a thin film. After the emitter compound in the thin film was excited by an excitation wavelength of 330 nm at room temperature, the photoluminescence quantum yield (PLQY) and FWHM were measured, and the results thereof are shown in Table 1.

**Table 1**

| | Emitter in emission layer | PLQY | FWHM (nm) | Relative efficiency (%) | λₘₐₓ (nm) |
|---|---|---|---|---|---|
| Example 1 | Compound 74 | 0.996 | 22 | 285 | 453 |
| Example 2 | Compound 75 | 0.997 | 18 | 287 | 478 |
| Comparative Example 1 | Compound A | 0.965 | 22 | 100 | 465 |
| Comparative Example 2 | Compound B | 0.968 | 17 | 184 | 449 |
| Comparative Example 3 | Compound C | 0.993 | 18 | 253 | 451 |

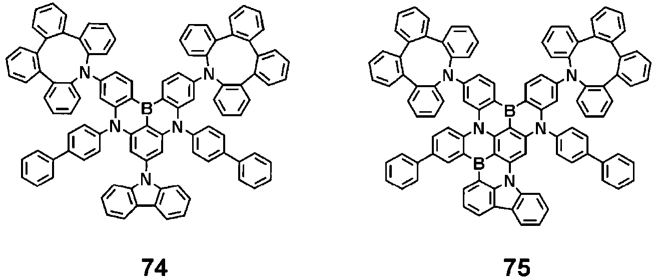

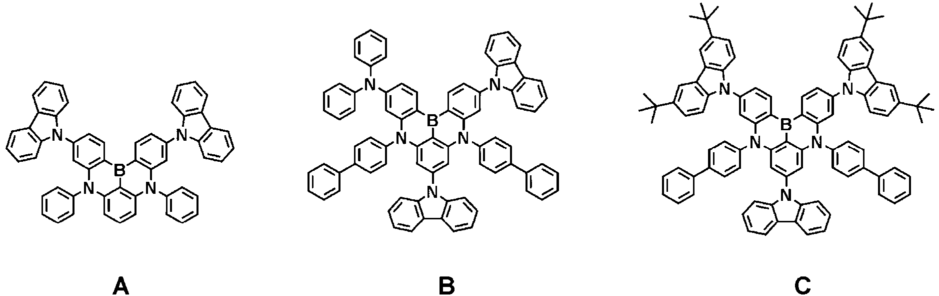

Referring to Table 1, it was found that a heterocyclic compound represented by Formula 1 had a higher PLQY and an equal or narrower FWHM compared to the compounds of Comparative Examples 1 to 3. In addition, it was found that an organic light-emitting device according to Examples 1 and 2 had superior relative efficiency compared to the organic light-emitting devices of Comparative Examples 1 to 3.

As described above, a heterocyclic compound represented by Formula 1 may have excellent luminescence characteristics and charge mobility characteristics, and thus, an electronic device, for example, an organic light-emitting device, including the heterocyclic compound represented by Formula 1 may have characteristics of low driving voltage, high efficiency, and/or long lifespan. Accordingly, a high-quality organic light-emitting device and an electronic apparatus including the same may be implemented by using the heterocyclic compound represented by Formula 1.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A heterocyclic compound represented by Formula 1: 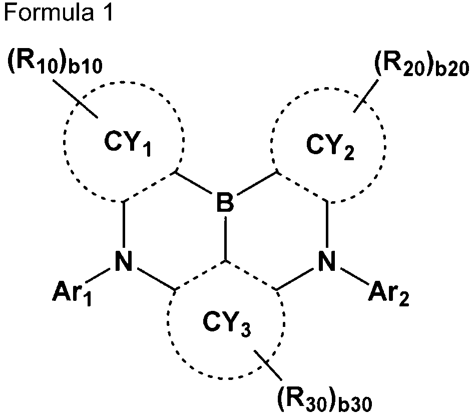 wherein, in Formula 1,
ring CY₁ to ring CY₃ are each independently a C₅-C₃₀ carbocyclic group unsubstituted or substituted with Q₁, Z₁, or a combination thereof; or a C₁-C₃₀ heterocyclic group unsubstituted or substituted with Q₁, Z₁, or a combination thereof,
at least one of ring CY₁ to ring CY₃ is substituted with Q₁,
Q₁ is a group represented by Formula 2, 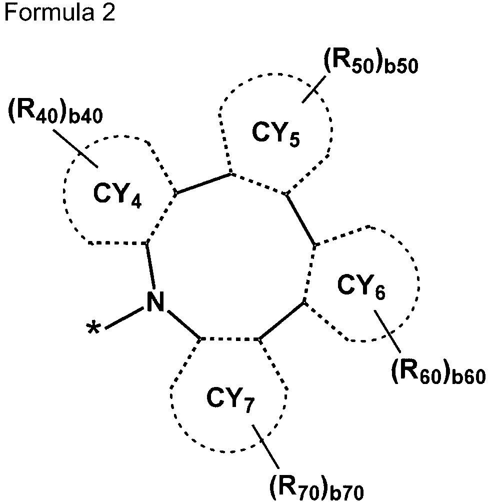
Z₁ is a group represented by Formula 3, and 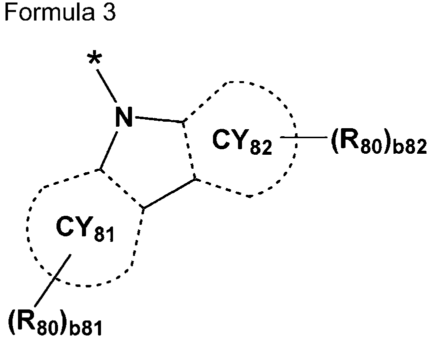
Ar₁ and Ar₂ are each independently a group represented by Formula 4, hydrogen, deuterium, -F, -Cl, -Br, -I, -SF₅, a hydroxyl group, a cyano group, a nitro group, an amino group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q_{1A})(Q_{2A}), - Si(Q_{1A})(Q_{2A})(Q_{3A}), -Ge(Q_{1A})(Q_{2A})(Q_{3A}), -C(=O)(Q_{1A}), -S(=O)(Q_{1A}), -S(=O)₂(Q_{1A}), - B(Q_{1A})(Q_{2A}), -P(Q_{1A})(Q_{2A}), -P(=O)(Q_{1A})(Q_{2A}), or -P(=S)(Q_{1A})(Q_{2A}), 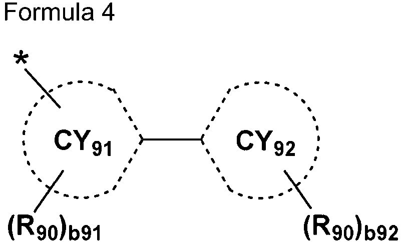
wherein, in Formulae 1 to 4,
ring CY₄ to ring CY₇, ring CY₈₁, ring CY₈₂, ring CY₉₁, and ring CY₉₂ are each independently a C₅-C₃₀ carbocyclic group or a C₁-C₃₀ heterocyclic group,
R₁₀, R₂₀, R₃₀, R₄₀, R₅₀, R₆₀, R₇₀, R₈₀, and R₉₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q_{1A})(Q_{2A}), -Si(Q_{1A})(Q_{2A})(Q_{3A}), -Ge(Q_{1A})(Q_{2A})(Q_{3A}), -C(=O)(Q_{1A}), - S(=O)(Q_{1A}), -S(=O)₂(Q_{1A}), -B(Q_{1A})(Q_{2A}), -P(Q_{1A})(Q_{2A}), -P(=O)(Q_{1A})(Q_{2A}), or - P(=S)(Q_{1A})(Q_{2A}),
b10, b20, b30, b40, b50, b60, b70, b81, b82, b91, and b92 are each independently 1, 2, 3, 4, 5, 6, 7, 8, 9, 10, 11, 12, 13, or 14,
neighboring two or more of R₁₀, R₂₀, R₃₀, R₄₀, R₅₀, R₆₀, R₇₀, R₈₀, and R₉₀ are optionally bonded to each other to form a substituted or unsubstituted C₅-C₃₀ carbocyclic group or a substituted or unsubstituted C₁-C₃₀ heterocyclic group,
two or more of a plurality of R₁₀ are optionally bonded to each other to form a substituted or unsubstituted C₅-C₃₀ carbocyclic group or a substituted or unsubstituted C₁-C₃₀ heterocyclic group,
two or more of a plurality of R₂₀ are optionally bonded to each other to form a substituted or unsubstituted C₅-C₃₀ carbocyclic group or a substituted or unsubstituted C₁-C₃₀ heterocyclic group,
two or more of a plurality of R₃₀ are optionally bonded to each other to form a substituted or unsubstituted C₅-C₃₀ carbocyclic group or a substituted or unsubstituted C₁-C₃₀ heterocyclic group,
two or more of a plurality of R₄₀ are optionally bonded to each other to form a substituted or unsubstituted C₅-C₃₀ carbocyclic group or a substituted or unsubstituted C₁-C₃₀ heterocyclic group,
two or more of a plurality of R₅₀ are optionally bonded to each other to form a substituted or unsubstituted C₅-C₃₀ carbocyclic group or a substituted or unsubstituted C₁-C₃₀ heterocyclic group,
two or more of a plurality of R₆₀ are optionally bonded to each other to form a substituted or unsubstituted C₅-C₃₀ carbocyclic group or a substituted or unsubstituted C₁-C₃₀ heterocyclic group,
two or more of a plurality of R₇₀ are optionally bonded to each other to form a substituted or unsubstituted C₅-C₃₀ carbocyclic group or a substituted or unsubstituted C₁-C₃₀ heterocyclic group,
two or more of a plurality of R₈₀ are optionally bonded to each other to form a substituted or unsubstituted C₅-C₃₀ carbocyclic group or a substituted or unsubstituted C₁-C₃₀ heterocyclic group,
two or more of a plurality of R₉₀ are optionally bonded to each other to form a substituted or unsubstituted C₅-C₃₀ carbocyclic group or a substituted or unsubstituted C₁-C₃₀ heterocyclic group,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is each independently:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q_{11A})(Q_{12A}), -Si(Q_{11A})(Q_{12A})(Q_{13A}), -Ge(Q_{11A})(Q_{12A})(Q_{13A}), -C(=O)(Q_{11A}), - S(=O)(Q_{11A}), -S(=O)₂(Q_{11A}), -B(Q_{11A})(Q_{12A}), -P(Q_{11A})(Q_{12A}), -P(=O)(Q_{11A})(Q_{12A}), - P(=S)(Q_{11A})(Q_{12A}), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q_{21A})(Q_{22A}), -Si(Q_{21A})(Q_{22A})(Q_{23A}), - Ge(Q_{21A})(Q_{22A})(Q_{23A}), -C(=O)(Q_{21A}), -S(=O)(Q_{21A}), -S(=O)₂(Q_{21A}), -B(Q_{21A})(Q_{22A}), - P(Q_{21A})(Q_{22A}), -P(=O)(Q_{21A})(Q_{22A}), -P(=S)(Q_{21A})(Q_{22A}), or a combination thereof;
-N(Q_{31A})(Q_{32A}), -Si(Q_{31A})(Q_{32A})(Q_{33A}), -Ge(Q_{31A})(Q_{32A})(Q_{33A}), -C(=O)(Q_{31A}), - S(=O)(Q_{31A}), -S(=O)₂(Q_{31A}), -B(Q_{31A})(Q_{32A}), -P(Q_{31A})(Q_{32A}), -P(=O)(Q_{31A})(Q_{32A}), or - P(=S)(Q_{31A})(Q_{32A}); or
a combination thereof,
Q_{1A} to Q_{3A}, Q_{11A} to Q_{13A}, Q_{21A} to Q_{23A}, and Q_{31A} to Q_{33A} are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group; or
a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with deuterium, -F, -Cl, -Br, -I, -SF₅, a hydroxyl group, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, or a combination thereof, and
* indicates a binding site to a neighboring atom.

2. The heterocyclic compound of claim 1, wherein ring CY₁ to ring CY₃ are each independently a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group, each unsubstituted or substituted with Q₁, Z₁, or a combination thereof.

3. The heterocyclic compound of claims 1 or 2, wherein ring CY₄ to ring CY₇, ring CY₈₁, ring CY₈₂, ring CY₉₁, and ring CY₉₂ are each independently a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

4. The heterocyclic compound of any of claims 1-3, wherein Q₁ is a group represented by Formula 2A: 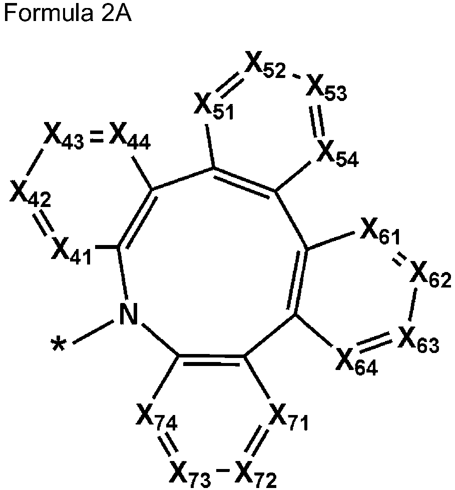 wherein, in Formula 2A,
X₄₁ is C(R₄₁) or N, X₄₂ is C(R₄₂) or N, X₄₃ is C(R₄₃) or N, and X₄₄ is C(R₄₄) or N,
X₅₁ is C(R₅₁) or N, X₅₂ is C(R₅₂) or N, X₅₃ is C(R₅₃) or N, and X₅₄ is C(R₅₄) or N,
X₆₁ is C(R₆₁) or N, X₆₂ is C(R₆₂) or N, X₆₃ is C(R₆₃) or N, and X₆₄ is C(R₆₄) or N,
X₇₁ is C(R₇₁) or N, X₇₂ is C(R₇₂) or N, X₇₃ is C(R₇₃) or N, and X₇₄ is C(R₇₄) or N,
R₄₁ to R₄₄ are each independently as described in connection with R₄₀ in claim 1,
R₅₁ to R₅₄ are each independently as described in connection with R₅₀ in claim 1,
R₆₁ to R₆₄ are each independently as described in connection with R₆₀ in claim 1,
R₇₁ to R₇₄ are each independently as described in connection with R₇₀ in claim 1, and
* indicates a binding site to a neighboring atom; and/or
wherein Z₁ is a group represented by Formula 3A: 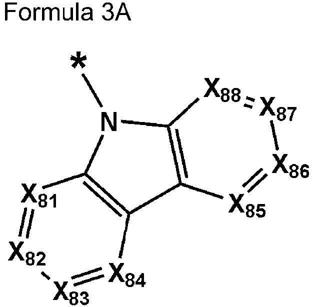
wherein, in Formula 3A,
X₈₁ is C(R₈₁) or N, X₈₂ is C(R₈₂) or N, X₈₃ is C(R₈₃) or N, X₈₄ is C(R₈₄) or N, X₈₅ is C(R₈₅) or N, X₈₆ is C(R₈₆) or N, X₈₇ is C(R₈₇) or N, and X₈₈ is C(R₈₈) or N,
R₈₁ to R₈₈ are each independently as described in connection with R₈₀ in claim 1, and
* indicates a binding site to a neighboring atom.

5. The heterocyclic compound of any of claims 1-4, wherein Ar₁ and Ar₂ are each independently the group represented by Formula 4; and/or
wherein the group represented by Formula 4 is a group represented by one of Formulae 4A to 4C: 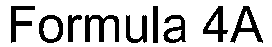 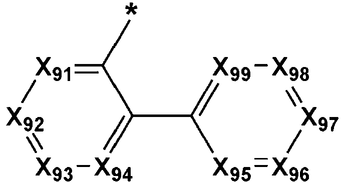 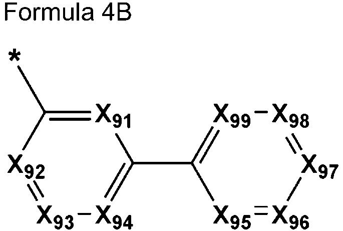 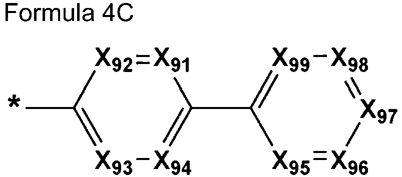 wherein, in Formulae 4A to 4C,
X₉₁ is C(R₉₁) or N, X₉₂ is C(R₉₂) or N, X₉₃ is C(R₉₃) or N, X₉₄ is C(R₉₄) or N, X₉₅ is C(R₉₅) or N, X₉₆ is C(R₉₆) or N, X₉₇ is C(R₉₇) or N, X₉₈ is C(R₉₈) or N, and X₉₉ is C(R₉₉) or N,
R₉₁ to R₉₉ are each independently as described in connection with R₉₀ in claim 1, and
* indicates a binding site to a neighboring atom.

6. The heterocyclic compound of any of claims 1-5, wherein R₁₀, R₂₀, R₃₀, R₄₀, R₅₀, R₆₀, R₇₀, R₈₀, and R₉₀ are each independently:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (a norbornanyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -,I -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q_{1A})(Q_{2A}), -Si(Q_{1A})(Q_{2A})(Q_{3A}), -Ge(Q_{1A})(Q_{2A})(Q_{3A}), -B(Q_{1A})(Q_{2A}), - P(=O)(Q_{1A})(Q_{2A}), or -P(Q_{1A})(Q_{2A}).

7. The heterocyclic compound of any of claims 1-6, wherein the heterocyclic compound is represented by one of Formulae 11 to 17: 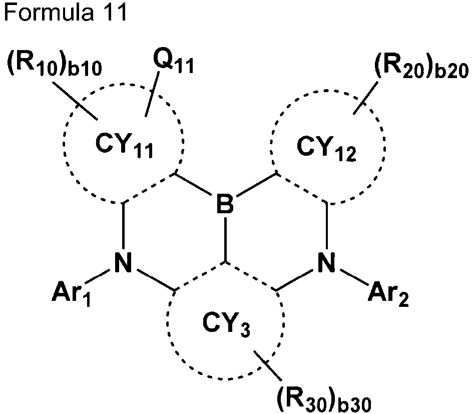 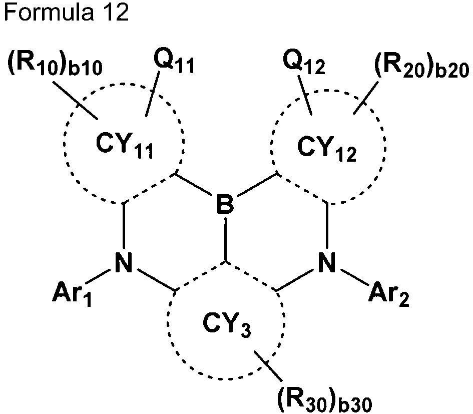 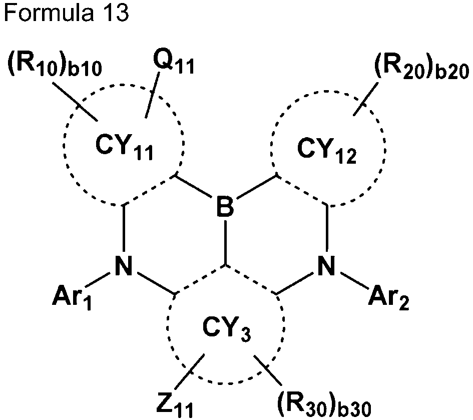 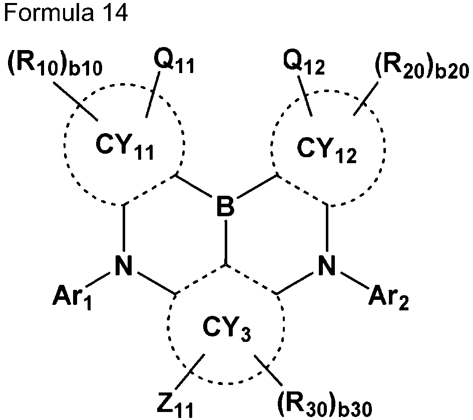 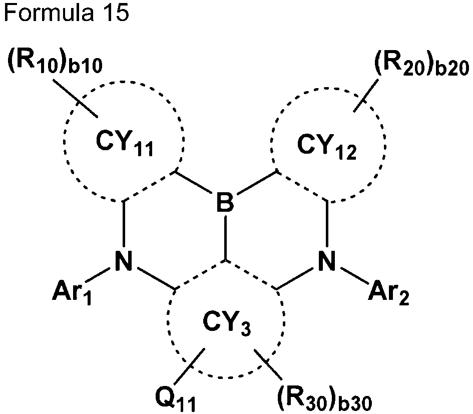 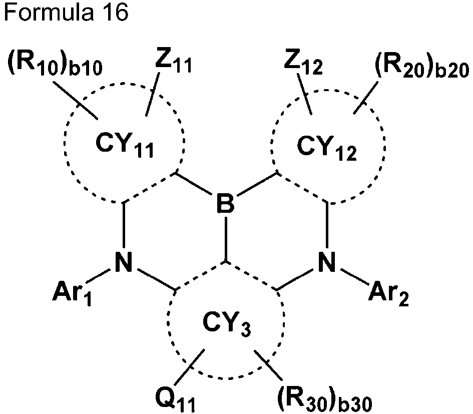 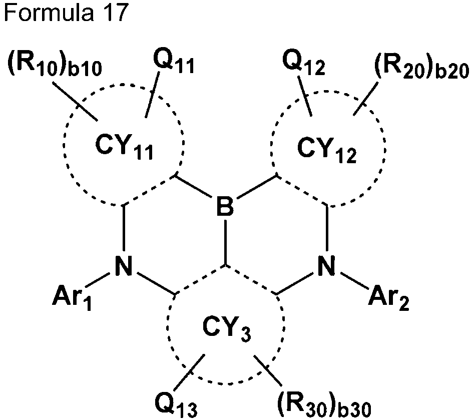 wherein, in Formulae 11 to 17,
ring CY₃, Ar₁, Ar₂, R₁₀, R₂₀, R₃₀, b10, b20, and b30 are each as described in claim 1,
ring CY₁₁ and ring CY₁₂ are each independently a C₅-C₃₀ carbocyclic group or a C₁-C₃₀ heterocyclic group,
Q₁₁ to Q₁₃ are each independently as described in connection with Q₁ in claim 1, and
Z₁₁ and Z₁₂ are each independently as described in connection with Z₁ in claim 1.

8. The heterocyclic compound of any of claims 1-7, wherein
the heterocyclic compound is represented by one of Formulae 21 to 23: 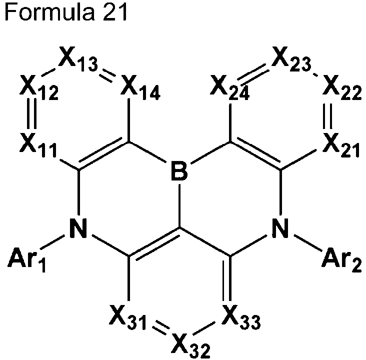 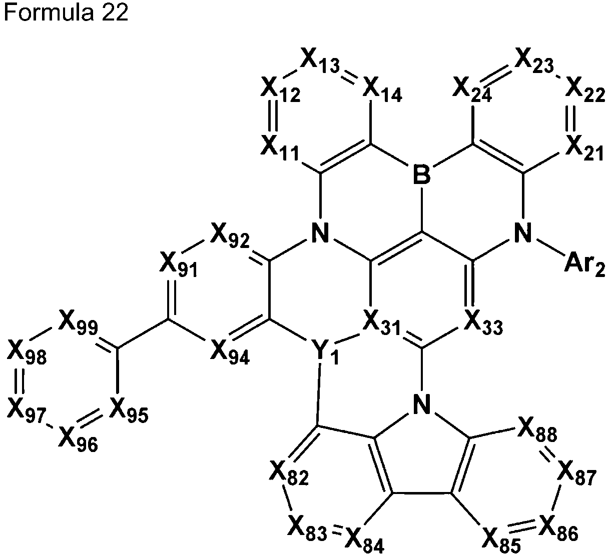 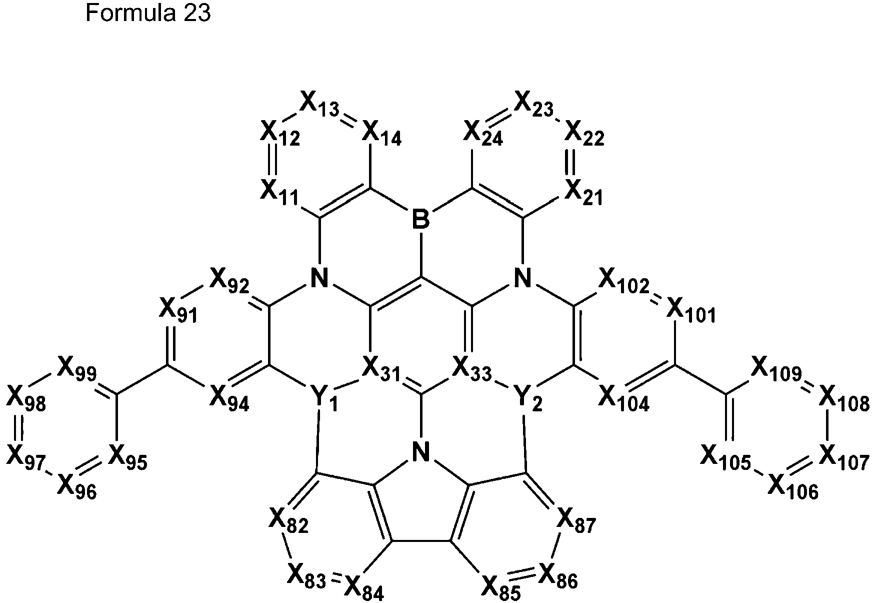 wherein, in Formulae 21 to 23,
Ar₁ and Ar₂ are each as described in claim 1,
Y₁ and Y₂ are each independently B, N, P, P(=O), or P(=S),
X₁₁ is C(Q₁), C(Z₁), C(R₁₁), or N, X₁₂ is C(Q₁), C(Z₁), C(R₁₂), or N, X₁₃ is C(Q₁), C(Z₁), C(R₁₃), or N, and X₁₄ is C(Q₁), C(Z₁), C(R₁₄), or N,
X₂₁ is C(Q₁), C(Z₁), C(R₂₁), or N, X₂₂ is C(Q₁), C(Z₁), C(R₂₂), or N, X₂₃ is C(Q₁), C(Z₁), C(R₂₃), or N, and X₂₄ is C(Q₁), C(Z₁), C(R₂₄), or N,
in Formula 21, X₃₁ is C(Q₁), C(Z₁), C(R₃₁), or N, X₃₂ is C(Q₁), C(Z₁), C(R₃₂), or N, and X₃₃ is C(Q₁), C(Z₁), C(R₃₃), or N; in Formula 22, X₃₁ is C, and X₃₃ is C(Q₁), C(Z₁), C(R₃₃), or N; in Formula 23, X₃₁ and X₃₃ are each C,
X₈₂ is C(R₈₂) or N, X₈₃ is C(R₈₃) or N, X₈₄ is C(R₈₄) or N, X₈₅ is C(R₈₅) or N, X₈₆ is C(R₈₆) or N, X₈₇ is C(R₈₇) or N, and X₈₈ is C(R₈₈) or N,
X₉₁ is C(R₉₁) or N, X₉₂ is C(R₉₂) or N, X₉₄ is C(R₉₄) or N, X₉₅ is C(R₉₅) or N, X₉₆ is C(R₉₆) or N, X₉₇ is C(R₉₇) or N, X₉₈ is C(R₉₈) or N, and X₉₉ is C(R₉₉) or N,
X₁₀₁ is C(R₁₀₁) or N, X₁₀₂ is C(R₁₀₂) or N, X₁₀₄ is C(R₁₀₄) or N, X₁₀₅ is C(R₁₀₅) or N, X₁₀₆ is C(R₁₀₆) or N, X₁₀₇ is C(R₁₀₇) or N, X₁₀₈ is C(R₁₀₈) or N, and X₁₀₉ is C(R₁₀₉) or N,
at least one of X₁₁ to X₁₄, X₂₁ to X₂₄, or X₃₁ to X₃₃ in Formula 21 is C(Q₁),
at least one of X₁₁ to X₁₄ or X₂₁ to X₂₄ in Formulae 22 and 23 is C(Q₁), R₁₁ to R₁₄ are each independently as described in connection with R₁₀ in claim 1,
R₂₁ to R₂₄ are each independently as described in connection with R₂₀ in claim 1,
R₃₁ to R₃₃ are each independently as described in connection with R₃₀ in claim 1,
R₈₂ to R₈₈ are each independently as described in connection with R₈₀ in claim 1, and
R₉₁, R₉₂, R₉₄ to R₉₉, R₁₀₁, R₁₀₂, and R₁₀₄ to R₁₀₉ are each independently as described in connection with R₉₀ in claim 1.

9. The heterocyclic compound of any of claims 1-8, wherein the heterocyclic compound is represented by one of Formulae 31 to 42: 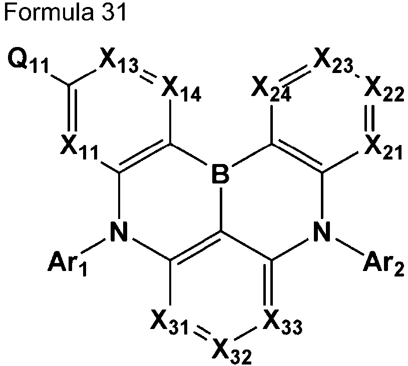 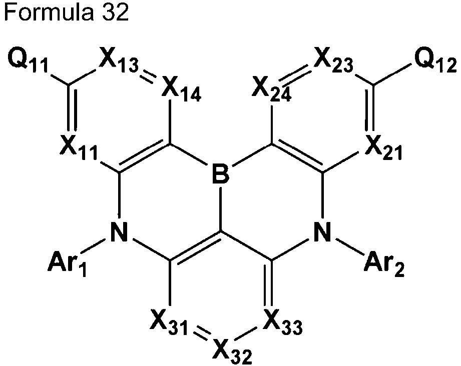 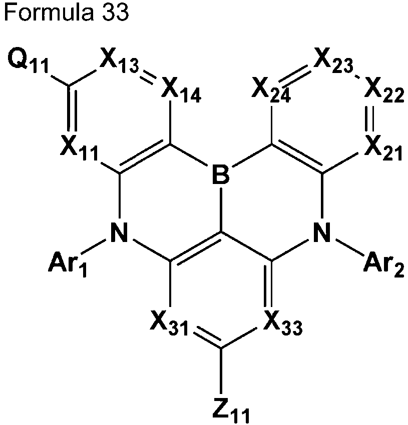 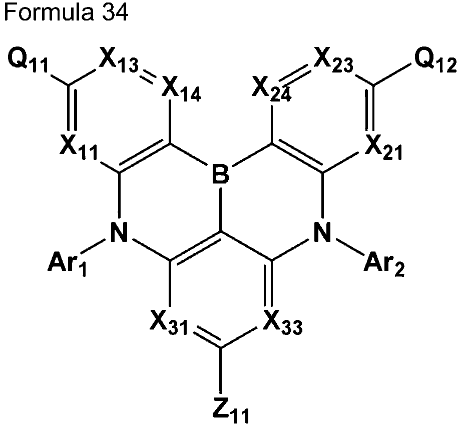 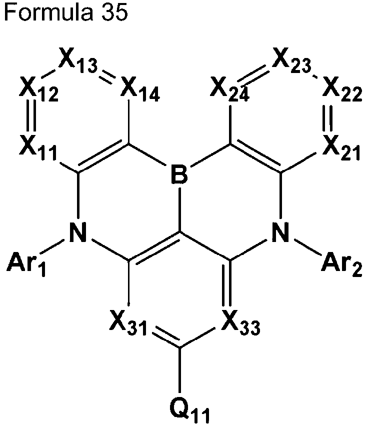 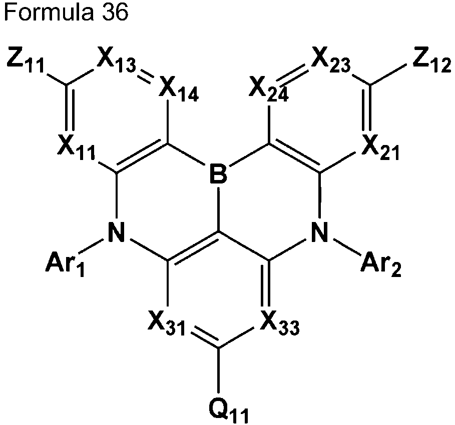 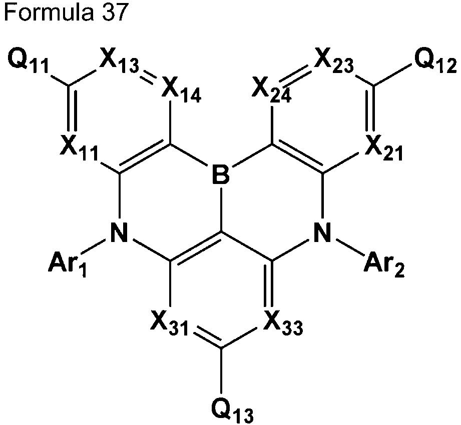 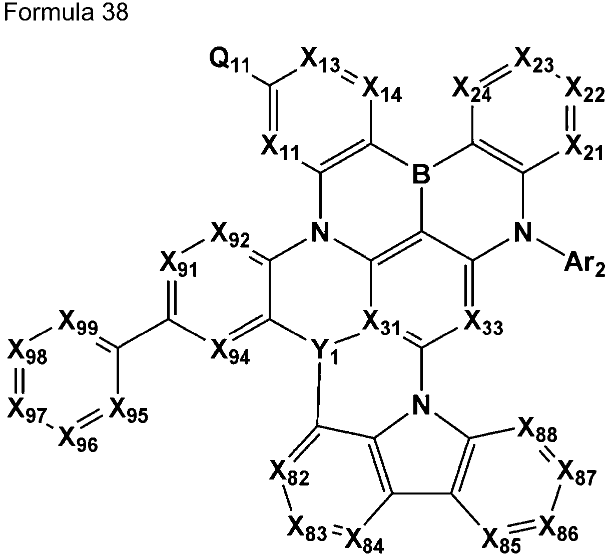 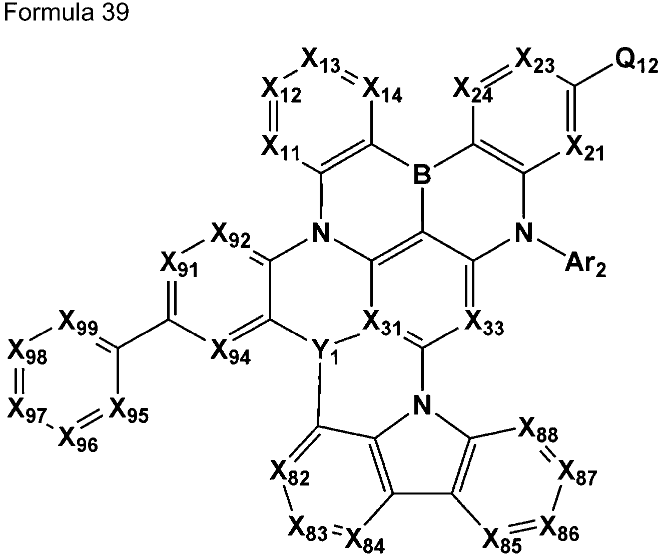 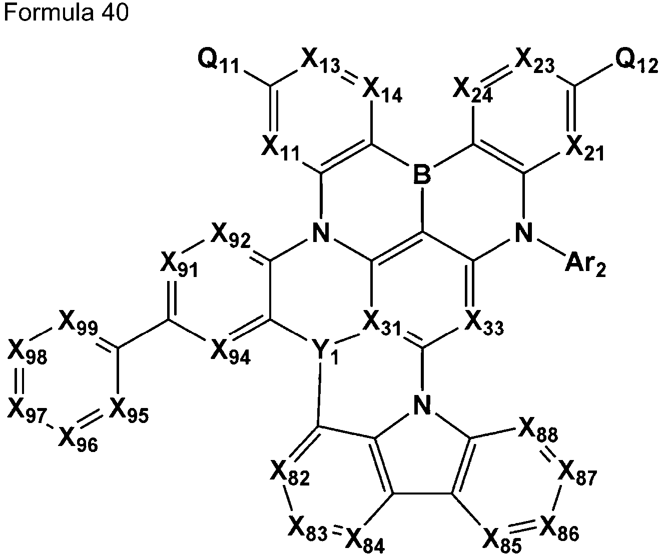 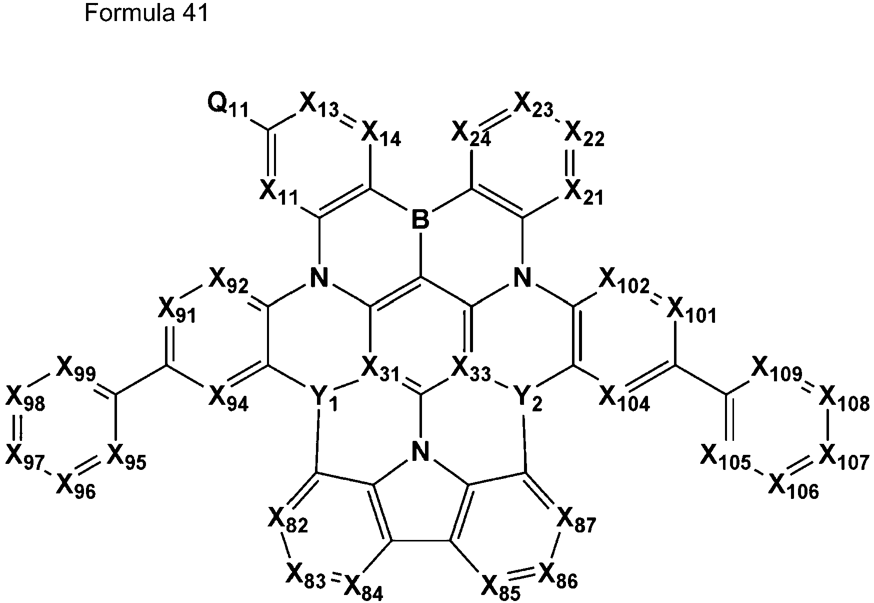 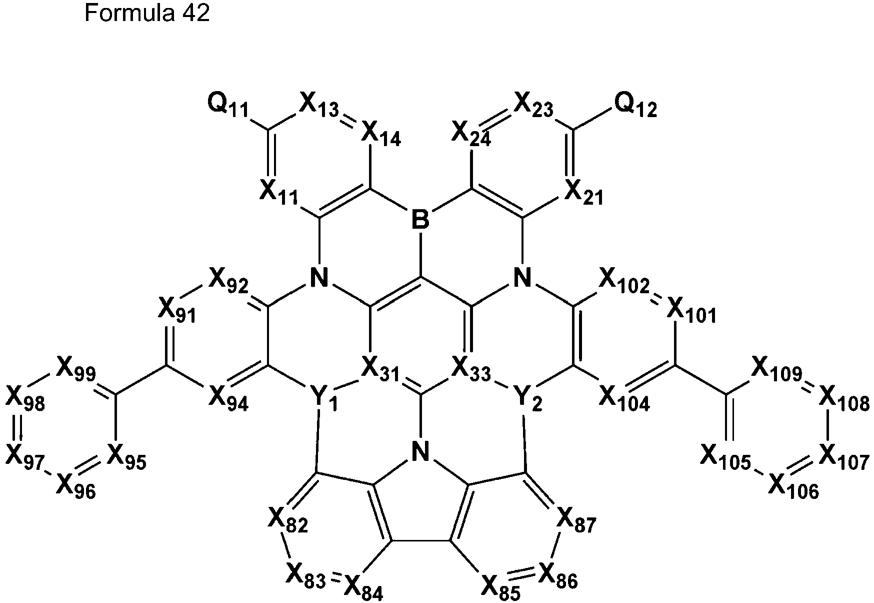 wherein, in Formulae 31 to 42,
Ar₁ and Ar₂ are each as described in claim 1,
Y₁ and Y₂ are each independently B, N, P, P(=O), or P(=S),
Q₁₁ to Q₁₃ are each independently as described in connection with Q₁ in claim 1,
Z₁₁ and Z₁₂ are each independently as described in connection with Z₁ in claim 1,
X₁₁ is C(R₁₁) or N, X₁₂ is C(R₁₂) or N, X₁₃ is C(R₁₃) or N, and X₁₄ is C(R₁₄) or N,
X₂₁ is C(R₂₁) or N, X₂₂ is C(R₂₂) or N, X₂₃ is C(R₂₃) or N, and X₂₄ is C(R₂₄) or N,
in Formulae 31 to 37, X₃₁ is C(R₃₁) or N, X₃₂ is C(R₃₂) or N, and X₃₃ is C(R₃₃) or N; in Formulae 38 to 40, X₃₁ is C, and X₃₃ is C(R₃₃) or N; in Formulae 41 and 42, X₃₁ and X₃₃ are each C,
X₈₂ is C(R₈₂) or N, X₈₃ is C(R₈₃) or N, X₈₄ is C(R₈₄) or N, X₈₅ is C(R₈₅) or N, X₈₆ is C(R₈₆) or N, X₈₇ is C(R₈₇) or N, and X₈₈ is C(R₈₈) or N,
X₉₁ is C(R₉₁) or N, X₉₂ is C(R₉₂) or N, X₉₄ is C(R₉₄) or N, X₉₅ is C(R₉₈) or N, X₉₆ is C(R₉₆) or N, X₉₇ is C(R₉₇) or N, X₉₈ is C(R₉₈) or N, and X₉₉ is C(R₉₉) or N,
X₁₀₁ is C(R₁₀₁) or N, X₁₀₂ is C(R₁₀₂) or N, X₁₀₄ is C(R₁₀₄) or N, X₁₀₅ is C(R₁₀₅) or N, X₁₀₆ is C(R₁₀₆) or N, X₁₀₇ is C(R₁₀₇) or N, X₁₀₈ is C(R₁₀₈) or N, and X₁₀₉ is C(R₁₀₉) or N,
R₁₁ to R₁₄ are each independently as described in connection with R₁₀ in claim 1,
R₂₁ to R₂₄ are each independently as described in connection with R₂₀ in claim 1,
R₃₁ to R₃₃ are each independently as described in connection with R₃₀ in claim 1,
R₈₂ to R₈₈ are each independently as described in connection with R₈₀ in claim 1, and
R₉₁, R₉₂, R₉₄ to R₉₉, R₁₀₁, R₁₀₂, and R₁₀₄ to R₁₀₉ are each independently as described in connection with R₉₀ in claim 1.

10. The heterocyclic compound of any of claims 1-9, wherein the heterocyclic compound is one of Compounds 1 to 75:

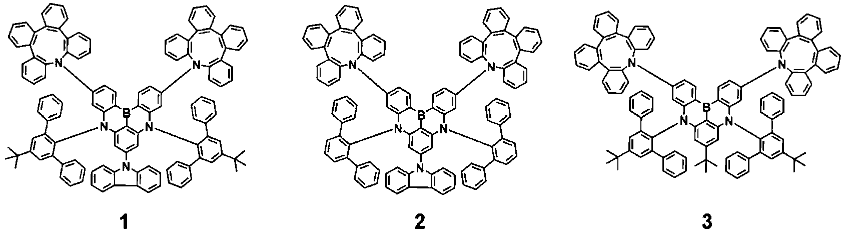

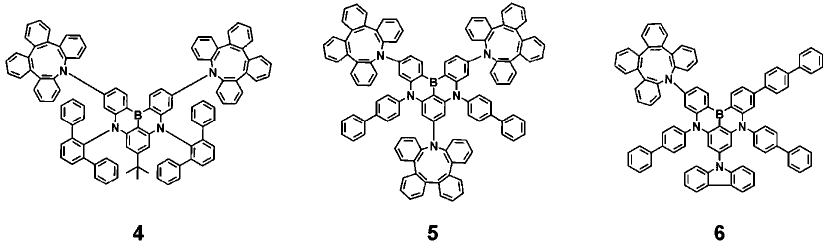

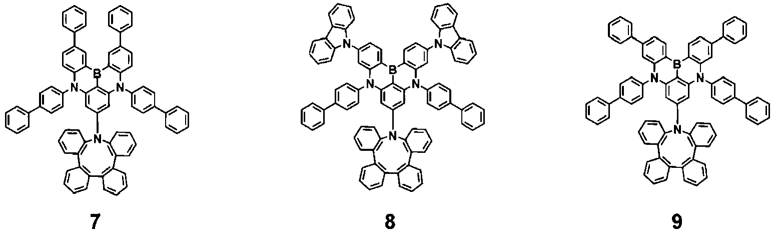

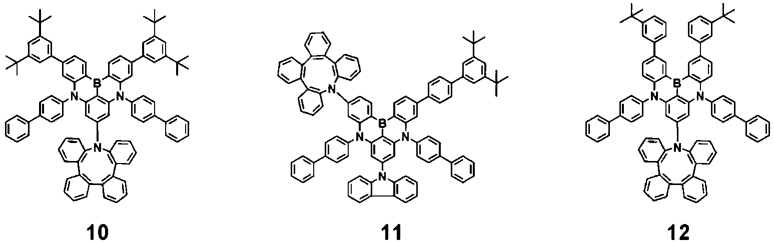

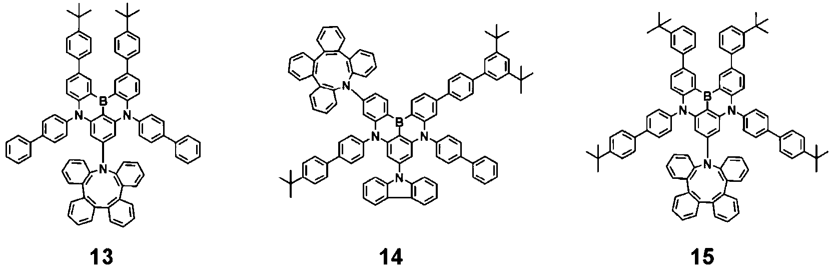

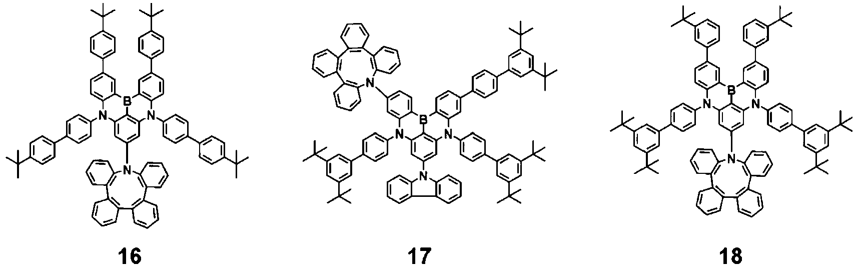

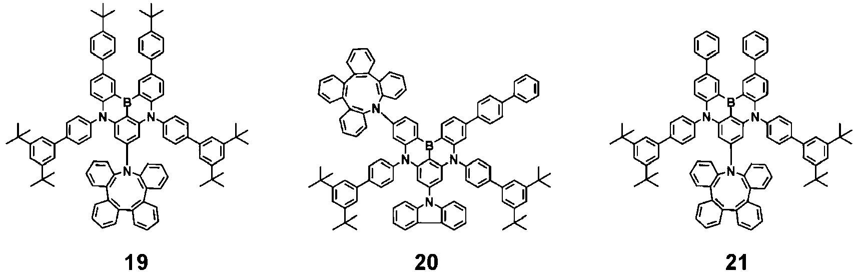

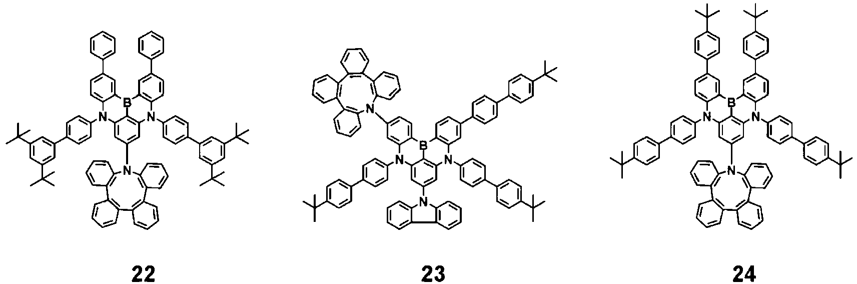

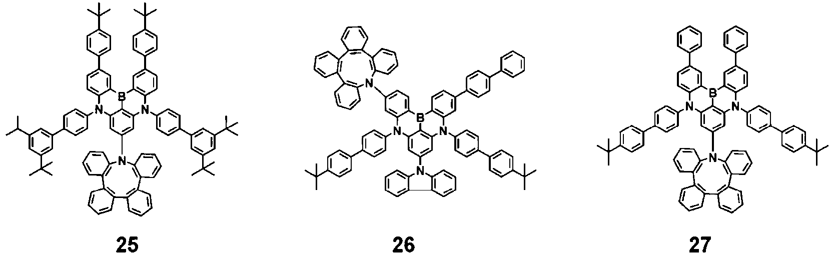

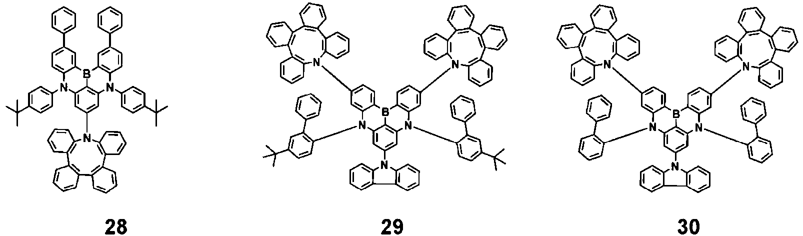

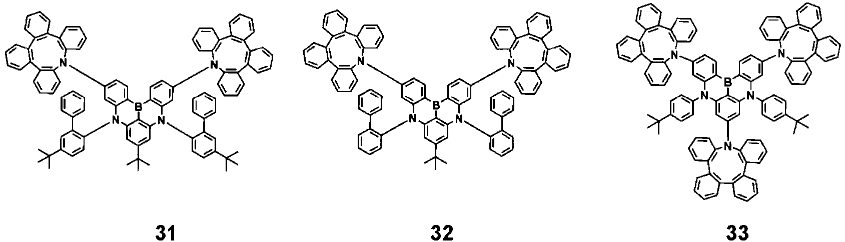

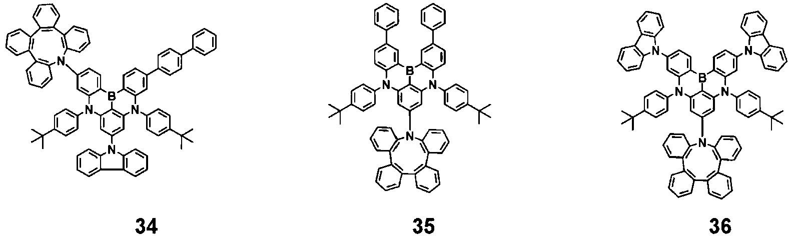

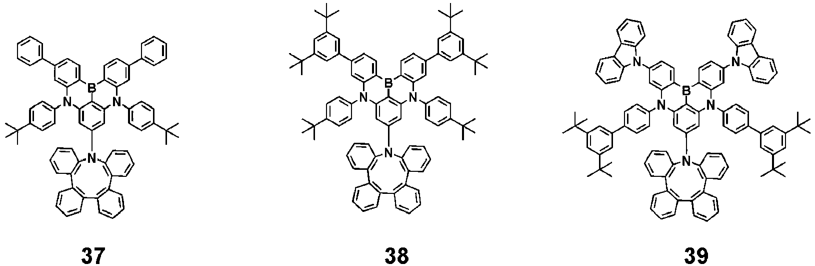

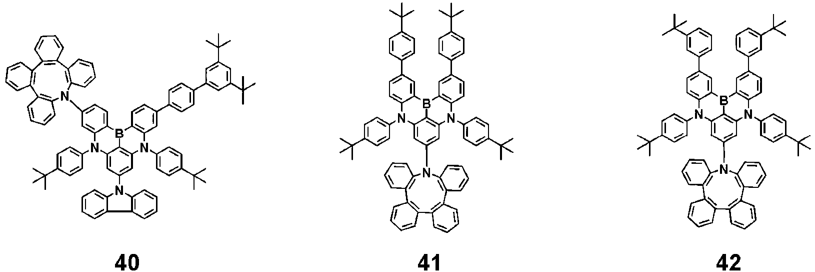

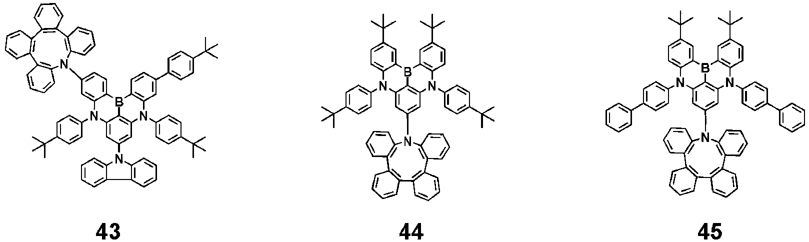

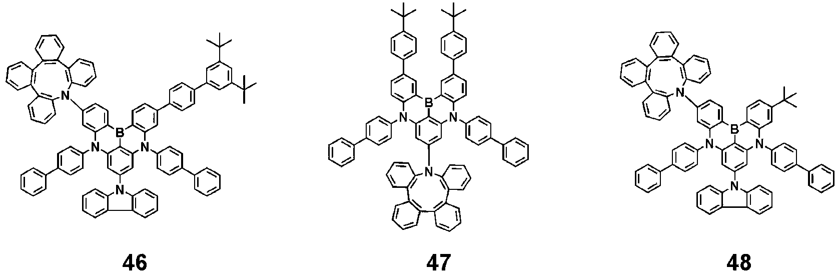

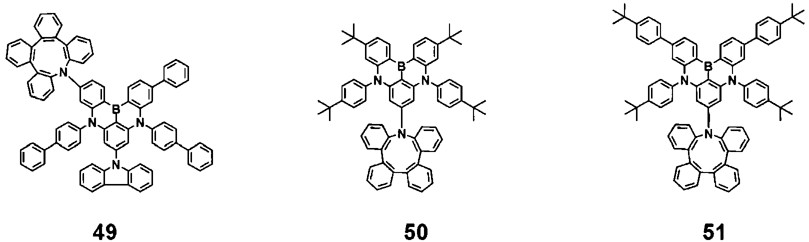

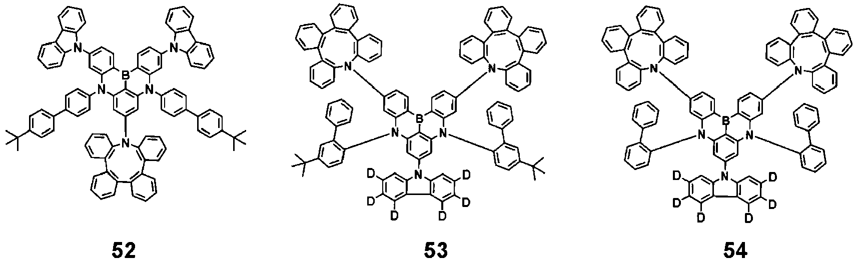

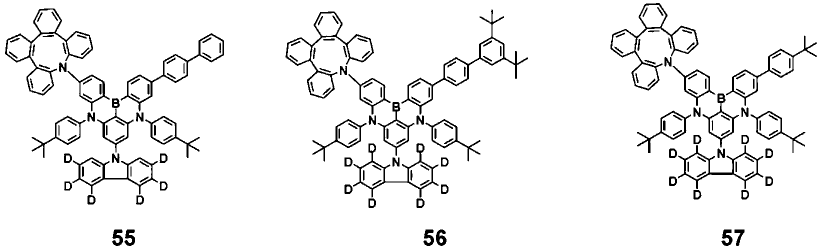

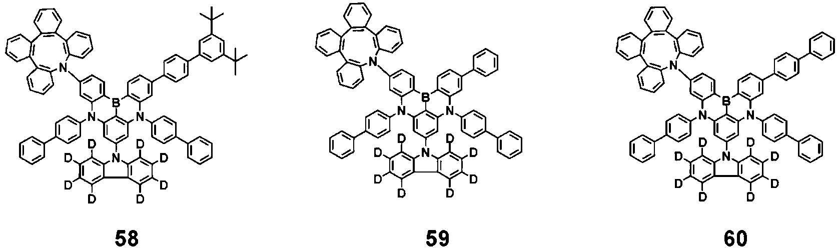

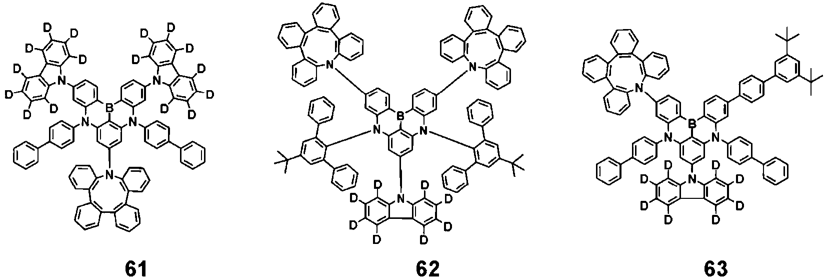

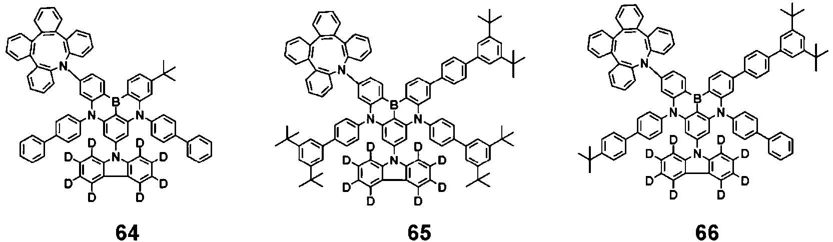

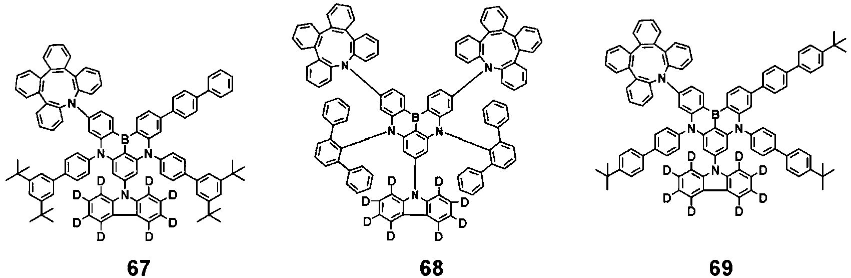

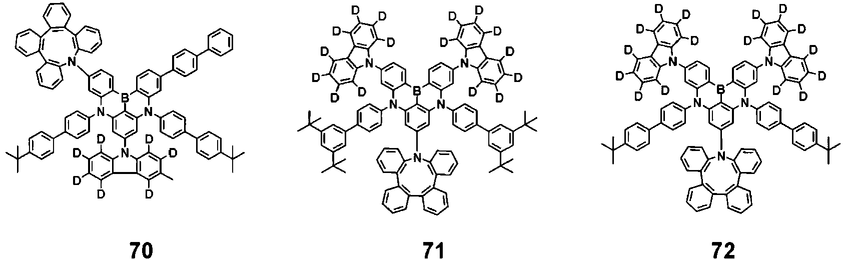

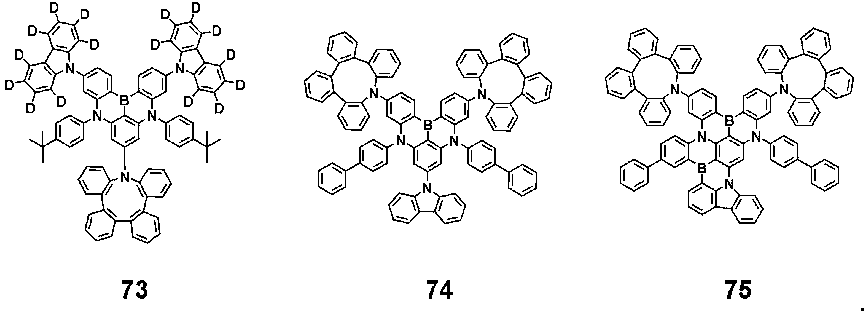

11. An organic light-emitting device, comprising:
a first electrode;
a second electrode; and
an organic layer arranged between the first electrode and the second electrode,
wherein the organic layer comprises an emission layer, and
wherein the organic layer further comprises the heterocyclic compound of any of claims 1-10.

12. The organic light-emitting device of claim 11, wherein the emission layer comprises the heterocyclic compound, preferably wherein the emission layer emits a blue light having a maximum emission wavelength of 400 nanometers to 490 nanometers.

13. The organic light-emitting device of claim 12, wherein the emission layer comprises a host and an emitter, and
the emitter comprises the heterocyclic compound.

14. The organic light-emitting device of claim 13, wherein an amount of the host in the emission layer is greater than an amount of the heterocyclic compound in the emission layer, based on weight; and/or
wherein the emission layer further comprises a sensitizer, preferably wherein the sensitizer comprises an organometallic compound.

15. An electronic apparatus, comprising the organic light-emitting device of any of claims 11-14.
